# EUROPEAN PATENT APPLICATION

(11) **EP 4 811 958 A1**
(43) Date of publication of application: **23.09.2026**
(21) Application number: 24891041.6
(22) Date of filing: 21.08.2024
(51) Int. Cl.: H10D 30/67, H10D 30/60, H10D 64/20, H10D 64/23, H10D 84/83, H10F 39/18

(54) **SEMICONDUCTOR DEVICE AND ELECTRONIC APPARATUS**

(30) Priority: 17.11.2023 JP 2023195929
(71) Applicant: Sony Semiconductor Solutions Corporation, Atsugi-shi, Kanagawa 243-0014 (JP)
(72) Inventor: IRIGUCHI, Takuya, Atsugi-shi, Kanagawa 243-0014 (JP); YAMACHI, Ryosuke, Atsugi-shi, Kanagawa 243-0014 (JP); SAKA, Naoki, Atsugi-shi, Kanagawa 243-0014 (JP); KAMO, Takashi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/029577
(87) International publication number: WO 2025/104997

(57) **Abstract**

A semiconductor device includes: a semiconductor portion having an island shape; a transistor including at least one of a source region and a drain region formed in the semiconductor portion; and a contactor connected to the at least one of the source region and the drain region, in which the contactor includes a contact surface that is in contact with the at least one of the source region and the drain region and extends downward.

## Description

### Technical Field

The present disclosure relates to a semiconductor device and an electronic apparatus.

### Background Art

As disclosed in PTL 1, for example, a field-effect transistor formed in a semiconductor portion provided in an island shape is known as one type of transistor. Such a transistor is also called a fin-type transistor.

### Citation List

### Patent Literature

PTL 1: JP 2021-34435 A

### Summary

### Technical Problem

There remains room for improvement in the performance of fin-type transistors.

An object of an aspect of the present disclosure is to achieve improvement in the performance of fin-type transistors.

### Solution to Problem

A semiconductor device according to an aspect of the present disclosure includes: a semiconductor portion having an island shape; a transistor including at least one of a source region and a drain region formed in the semiconductor portion; and a contactor connected to the at least one of the source region and the drain region, in which the contactor includes a contact surface being in contact with the at least one of the source region and the drain region and extending downward.

An electronic apparatus according to an aspect of the present disclosure includes a semiconductor device, in which the semiconductor device includes: a semiconductor portion having an island shape; a transistor including at least one of a source region and a drain region formed in the semiconductor portion; and a contactor connected to the at least one of the source region and the drain region, in which the contactor includes a contact surface being in contact with the at least one of the source region and the drain region and extending downward.

### Brief Description of Drawings

[Fig. 1]

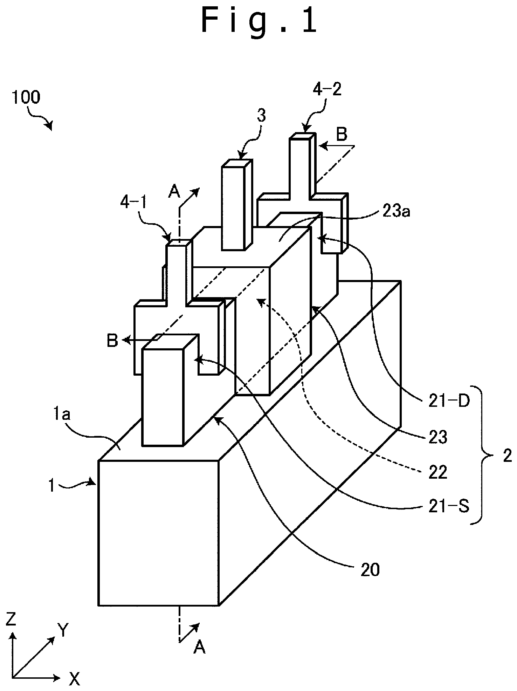

   Fig. 1 is a diagram depicting an example of a schematic configuration of a semiconductor device 100.
[Fig. 2]

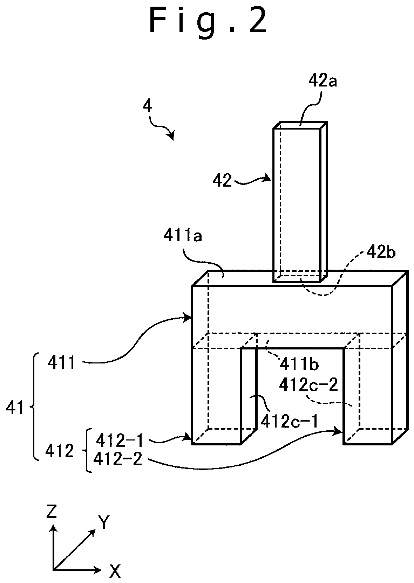

   Fig. 2 is a diagram depicting an example of a schematic configuration of the semiconductor device 100.
[Fig. 3]

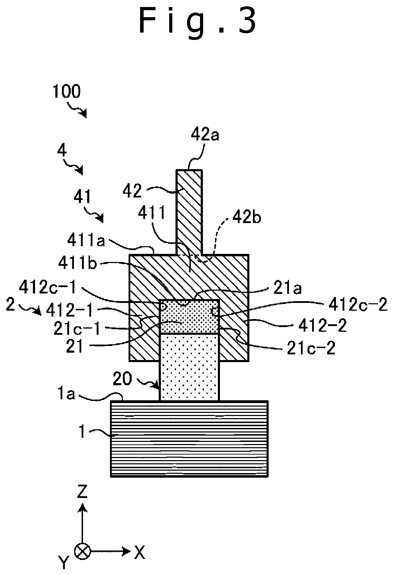

   Fig. 3 is a diagram depicting an example of a schematic configuration of the semiconductor device 100.
[Fig. 4]

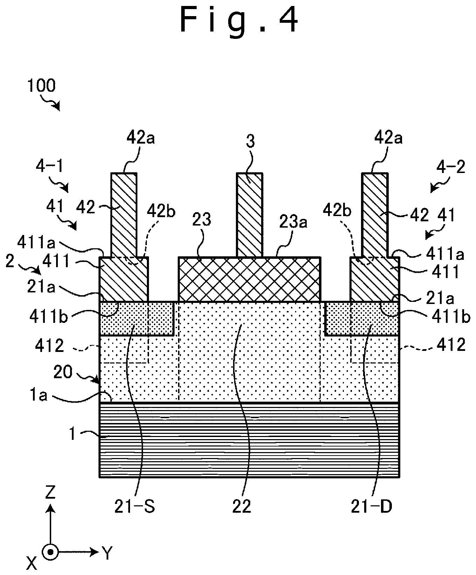

   Fig. 4 is a diagram depicting an example of a schematic configuration of the semiconductor device 100.
[Fig. 5]

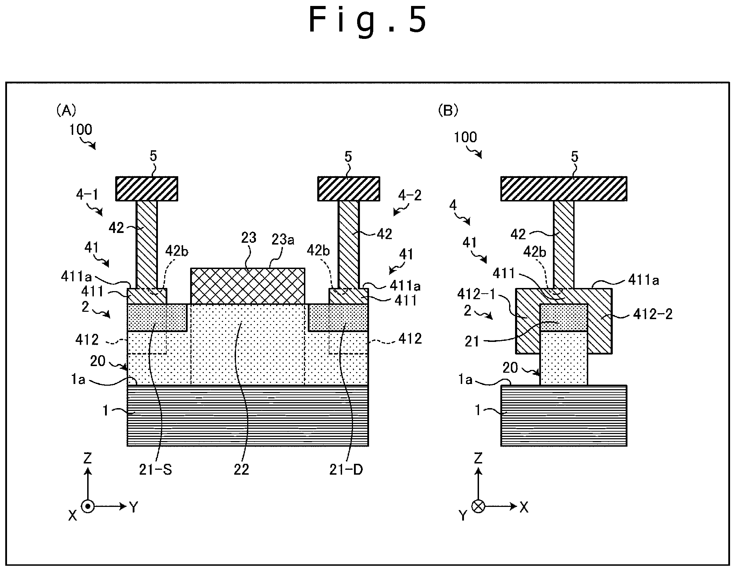

   Fig. 5 is a diagram depicting an example of a schematic configuration of the semiconductor device 100.
[Fig. 6]

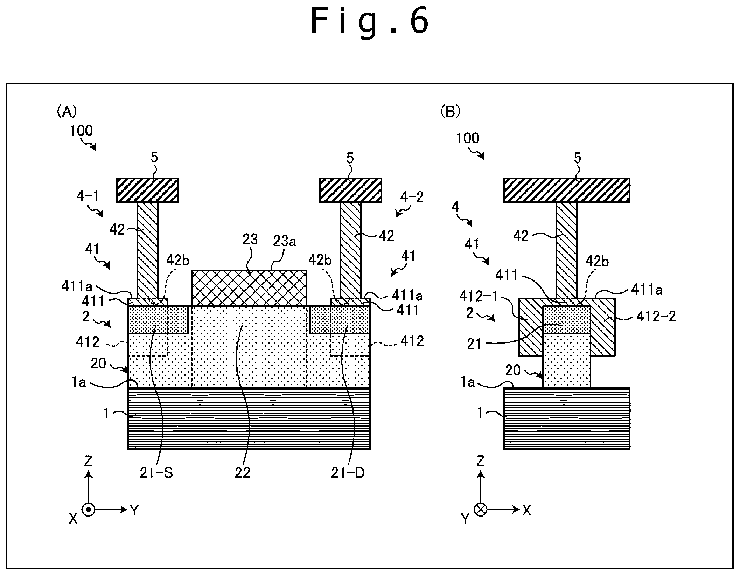

   Fig. 6 is a diagram depicting an example of a schematic configuration of the semiconductor device 100.
[Fig. 7]

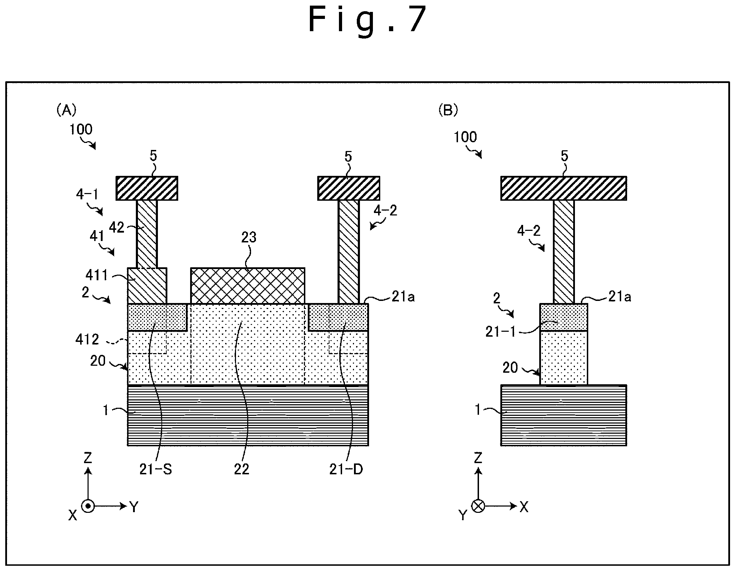

   Fig. 7 is a diagram depicting an example of a schematic configuration of the semiconductor device 100.
[Fig. 8]

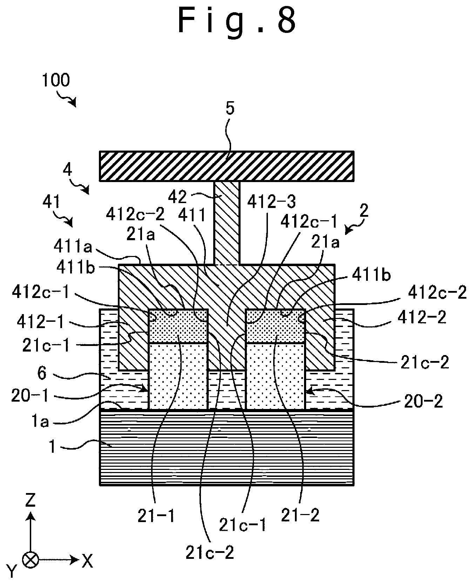

   Fig. 8 is a diagram depicting an example of a schematic configuration of the semiconductor device 100.
[Fig. 9]

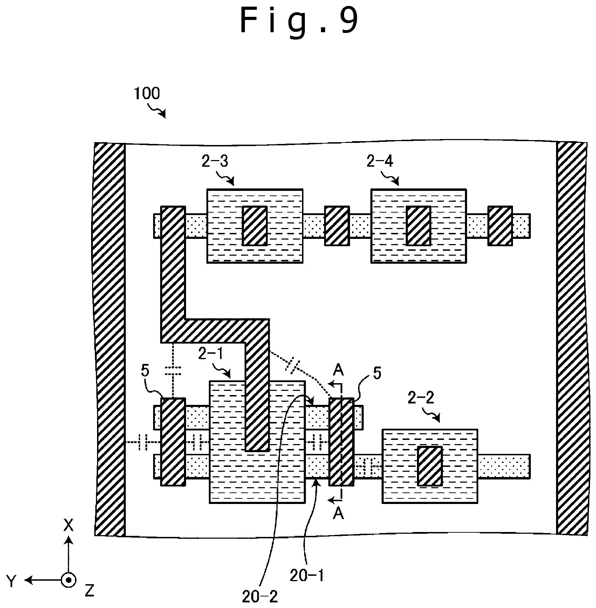

   Fig. 9 is a diagram depicting an example of a schematic configuration of the semiconductor device 100.
[Fig. 10]

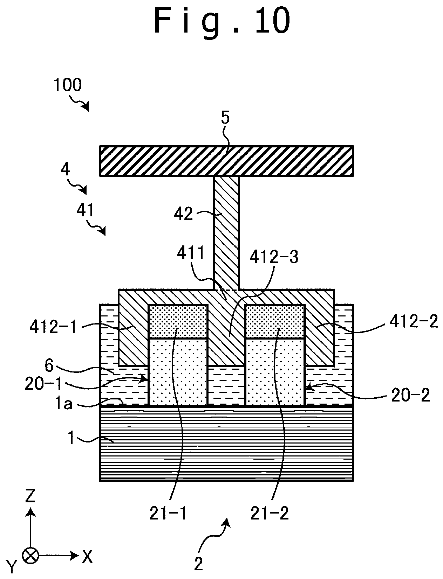

   Fig. 10 is a diagram depicting an example of a schematic configuration of the semiconductor device 100.
[Fig. 11]

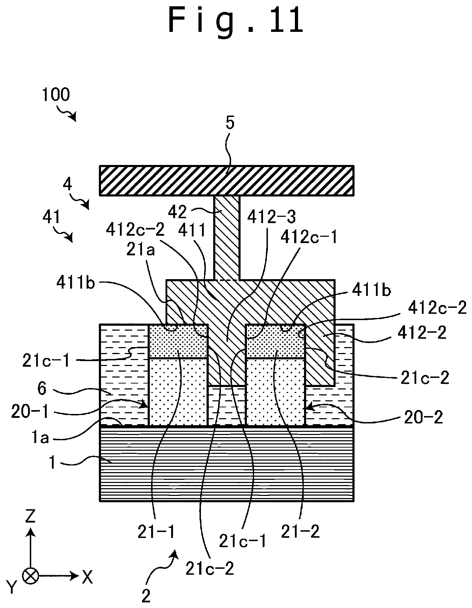

   Fig. 11 is a diagram depicting an example of a schematic configuration of the semiconductor device 100.
[Fig. 12]

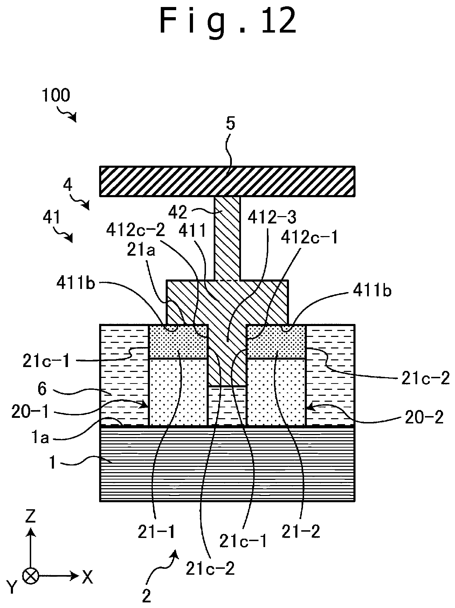

   Fig. 12 is a diagram depicting an example of a schematic configuration of the semiconductor device 100.
[Fig. 13]

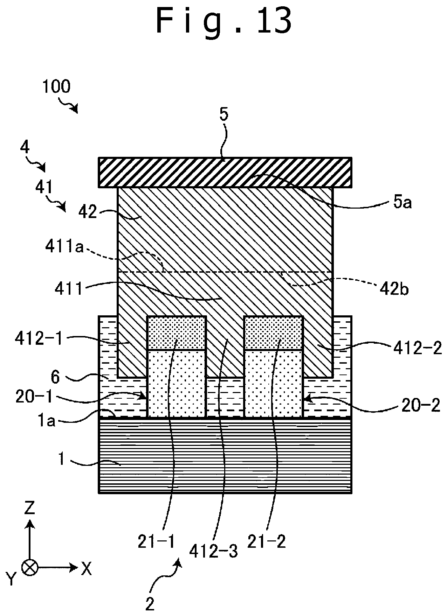

   Fig. 13 is a diagram depicting an example of a schematic configuration of the semiconductor device 100.
[Fig. 14]

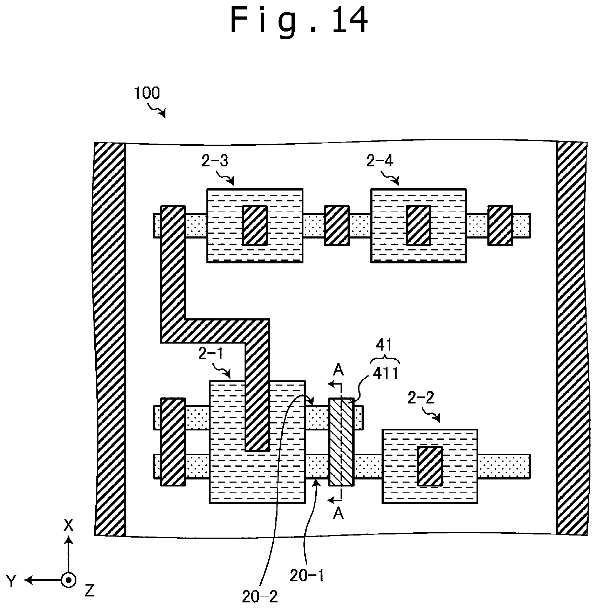

   Fig. 14 is a diagram depicting an example of a schematic configuration of the semiconductor device 100.
[Fig. 15]

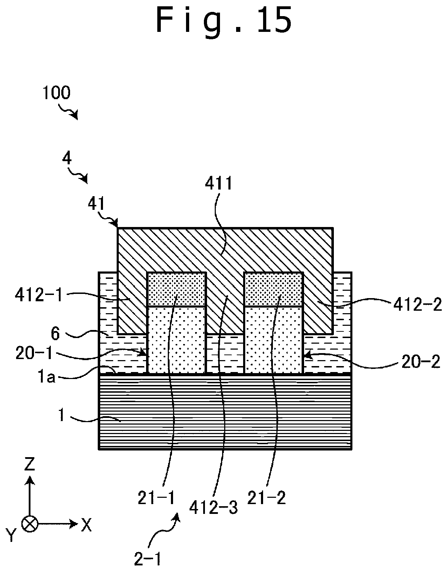

   Fig. 15 is a diagram depicting an example of a schematic configuration of the semiconductor device 100.
[Fig. 16]

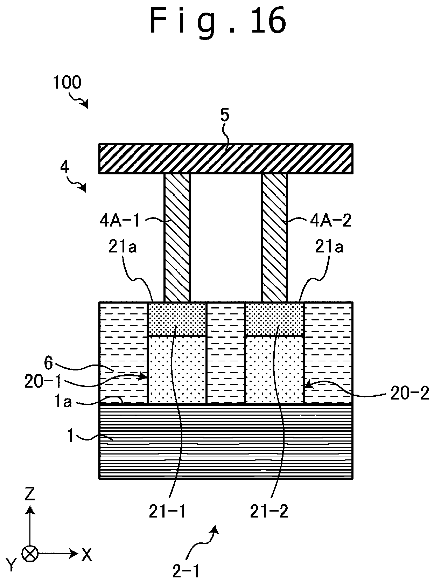

   Fig. 16 is a diagram depicting an example of a schematic configuration of the semiconductor device 100.
[Fig. 17]

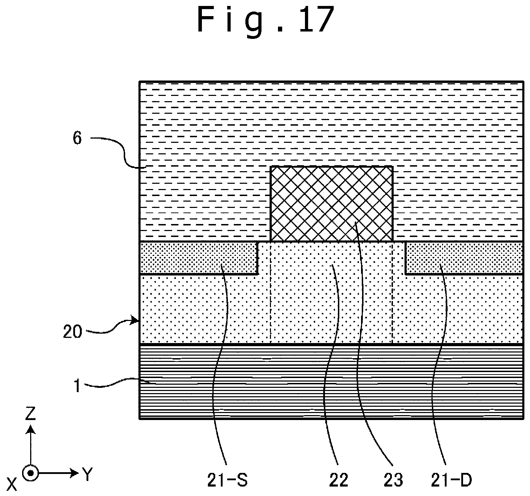

   Fig. 17 is a diagram depicting an example of a manufacturing method for the semiconductor device 100.
[Fig. 18]

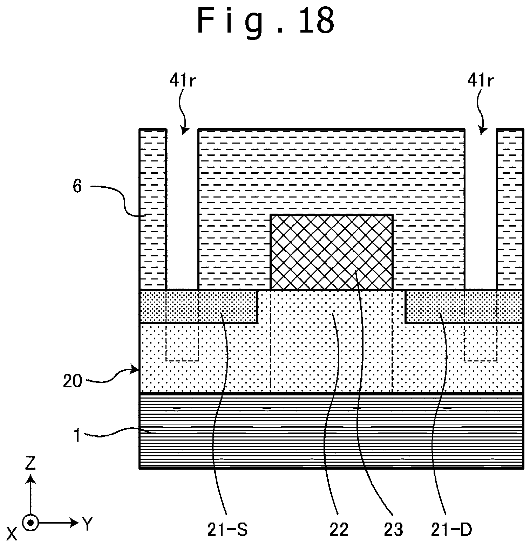

   Fig. 18 is a diagram depicting an example of a manufacturing method for the semiconductor device 100.
[Fig. 19]

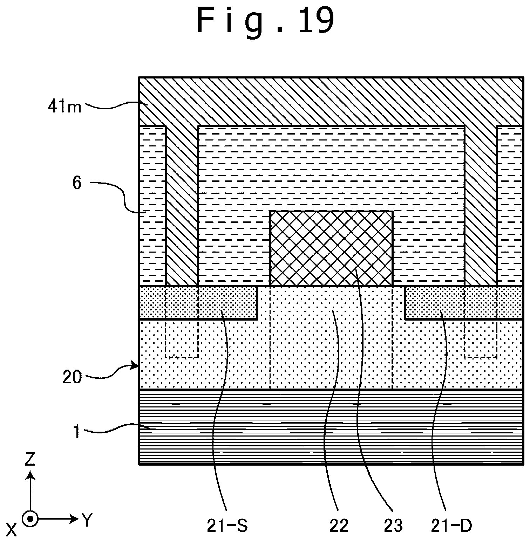

   Fig. 19 is a diagram depicting an example of a manufacturing method for the semiconductor device 100.
[Fig. 20]

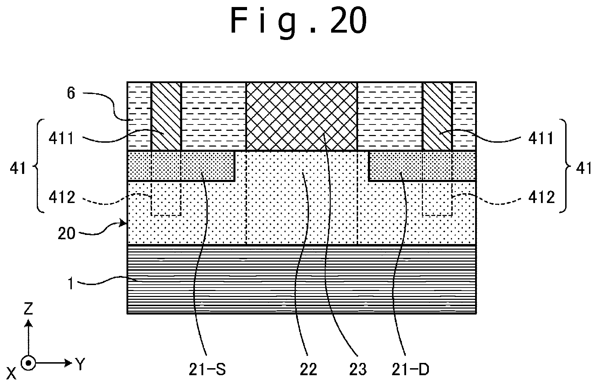

   Fig. 20 is a diagram depicting an example of a manufacturing method for the semiconductor device 100.
[Fig. 21]

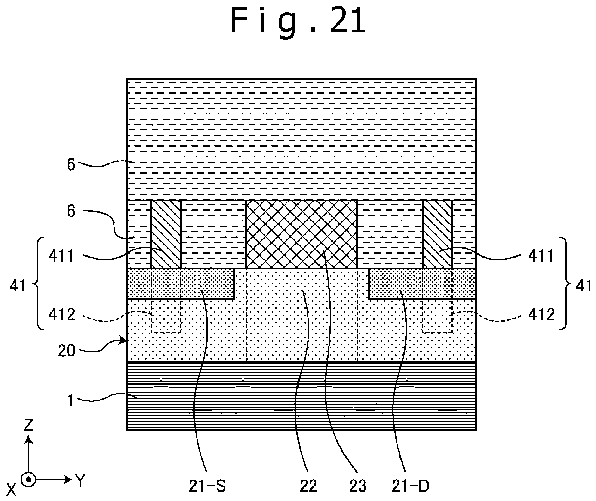

   Fig. 21 is a diagram depicting an example of a manufacturing method for the semiconductor device 100.
[Fig. 22]

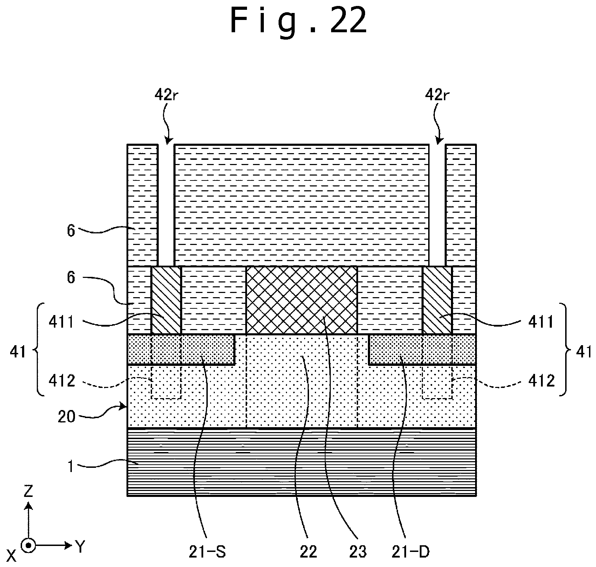

   Fig. 22 is a diagram depicting an example of a manufacturing method for the semiconductor device 100.
[Fig. 23]

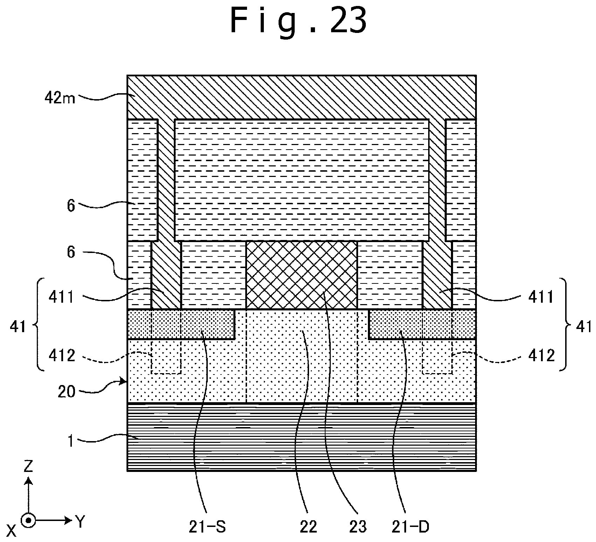

   Fig. 23 is a diagram depicting an example of a manufacturing method for the semiconductor device 100.
[Fig. 24]

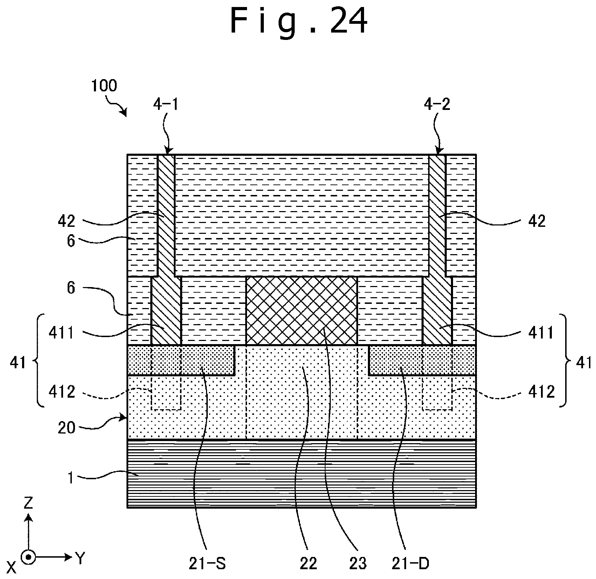

   Fig. 24 is a diagram depicting an example of a manufacturing method for the semiconductor device 100.
[Fig. 25]

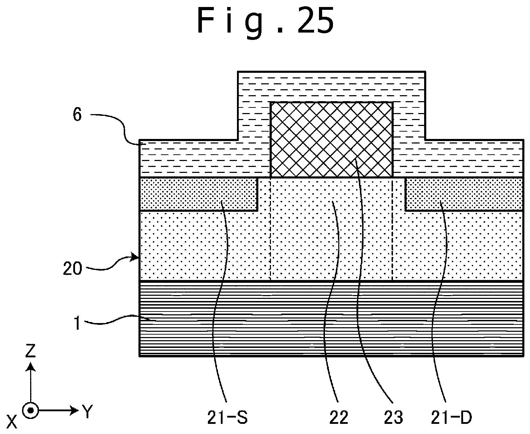

   Fig. 25 is a diagram depicting an example of a manufacturing method for the semiconductor device 100.
[Fig. 26]

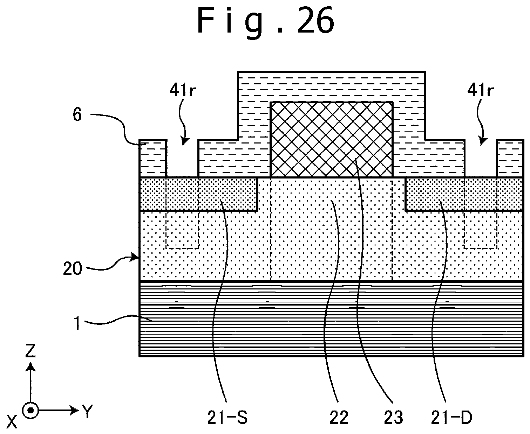

   Fig. 26 is a diagram depicting an example of a manufacturing method for the semiconductor device 100.
[Fig. 27]

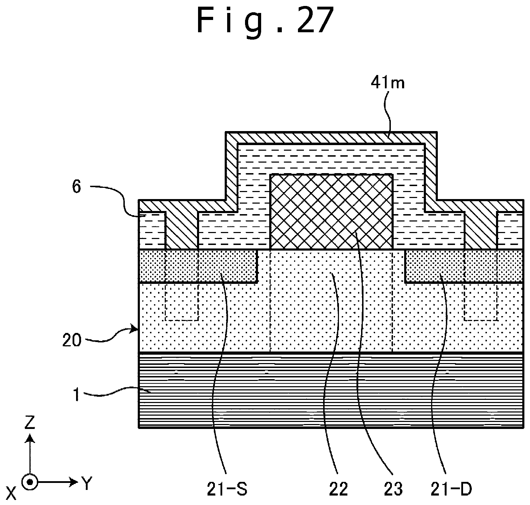

   Fig. 27 is a diagram depicting an example of a manufacturing method for the semiconductor device 100.
[Fig. 28]

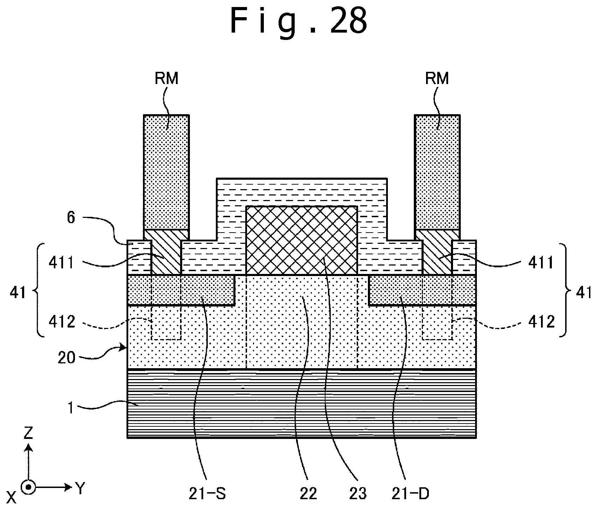

   Fig. 28 is a diagram depicting an example of a manufacturing method for the semiconductor device 100.
[Fig. 29]

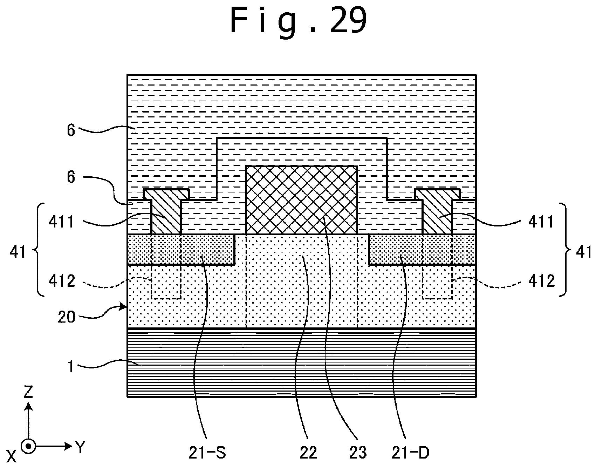

   Fig. 29 is a diagram depicting an example of a manufacturing method for the semiconductor device 100.
[Fig. 30]

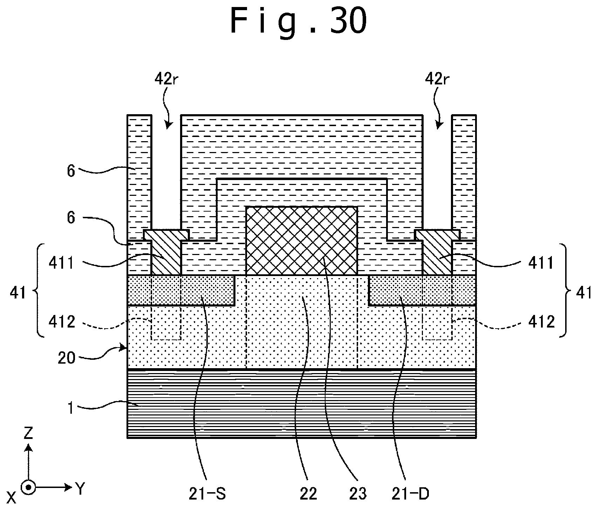

   Fig. 30 is a diagram depicting an example of a manufacturing method for the semiconductor device 100.
[Fig. 31]

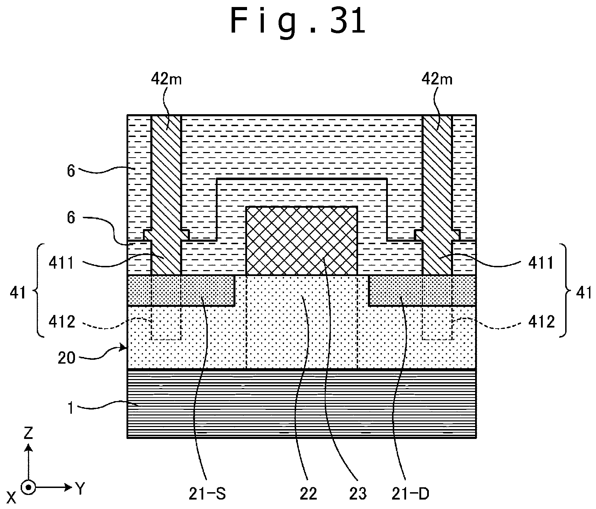

   Fig. 31 is a diagram depicting an example of a manufacturing method for the semiconductor device 100.
[Fig. 32]

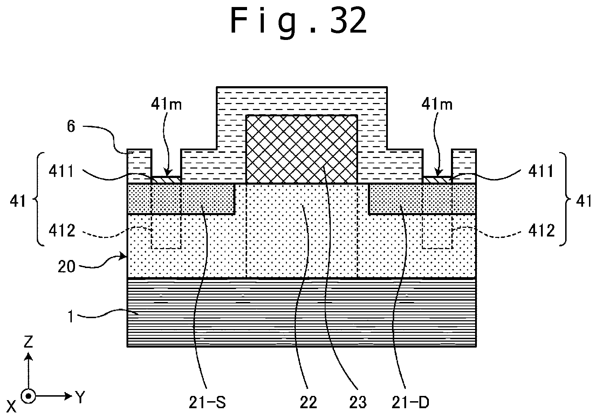

   Fig. 32 is a diagram depicting an example of a manufacturing method for the semiconductor device 100.
[Fig. 33]

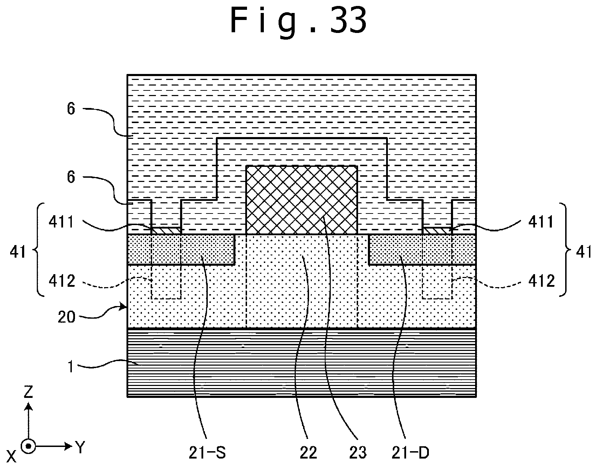

   Fig. 33 is a diagram depicting an example of a manufacturing method for the semiconductor device 100.
[Fig. 34]

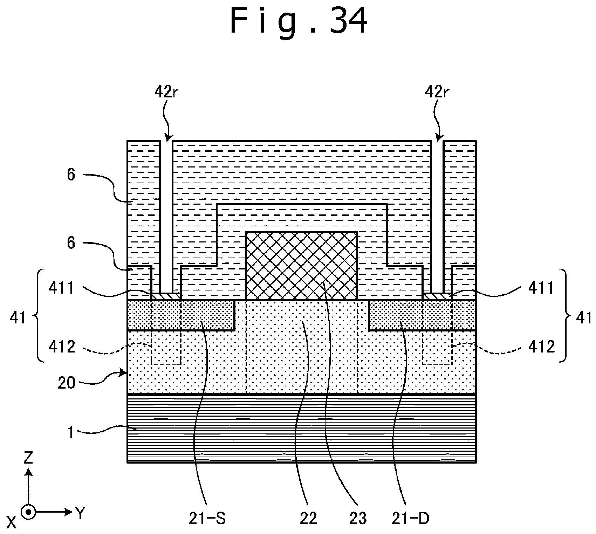

   Fig. 34 is a diagram depicting an example of a manufacturing method for the semiconductor device 100.
[Fig. 35]

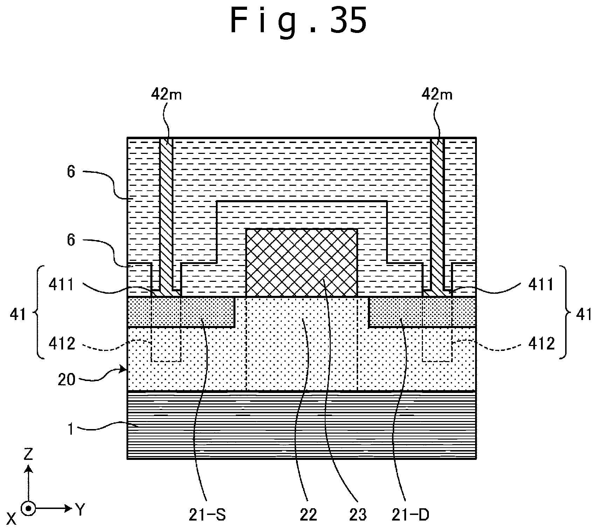

   Fig. 35 is a diagram depicting an example of a manufacturing method for the semiconductor device 100.
[Fig. 36]

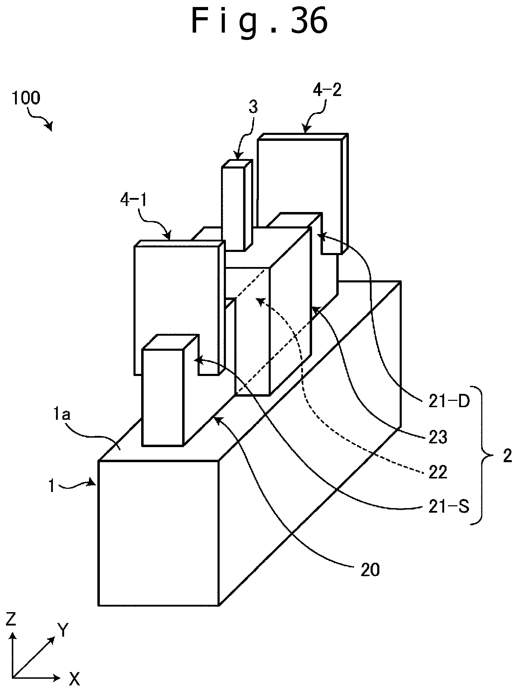

   Fig. 36 is a diagram depicting an example of a schematic configuration of the semiconductor device 100.
[Fig. 37]

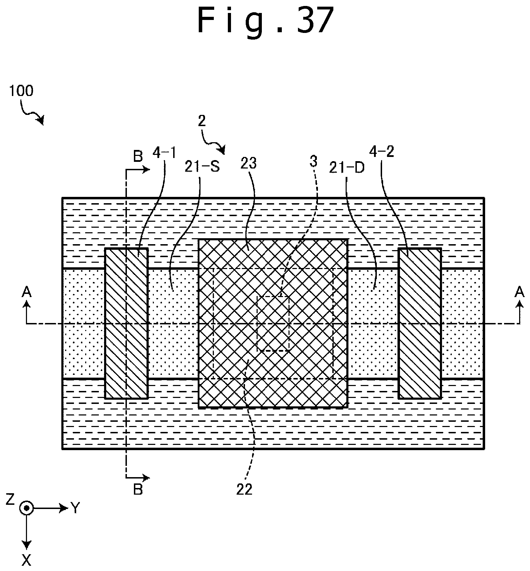

   Fig. 37 is a diagram depicting an example of a schematic configuration of the semiconductor device 100.
[Fig. 38]

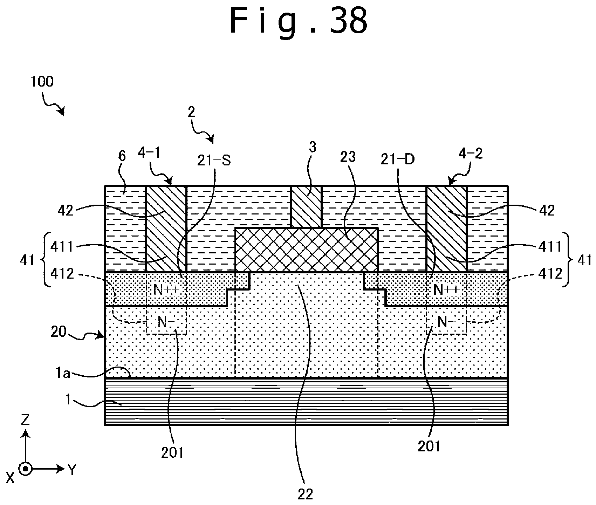

   Fig. 38 is a diagram depicting an example of a schematic configuration of the semiconductor device 100.
[Fig. 39]

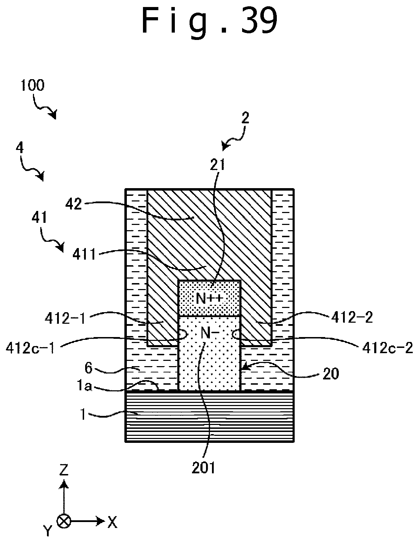

   Fig. 39 is a diagram depicting an example of a schematic configuration of the semiconductor device 100.
[Fig. 40]

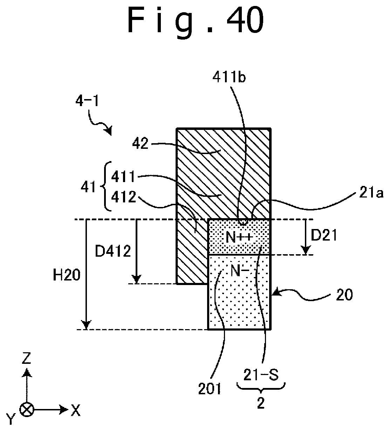

   Fig. 40 is a diagram depicting an example of a simulation.
[Fig. 41]

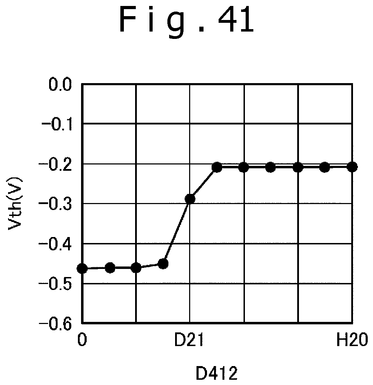

   Fig. 41 is a diagram depicting an example of a simulation.
[Fig. 42]

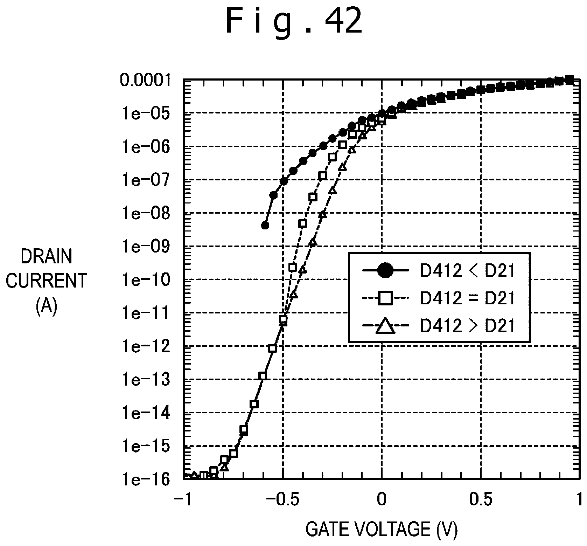

   Fig. 42 is a diagram depicting an example of a simulation.
[Fig. 43]

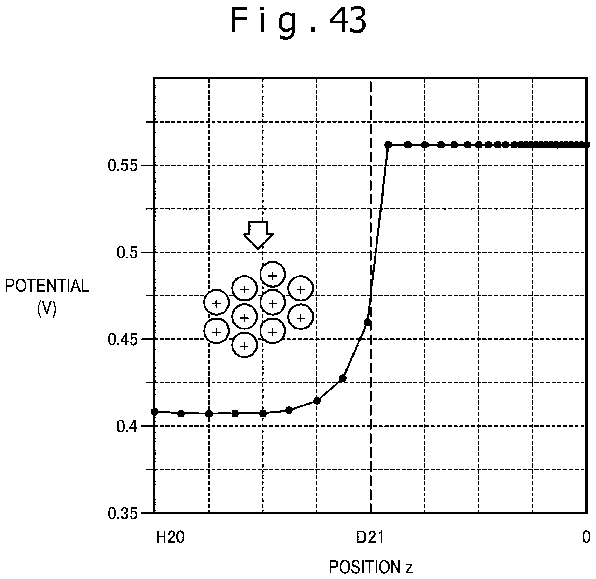

   Fig. 43 is a diagram depicting an example of a simulation.
[Fig. 44]

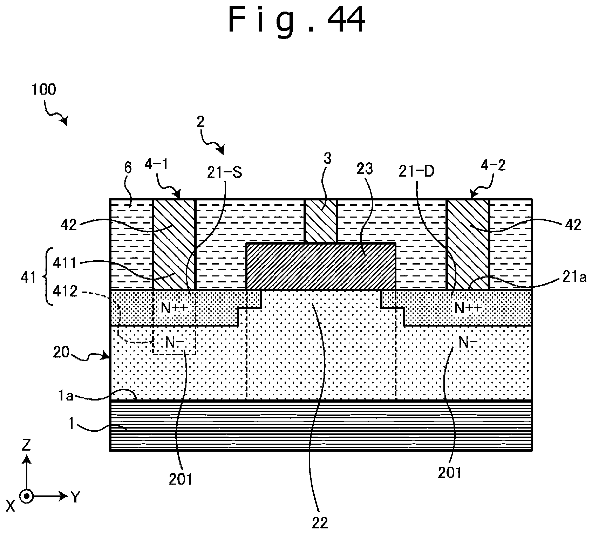

   Fig. 44 is a diagram depicting an example of a schematic configuration of the semiconductor device 100.
[Fig. 45]

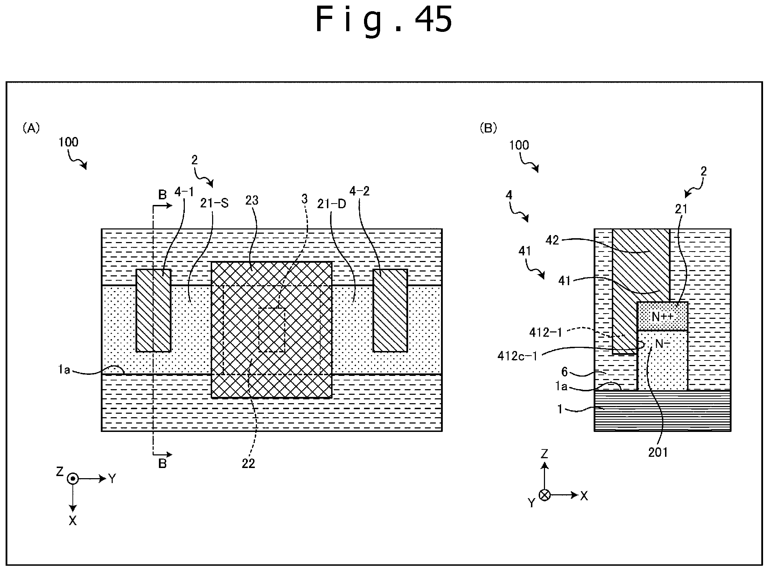

   Fig. 45 is a diagram depicting an example of a schematic configuration of the semiconductor device 100.
[Fig. 46]

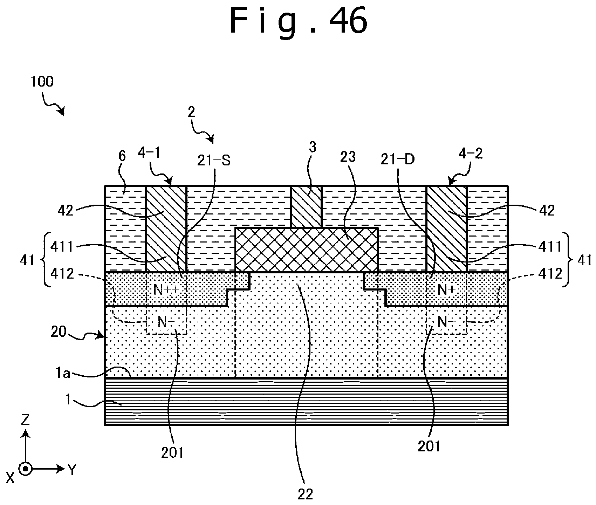

   Fig. 46 is a diagram depicting an example of a schematic configuration of the semiconductor device 100.
[Fig. 47]

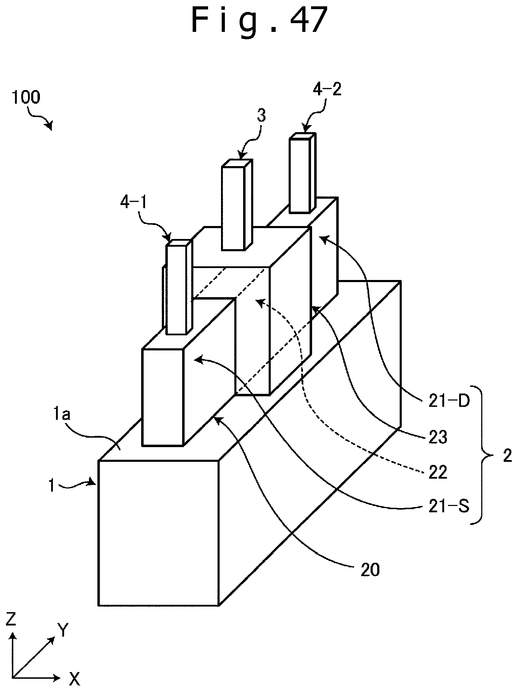

   Fig. 47 is a diagram depicting an example of a schematic configuration of the semiconductor device 100.
[Fig. 48]

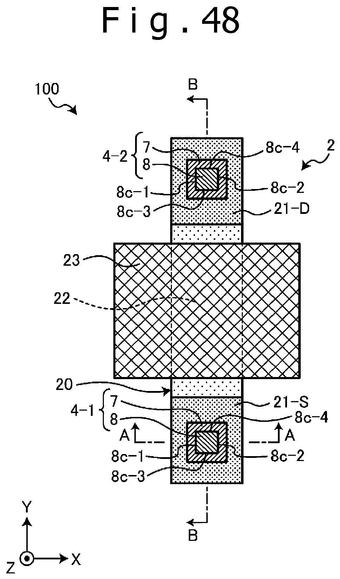

   Fig. 48 is a diagram depicting an example of a schematic configuration of the semiconductor device 100.
[Fig. 49]

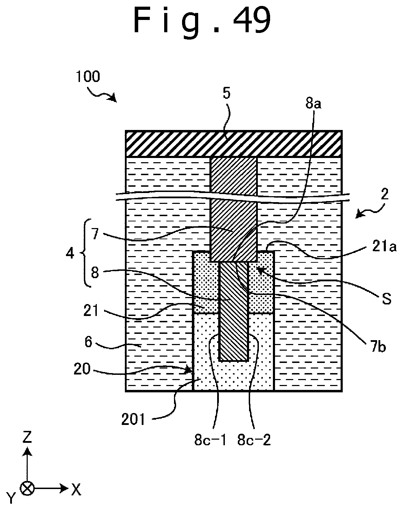

   Fig. 49 is a diagram depicting an example of a schematic configuration of the semiconductor device 100.
[Fig. 50]

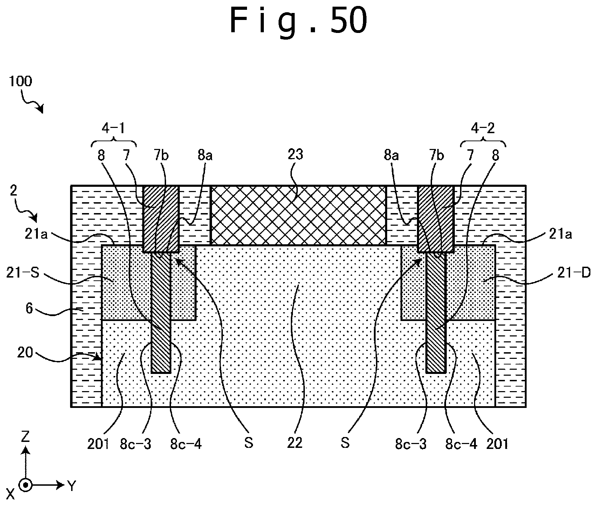

   Fig. 50 is a diagram depicting an example of a schematic configuration of the semiconductor device 100.
[Fig. 51]

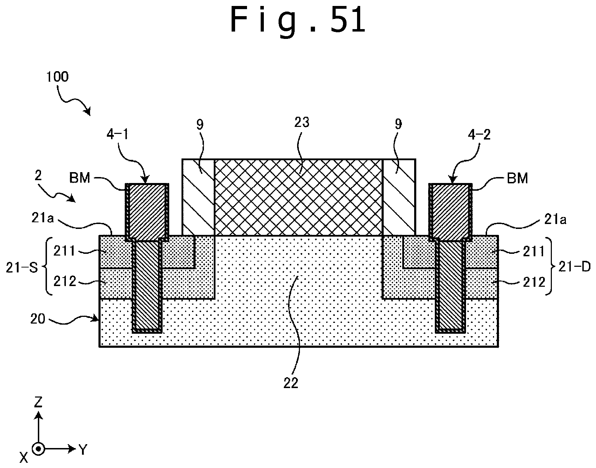

   Fig. 51 is a diagram depicting an example of a schematic configuration of the semiconductor device 100.
[Fig. 52]

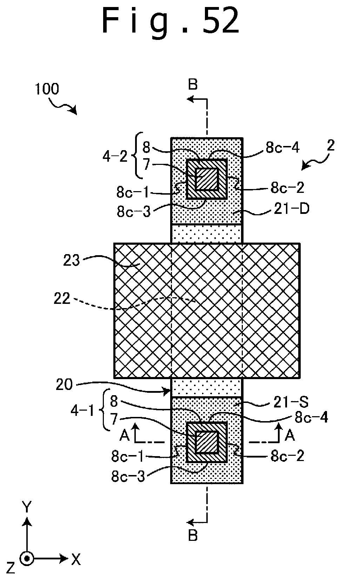

   Fig. 52 is a diagram depicting an example of a schematic configuration of the semiconductor device 100.
[Fig. 53]

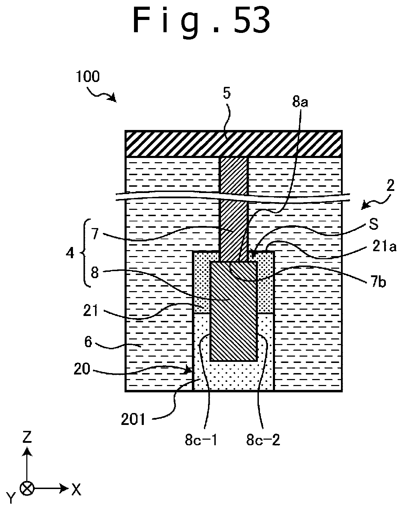

   Fig. 53 is a diagram depicting an example of a schematic configuration of the semiconductor device 100.
[Fig. 54]

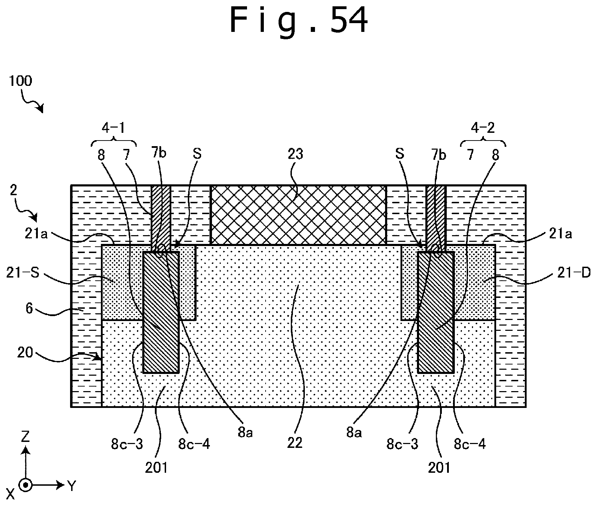

   Fig. 54 is a diagram depicting an example of a schematic configuration of the semiconductor device 100.
[Fig. 55]

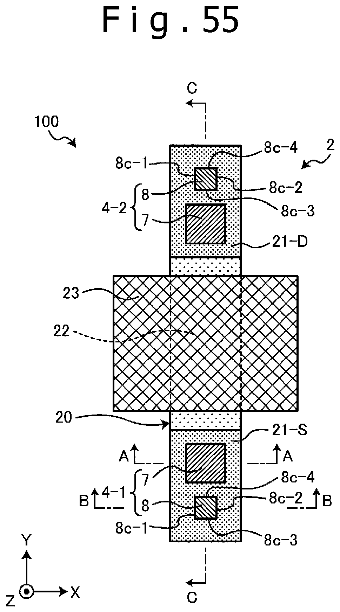

   Fig. 55 is a diagram depicting an example of a schematic configuration of the semiconductor device 100.
[Fig. 56]

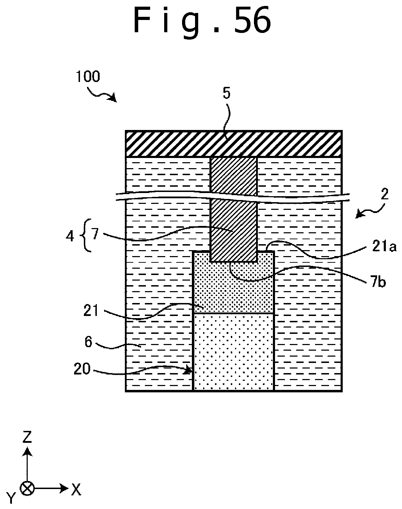

   Fig. 56 is a diagram depicting an example of a schematic configuration of the semiconductor device 100.
[Fig. 57]

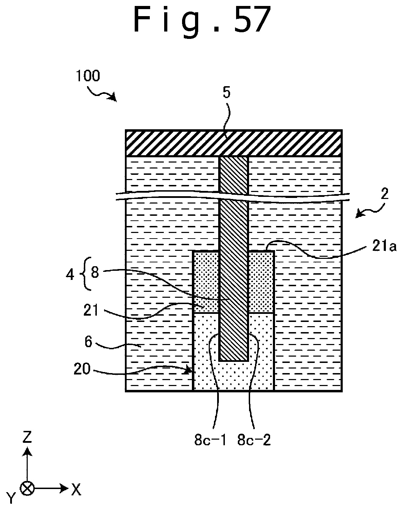

   Fig. 57 is a diagram depicting an example of a schematic configuration of the semiconductor device 100.
[Fig. 58]

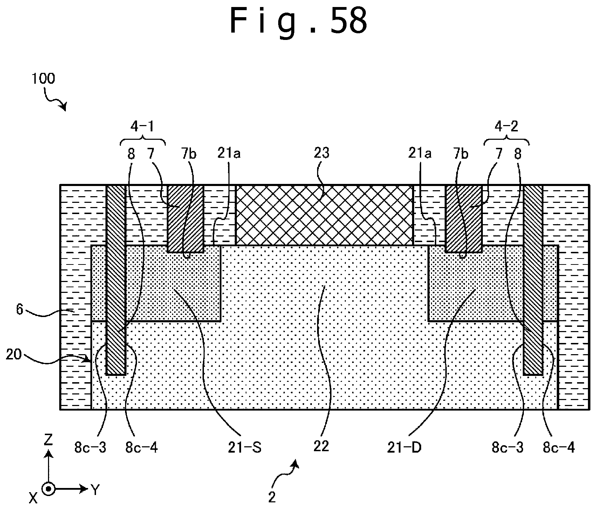

   Fig. 58 is a diagram depicting an example of a schematic configuration of the semiconductor device 100.
[Fig. 59]

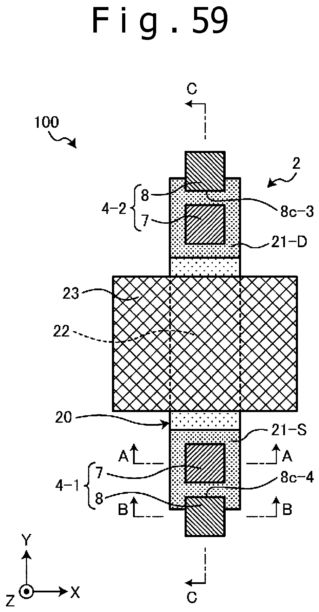

   Fig. 59 is a diagram depicting an example of a schematic configuration of the semiconductor device 100.
[Fig. 60]

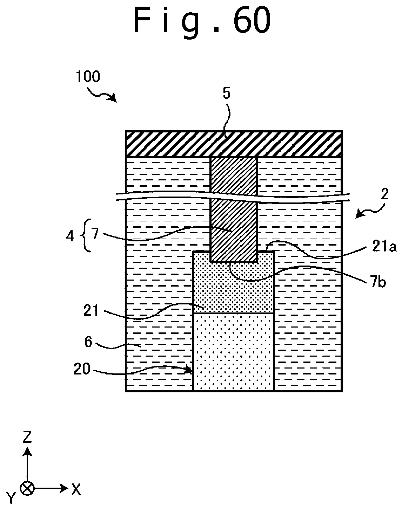

   Fig. 60 is a diagram depicting an example of a schematic configuration of the semiconductor device 100.
[Fig. 61]

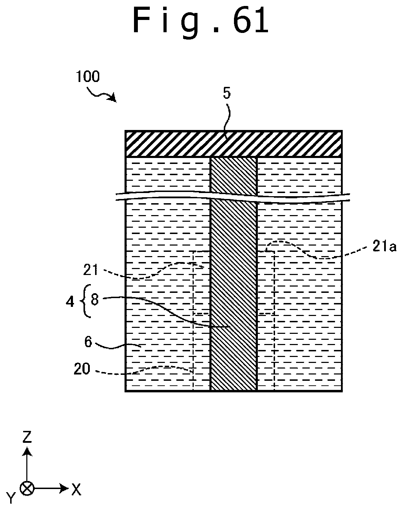

   Fig. 61 is a diagram depicting an example of a schematic configuration of the semiconductor device 100.
[Fig. 62]

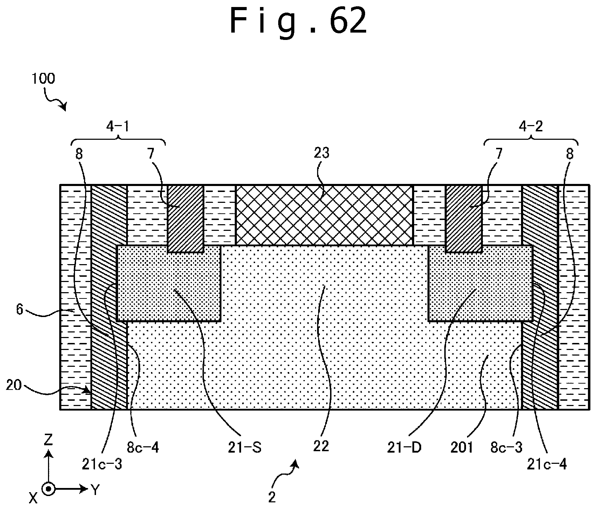

   Fig. 62 is a diagram depicting an example of a schematic configuration of the semiconductor device 100.
[Fig. 63]

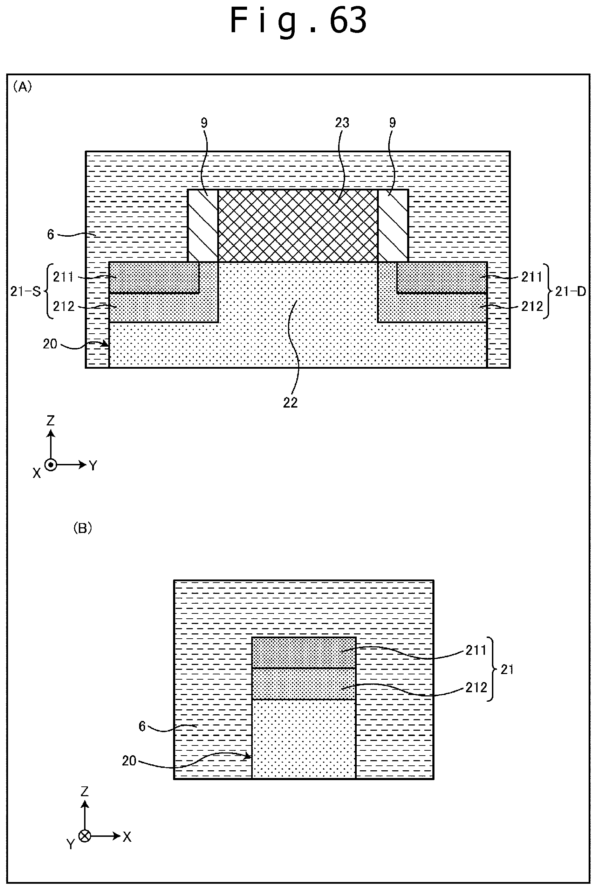

   Fig. 63 is a diagram depicting an example of a manufacturing method for the semiconductor device 100.
[Fig. 64]

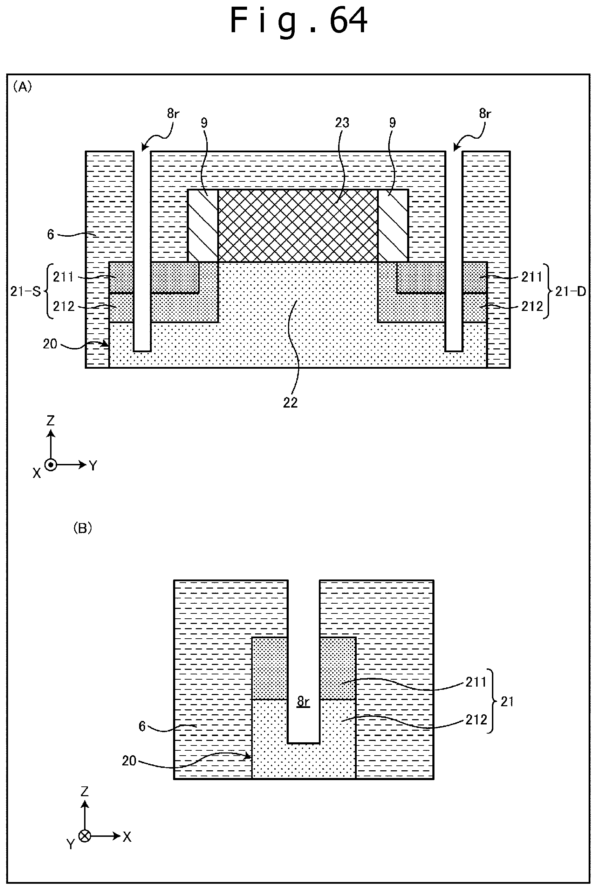

   Fig. 64 is a diagram depicting an example of a manufacturing method for the semiconductor device 100.
[Fig. 65]

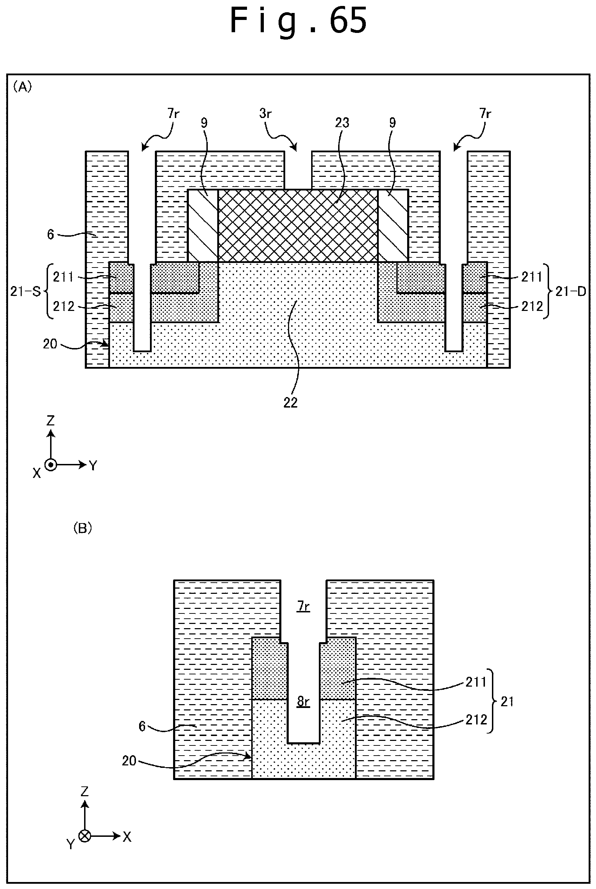

   Fig. 65 is a diagram depicting an example of a manufacturing method for the semiconductor device 100.
[Fig. 66]

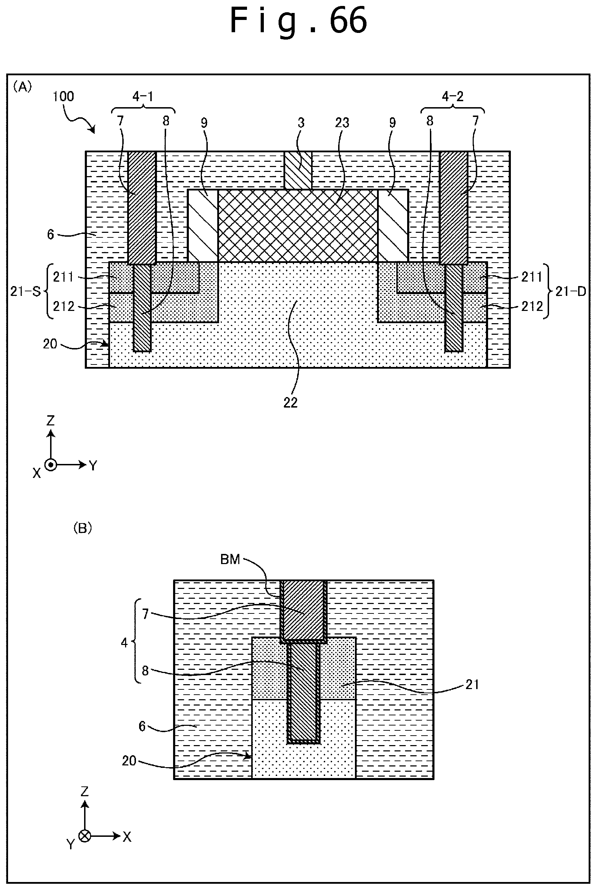

   Fig. 66 is a diagram depicting an example of a manufacturing method for the semiconductor device 100.
[Fig. 67]

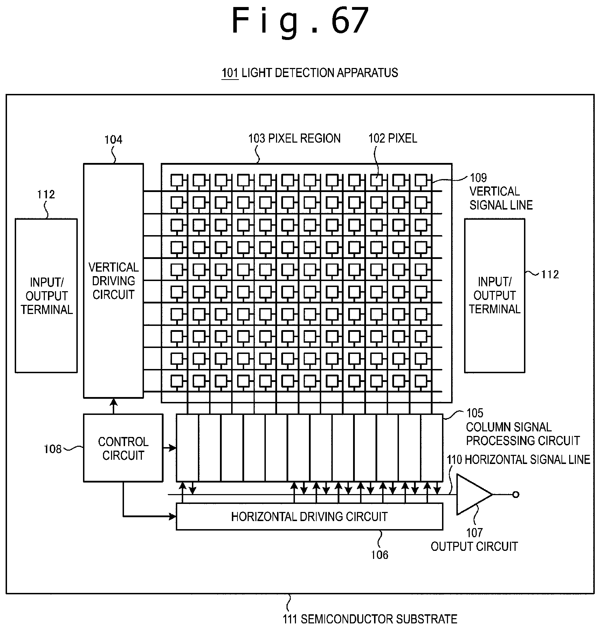

   Fig. 67 is a diagram depicting an example of a schematic configuration of a light detection apparatus 101.
[Fig. 68]

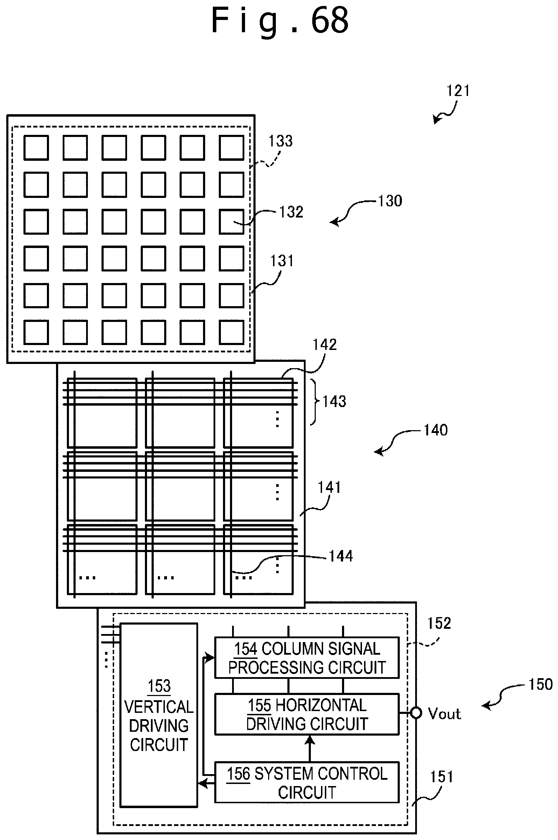

   Fig. 68 is a diagram depicting an example of a schematic configuration of a light detection apparatus 121.
[Fig. 69]

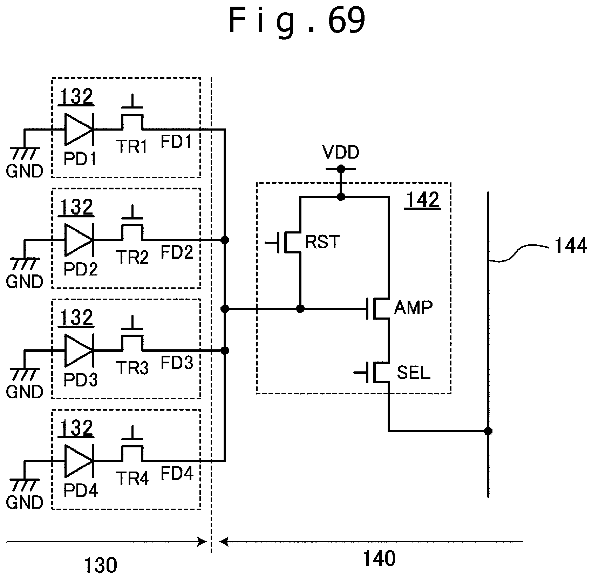

   Fig. 69 is a diagram depicting examples of a sensor pixel 132 and a readout circuit 142.
[Fig. 70]

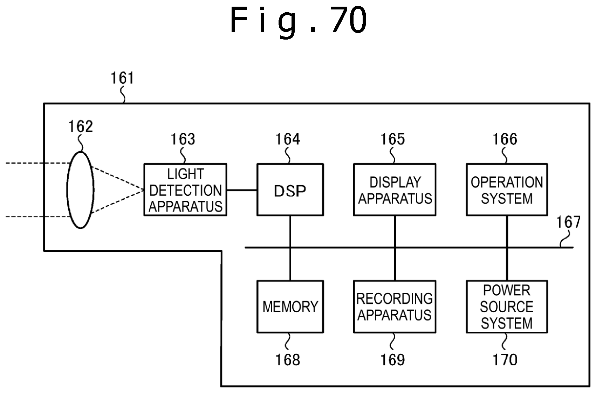

   Fig. 70 is a block diagram depicting an example of a configuration of an electronic apparatus 161.
[Fig. 71]

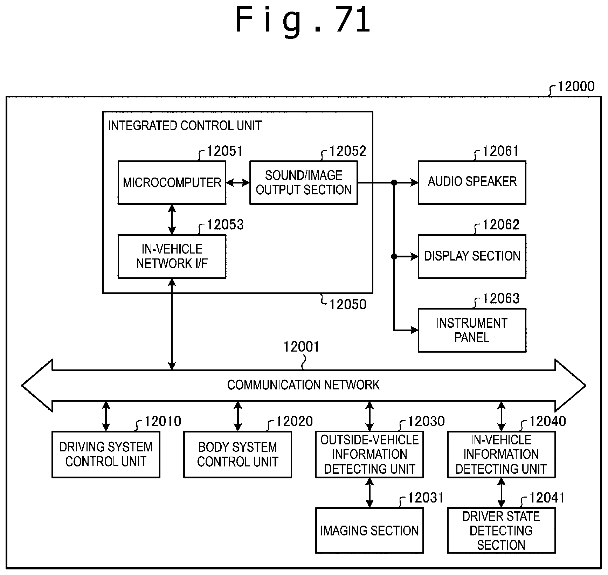

   Fig. 71 is a block diagram depicting an example of a schematic configuration of a vehicle control system.
[Fig. 72]

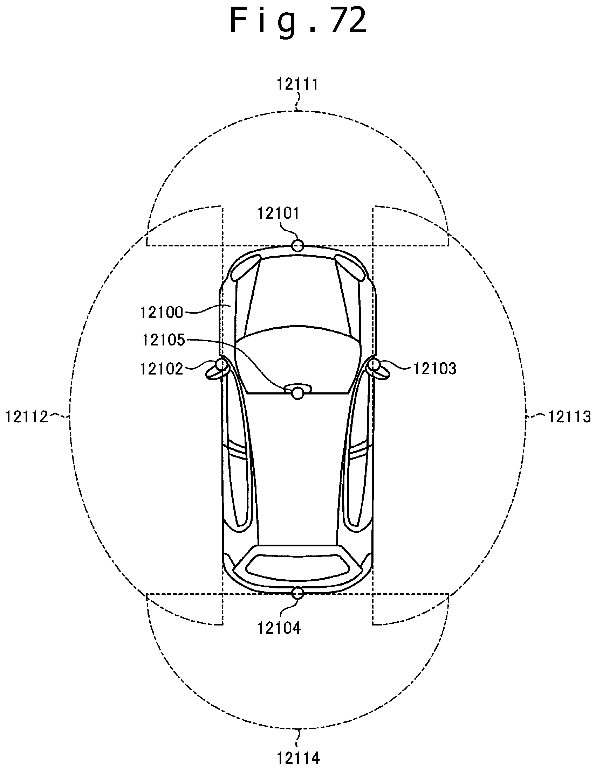

   Fig. 72 is a diagram depicting an example of installation positions of an outside-vehicle information detecting unit and an imaging section.
[Fig. 73]

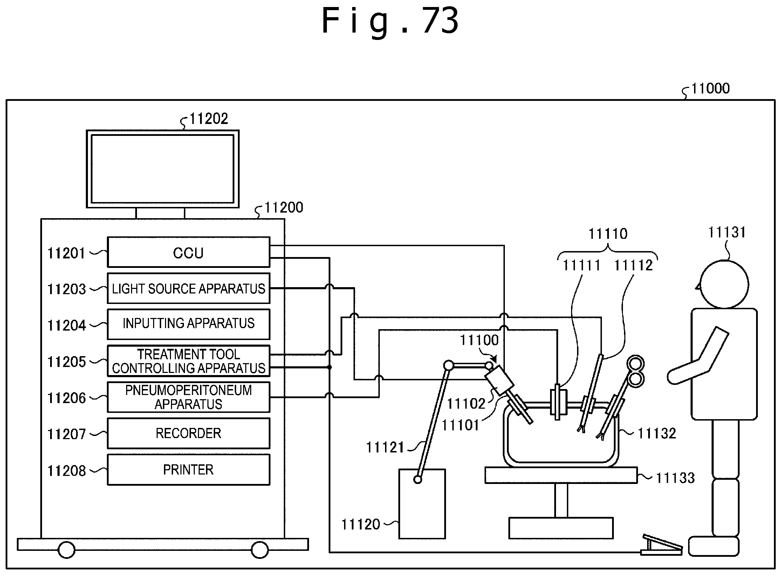

   Fig. 73 is a diagram depicting an example of a schematic configuration of an endoscopic surgery system.
[Fig. 74]

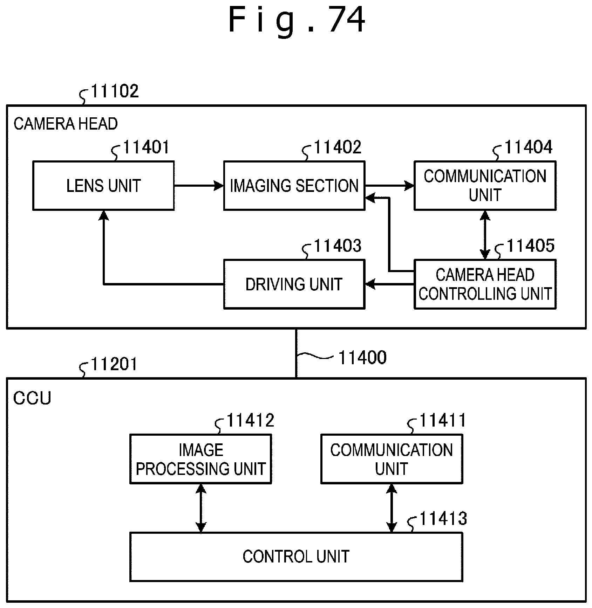

   Fig. 74 is a block diagram depicting an example of functional configurations of a camera head and a CCU.
[Fig. 75]

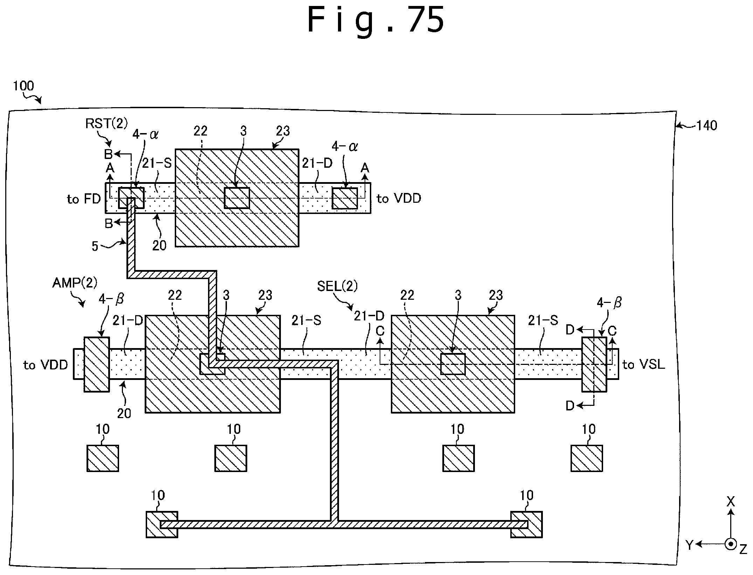

   Fig. 75 is a diagram depicting an example of a schematic configuration of the semiconductor device 100.
[Fig. 76]

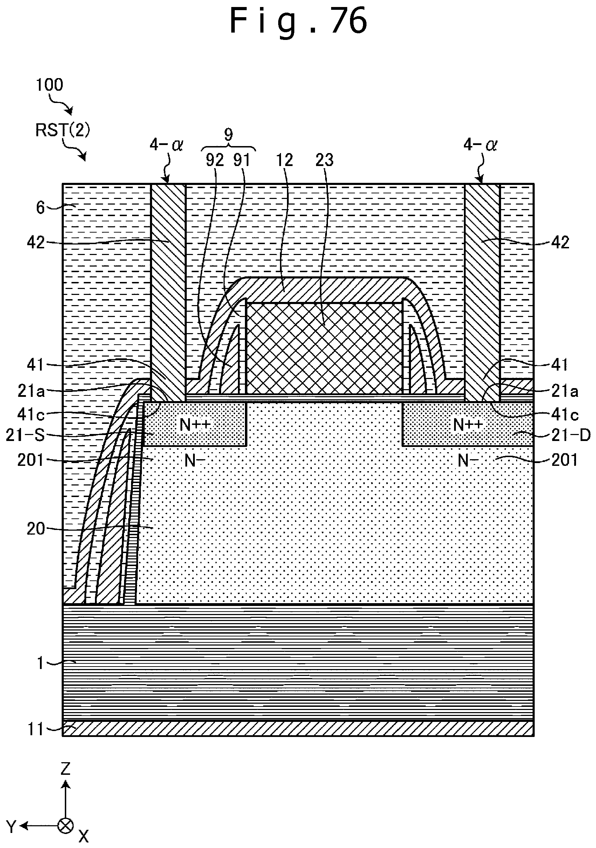

   Fig. 76 is a diagram depicting an example of a schematic configuration of the semiconductor device 100.
[Fig. 77]

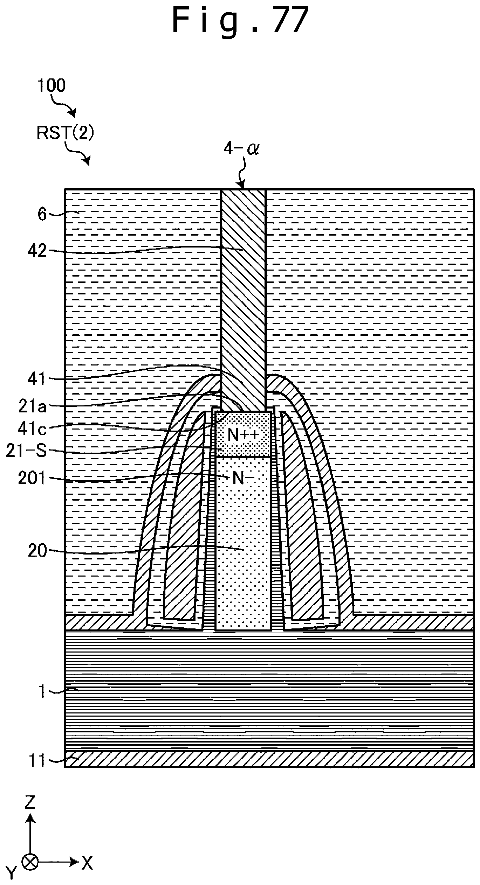

   Fig. 77 is a diagram depicting an example of a schematic configuration of the semiconductor device 100.
[Fig. 78]

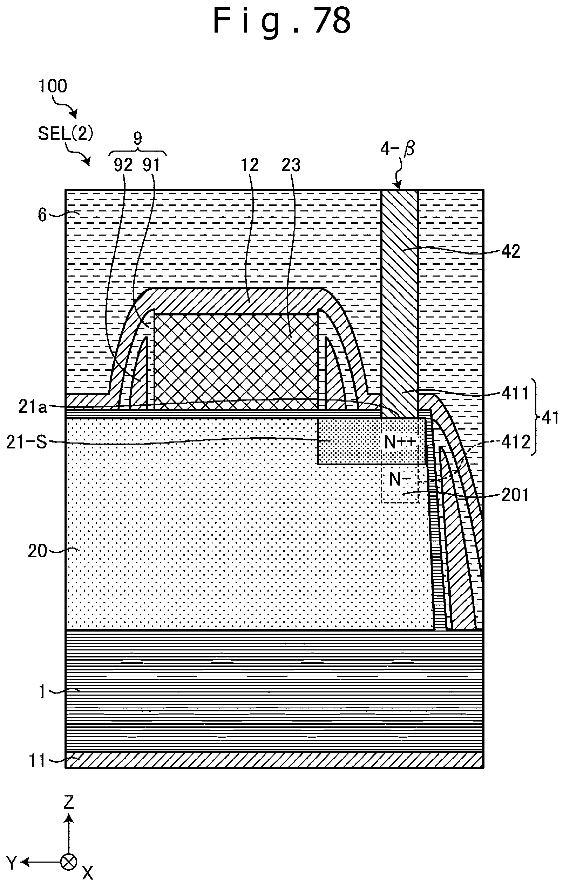

   Fig. 78 is a diagram depicting an example of a schematic configuration of the semiconductor device 100.
[Fig. 79]

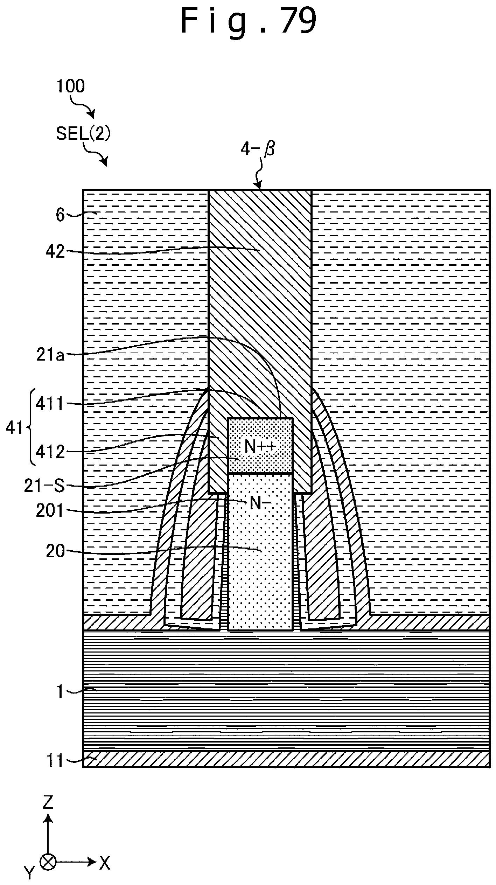

   Fig. 79 is a diagram depicting an example of a schematic configuration of the semiconductor device 100.
[Fig. 80]

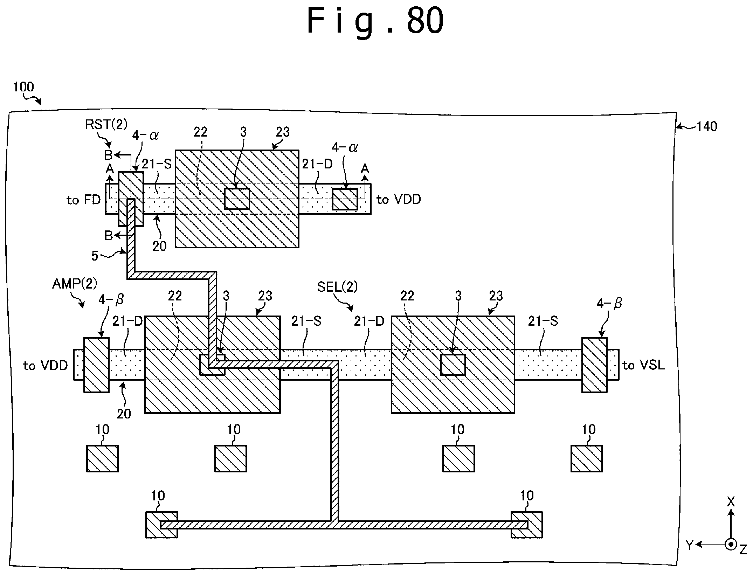

   Fig. 80 is a diagram depicting an example of a schematic configuration of the semiconductor device 100.
[Fig. 81]

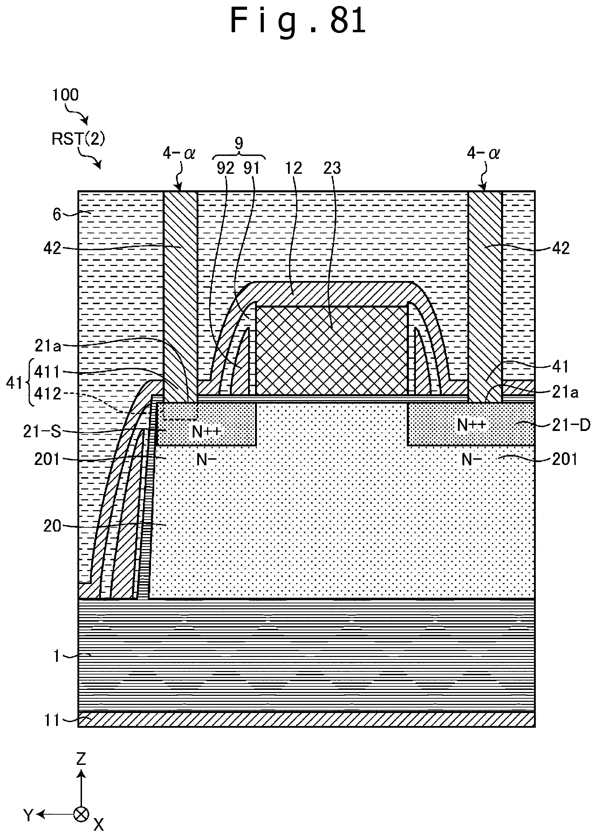

   Fig. 81 is a diagram depicting an example of a schematic configuration of the semiconductor device 100.
[Fig. 82]

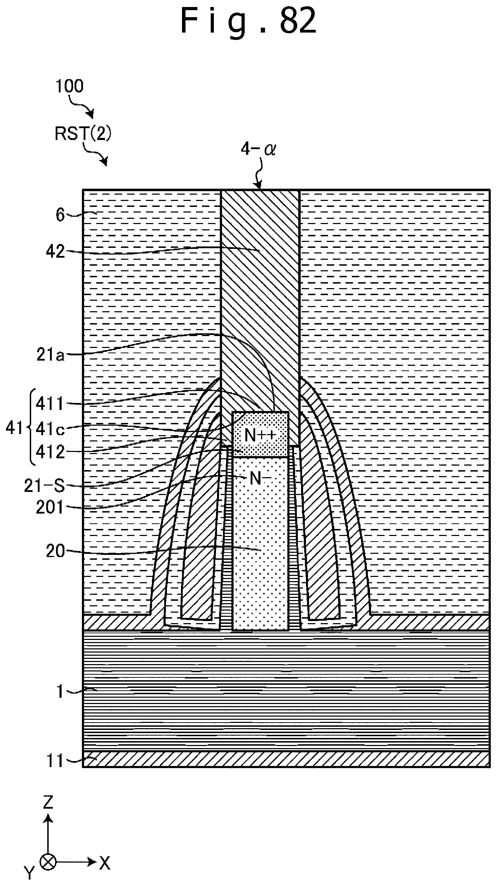

   Fig. 82 is a diagram depicting an example of a schematic configuration of the semiconductor device 100.
[Fig. 83]

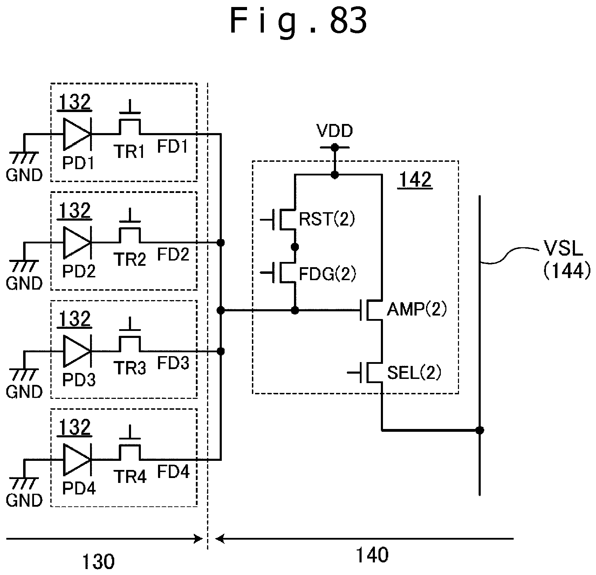

   Fig. 83 is a diagram depicting an example of a circuit.
[Fig. 84]

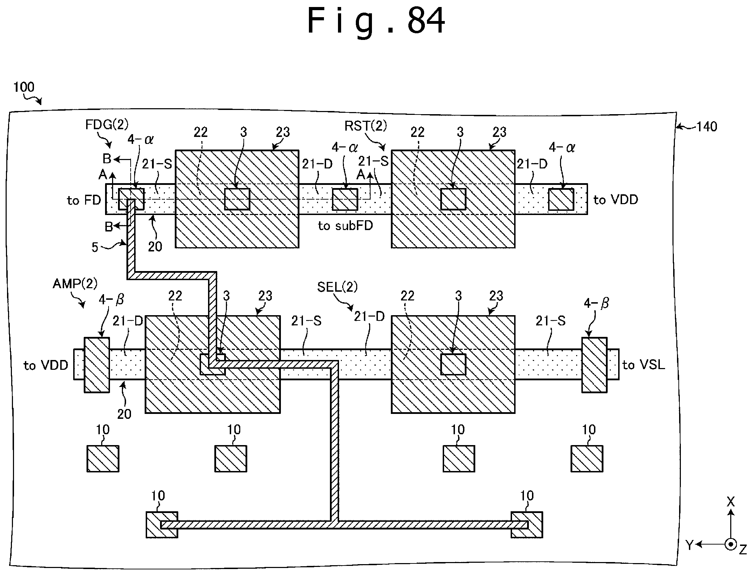

   Fig. 84 is a diagram depicting an example of a schematic configuration of the semiconductor device 100.
[Fig. 85]

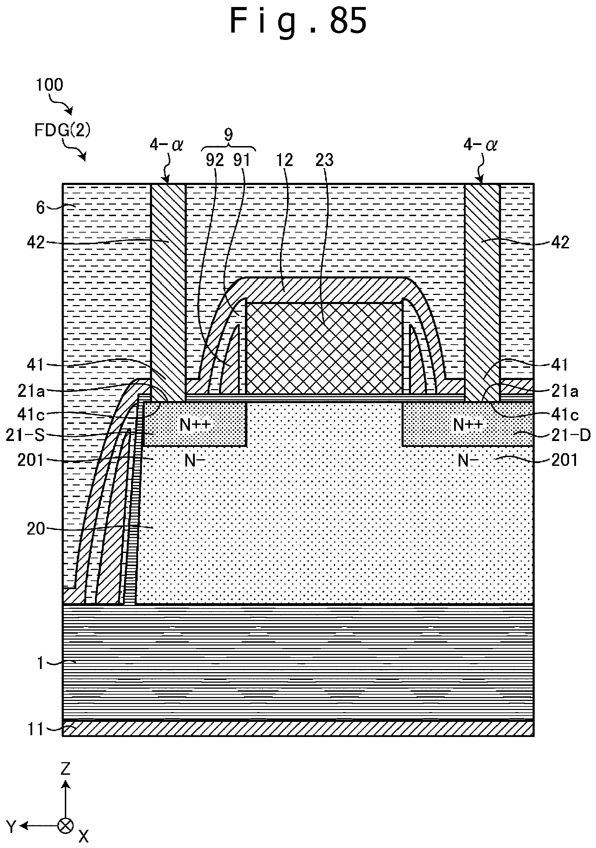

   Fig. 85 is a diagram depicting an example of a schematic configuration of the semiconductor device 100.
[Fig. 86]

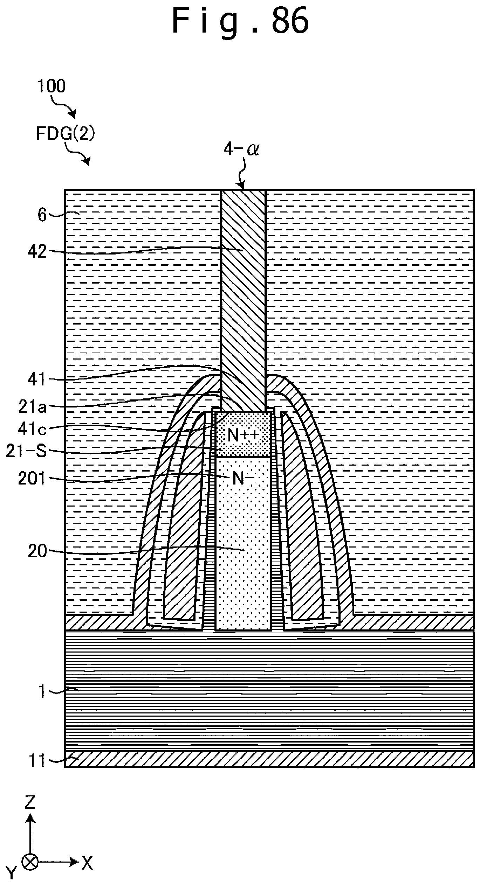

   Fig. 86 is a diagram depicting an example of a schematic configuration of the semiconductor device 100.
[Fig. 87]

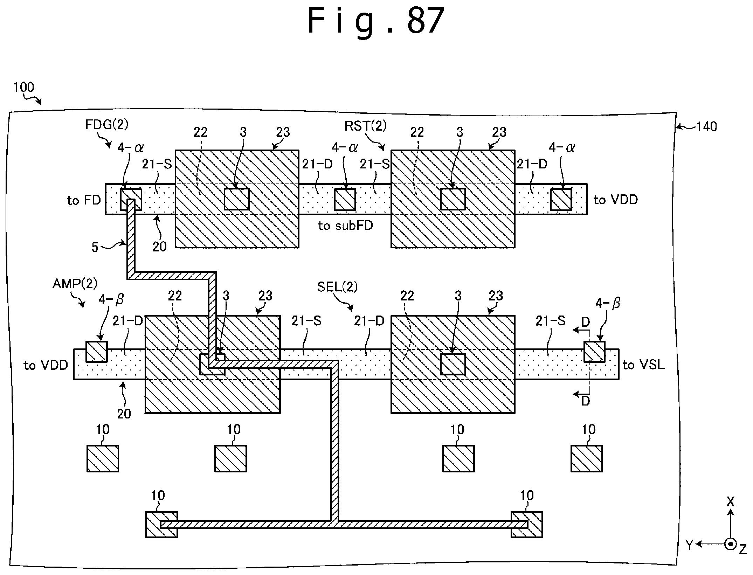

   Fig. 87 is a diagram depicting an example of a schematic configuration of the semiconductor device 100.
[Fig. 88]

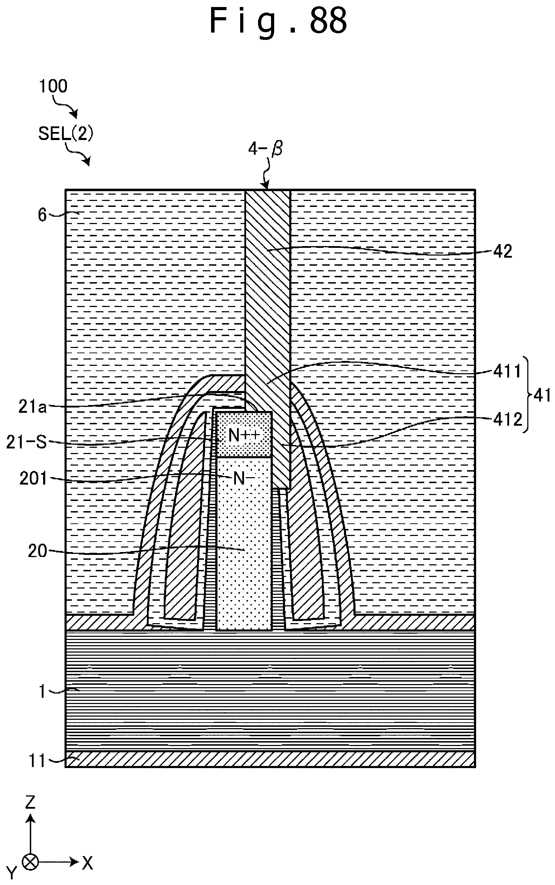

   Fig. 88 is a diagram depicting an example of a schematic configuration of the semiconductor device 100.
[Fig. 89]

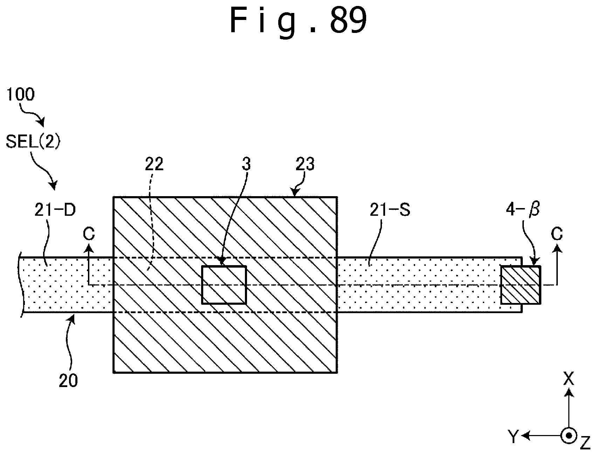

   Fig. 89 is a diagram depicting an example of a schematic configuration of the semiconductor device 100.
[Fig. 90]

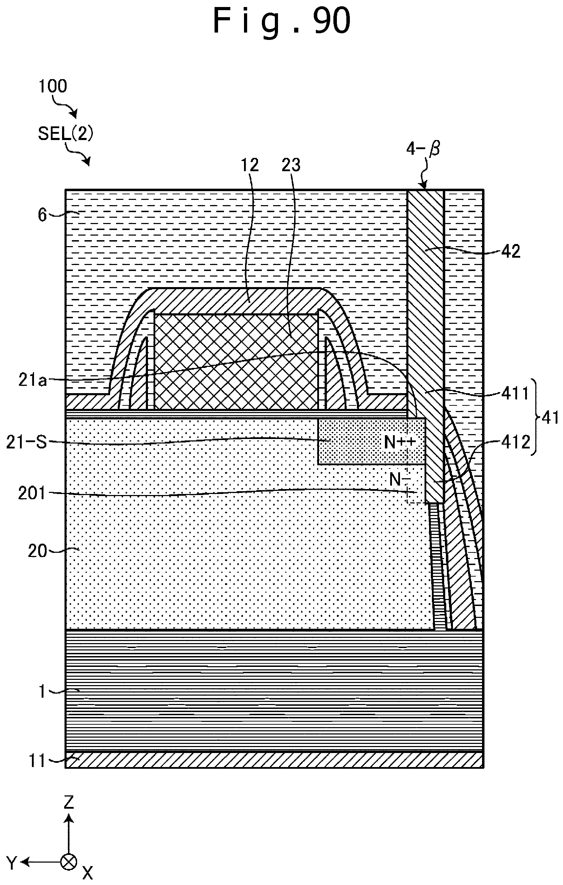

   Fig. 90 is a diagram depicting an example of a schematic configuration of the semiconductor device 100.
[Fig. 91]

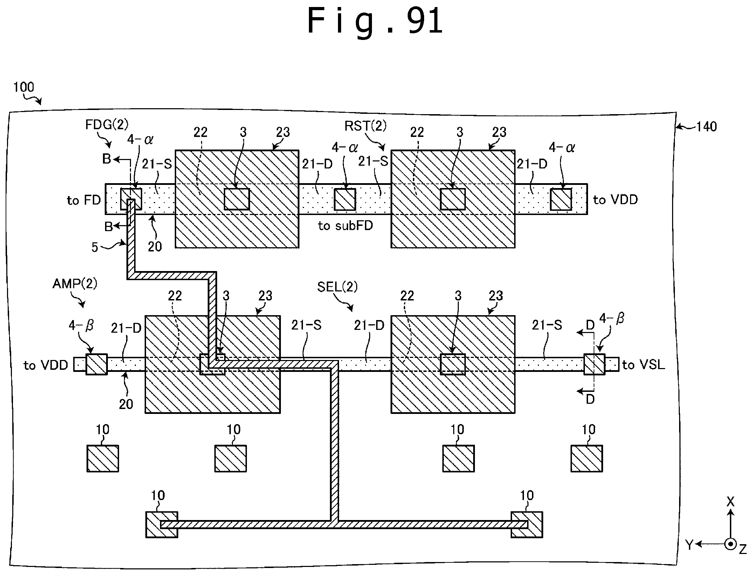

   Fig. 91 is a diagram depicting an example of a schematic configuration of the semiconductor device 100.
[Fig. 92]

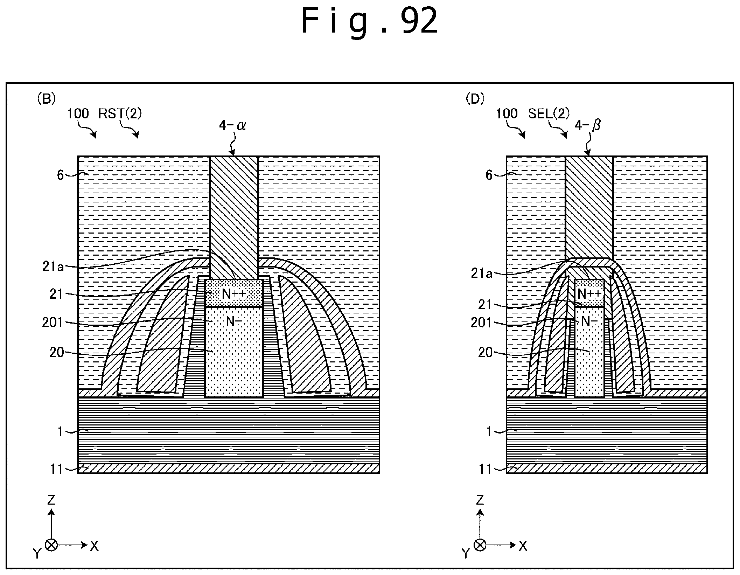

   Fig. 92 is a diagram depicting an example of a schematic configuration of the semiconductor device 100.
[Fig. 93]

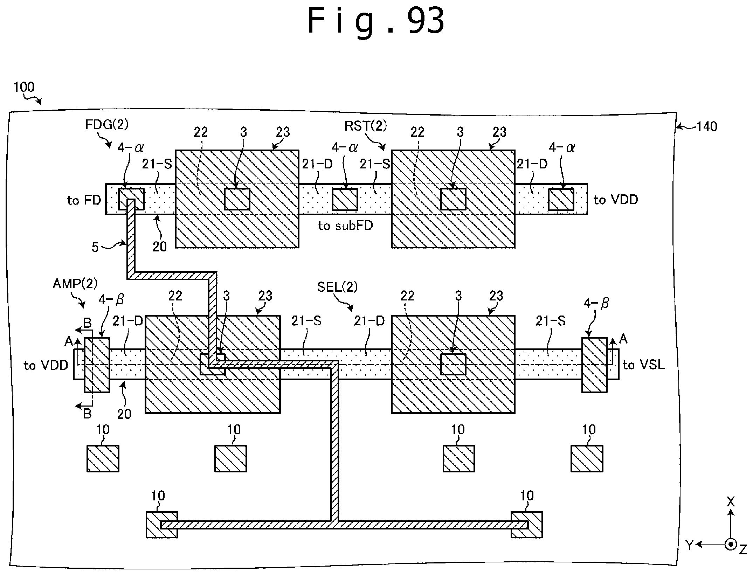

   Fig. 93 is a diagram depicting an example of a schematic configuration of the semiconductor device 100.
[Fig. 94]

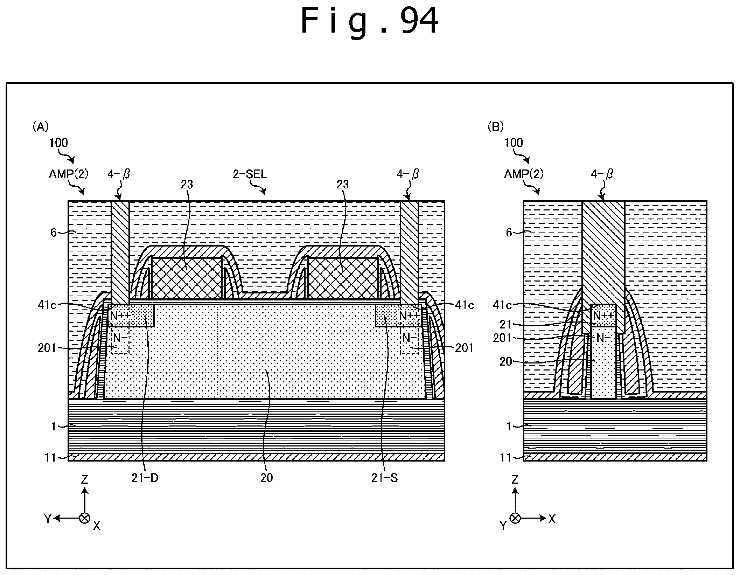

   Fig. 94 is a diagram depicting an example of a schematic configuration of the semiconductor device 100.
[Fig. 95]

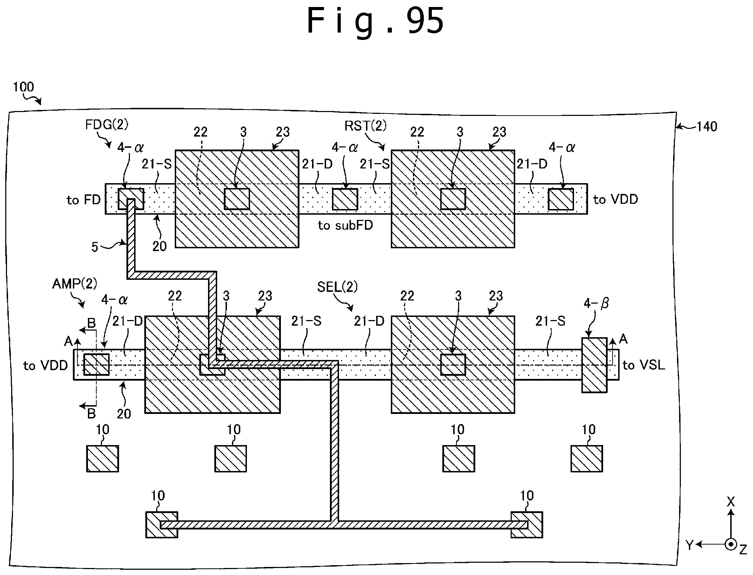

   Fig. 95 is a diagram depicting an example of a schematic configuration of the semiconductor device 100.
[Fig. 96]

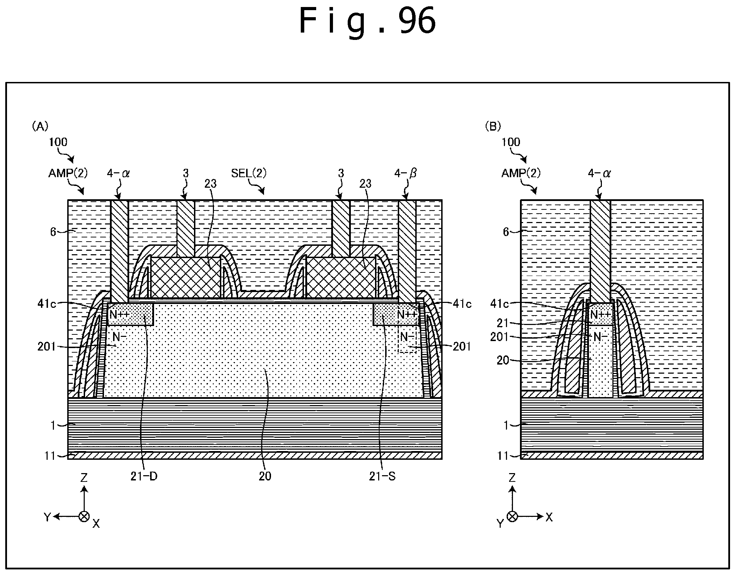

   Fig. 96 is a diagram depicting an example of a schematic configuration of the semiconductor device 100.
[Fig. 97]

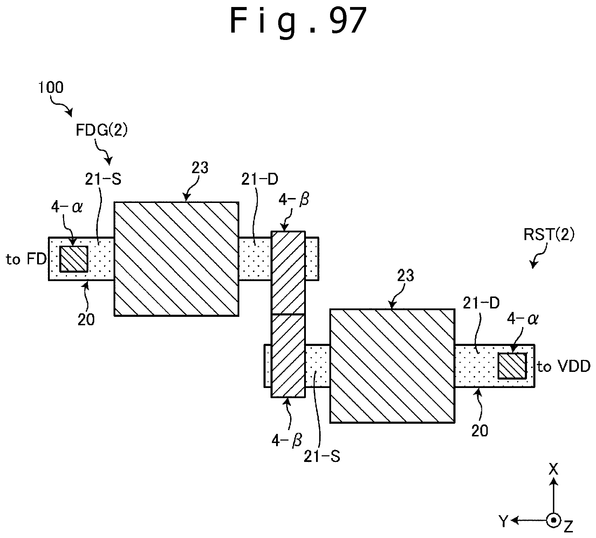

   Fig. 97 is a diagram depicting an example of a schematic configuration of the semiconductor device 100.
[Fig. 98]

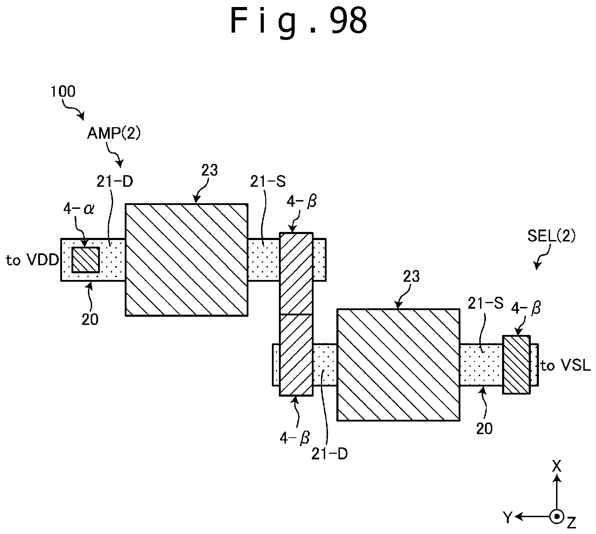

   Fig. 98 is a diagram depicting an example of a schematic configuration of the semiconductor device 100.
[Fig. 99]

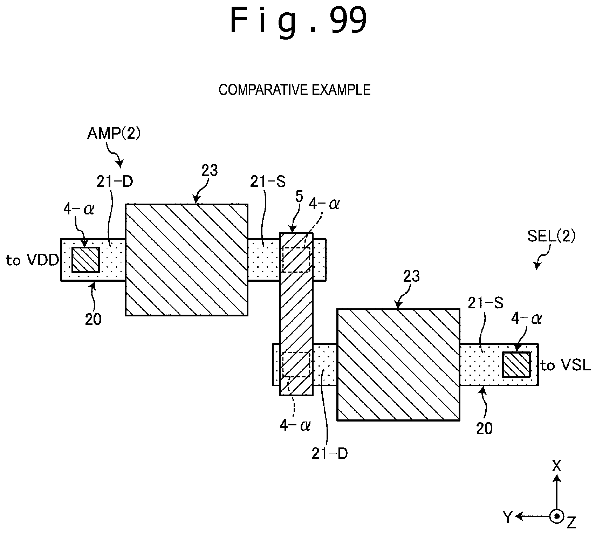

   Fig. 99 is a diagram depicting a comparative example.
[Fig. 100]

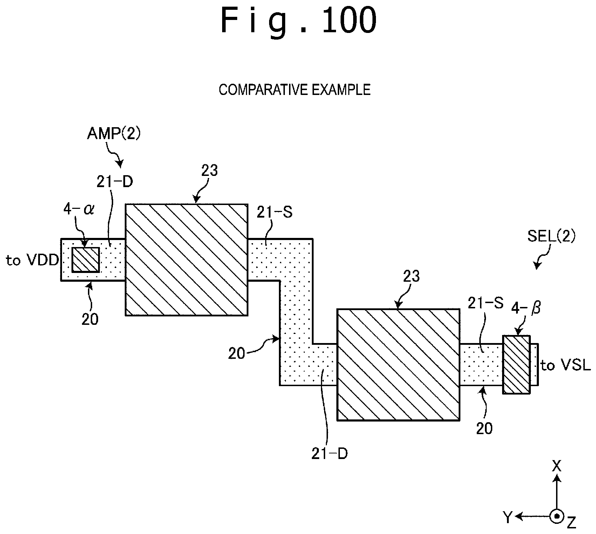

   Fig. 100 is a diagram depicting a comparative example.
[Fig. 101]

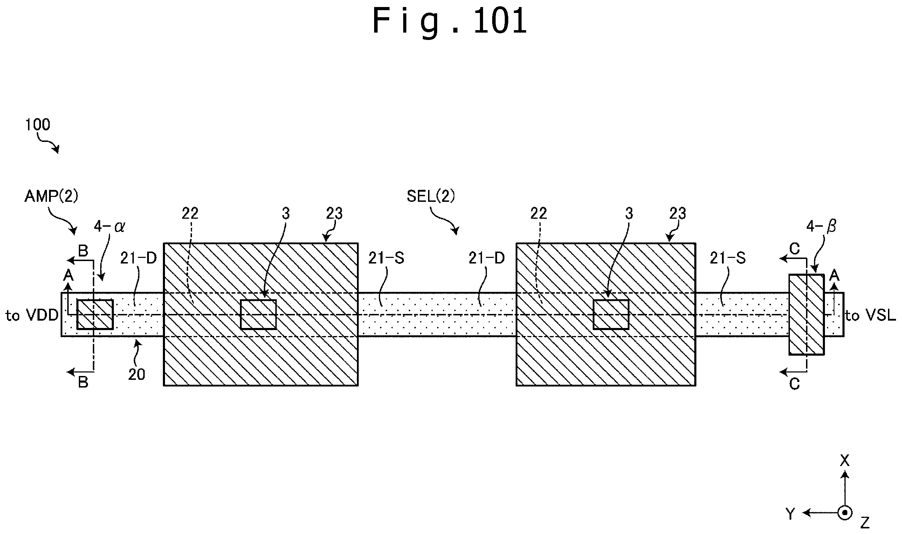

   Fig. 101 is a diagram depicting an example of a manufacturing method for the semiconductor device 100.
[Fig. 102]

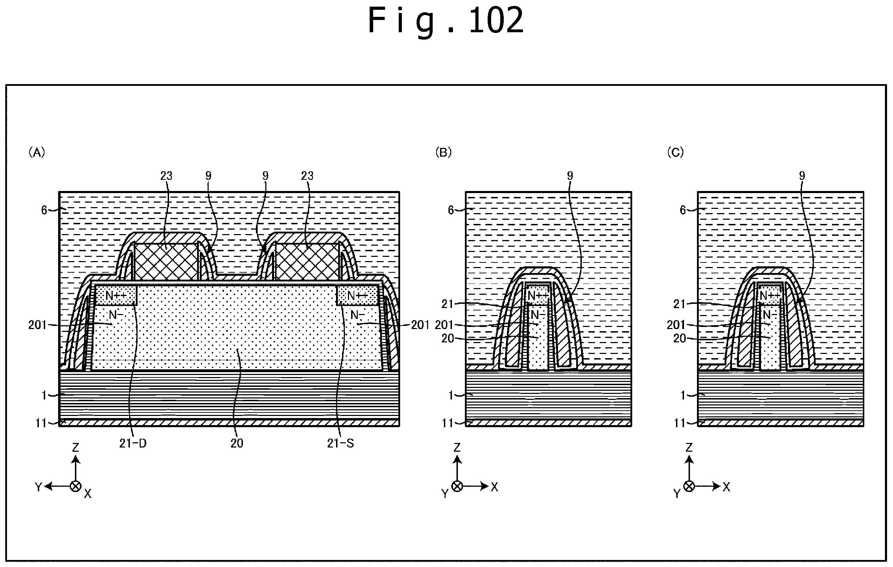

   Fig. 102 is a diagram depicting an example of a manufacturing method for the semiconductor device 100.
[Fig. 103]

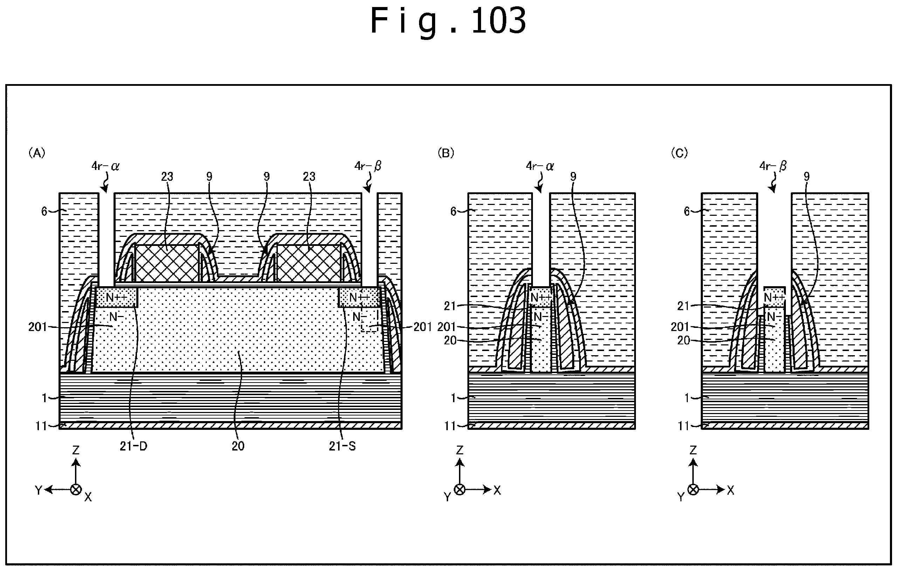

   Fig. 103 is a diagram depicting an example of a manufacturing method for the semiconductor device 100.
[Fig. 104]

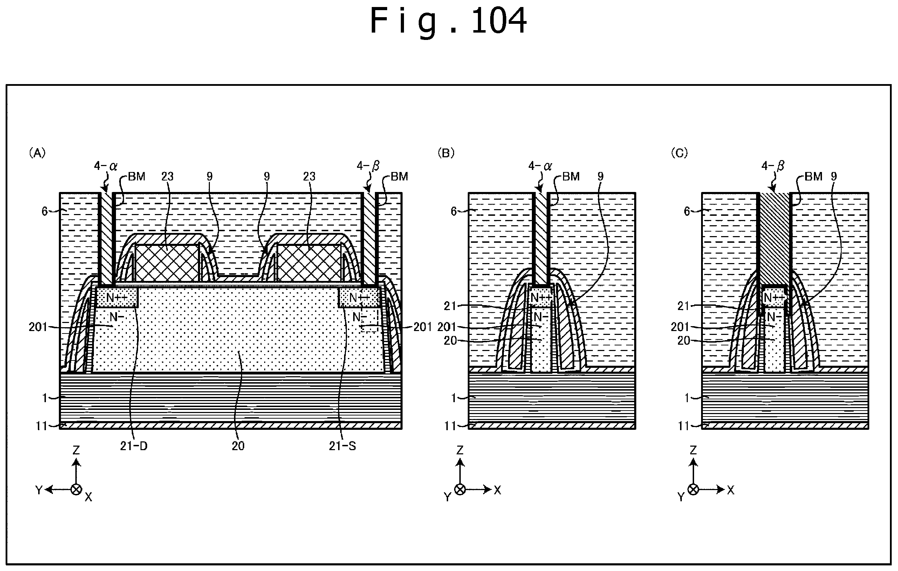

   Fig. 104 is a diagram depicting an example of a manufacturing method for the semiconductor device 100.

### Description of Embodiments

Hereinafter, embodiments of the present disclosure will be described in detail with reference to the drawings. It should be noted that, in the following embodiments, redundant explanations are omitted by assigning the same reference numerals to identical elements.

The present disclosure will be described in the order of the following items.
1. First Embodiment
2. Example/Modification
3. Example of Manufacturing Method
4. Brief Summary
5. Second Embodiment
6. Example/Modification
7. Brief Summary
8. Third Embodiment
9. Example/Modification
10. Example of Manufacturing Method
11. Brief Summary
12. Application Example
12.1 Example of Light Detection Apparatus
12.2 Example of Electronic Apparatus
13. Application Example to Mobile Body
14. Application Example to Endoscopic Surgery System
15. Fourth Embodiment
16. Example/Modification
17. Example of Manufacturing Method
18. Brief Summary

### 1. First Embodiment

Figs. 1 to 4 are diagrams depicting an example of a schematic configuration of a semiconductor device 100. Fig. 1 depicts an external appearance of the semiconductor device 100. Fig. 2 depicts an external appearance of a contactor 4 (described later). Fig. 3 depicts a cross section taken along line A-A of Fig. 1 (XZ plane passing through line A-A). Fig. 4 depicts a cross section taken along line B-B of Fig. 1 (YZ plane passing through line B-B). For convenience of description, some portions that are located at overlapping positions as viewed in the direction of Fig. 4 are indicated with broken lines. Note that unless otherwise specified, the drawings depicting the semiconductor device 100 may be understood as depicting a part of the semiconductor device 100.

The semiconductor device 100 includes an insulating layer 1, a semiconductor portion 20, a transistor 2, a contactor 3, and the contactor 4. As the material of the insulating layer 1, various publicly known materials may be used. Examples of the material include silicon oxide (SiO2). Note that a layer may be interpreted to mean a film, and these terms may be appropriately read interchangeably to the extent that no inconsistency arises.

An XYZ coordinate system is also depicted in the drawings. The X-axis direction and the Y-axis direction (XY plane direction) correspond to the surface direction of the insulating layer 1. The Z-axis direction corresponds to the thickness direction of the insulating layer 1. The Z-axis direction is also referred to as a vertical direction or the like. The upward direction corresponds to the Z-axis positive direction, and the downward direction corresponds to the Z-axis negative direction. The surface on the Z-axis positive direction side in the insulating layer 1 is referred to as top surface 1a and depicted in the drawings.

The semiconductor portion 20 is a semiconductor portion having an island shape. The semiconductor portion 20 has, for example, a cuboid shape, and in that case, the semiconductor portion 20 may be defined by the top surface, bottom surface and four side surfaces. In this example, the semiconductor portion 20 is provided to protrude from the top surface 1a of the insulating layer 1. In plan view (as viewed in the Z-axis negative direction), the semiconductor portion 20 may be located inside the insulating layer 1. In side view (as viewed in the X-axis direction or the Y-axis direction), the insulating layer 1 and the semiconductor portion 20 have a protruding shape as a whole, and the protruding portion may correspond to the semiconductor portion 20. In the example depicted in Fig. 1, the semiconductor portion 20 has a rectangular shape extending in the Y-axis direction as its longitudinal direction. Examples of the material of the semiconductor portion 20 include silicon (Si).

The transistor 2 includes an S/D region 21, a channel region 22, and a gate electrode 23. The S/D region 21 may be understood as meaning at least one of the source region and the drain region. The source region is referred to and depicted as source region 21-S. The drain region is referred to and depicted as drain region 21-D. When they are not particularly distinguished, they are simply referred to as S/D region 21. Within a scope free from contradiction, the S/D region 21 may be interpreted as either or both of the source region 21-S and the drain region 21-D.

The S/D region 21 is formed in the semiconductor portion 20. The S/D region 21 is a region having a higher impurity concentration than other portions of the semiconductor portion 20. The S/D region 21 in the semiconductor portion 20 can be said to be a so-called N+ region. The regions other than the S/D region 21 can be said to be so-called N- semiconductor regions.

The channel region 22 is a region located between the source region 21-S and the drain region 21-D in the semiconductor portion 20. In the Y-axis positive direction, the source region 21-S, the channel region 22 and the drain region 21-D are located in this order.

The surface on the Z-axis positive direction side in the S/D region 21 is referred to and depicted as top surface 21a. The surface on the X-axis negative direction side is referred to and depicted as side surface 21c-1. The surface on the X-axis positive direction side is referred to and depicted as side surface 21c-2. The top surface 21a, the side surface 21c-1 and the side surface 21c-2 are exposed on the surface of the semiconductor portion 20. The side surface 21c-1 and the side surface 21c-2 are a pair of side surfaces opposite to each other. When the side surface 21c-1 and the side surface 21c-2 are not particularly distinguished, they are simply referred to as side surface 21c.

The gate electrode 23 is provided to face the channel region 22. The gate electrode 23 is provided to cover the top surface (the surface on the Z-axis positive direction side) and the side surfaces (the surface on the X-axis positive direction side and the surface on the X-axis negative direction side) of the channel region 22 through an insulating film not depicted in the drawing, for example. The surface on the Z-axis positive direction side in the gate electrode 23 is referred to and depicted as top surface 23a. Examples of the material of the gate electrode 23 include polycrystalline silicon.

The transistor 2 configured with the semiconductor portion 20 protruding on the upper side of the insulating layer 1 as described above is also called a fin-type transistor.

The contactor 3 is connected to the gate electrode 23. In this example, the contactor 3 is in contact with the top surface 23a of the gate electrode 23, and extends upward from the top surface. The material of the contactor 3 may be a metal material. Examples of the material include tungsten (W).

The contactor 4 is connected to the S/D region 21 of the transistor 2. The contactor 4 extends upward from the S/D region 21. The contactor 4 includes two contactors. The first contactor is referred to and depicted as contactor 4-1. The second contactor is referred to and depicted as contactor 4-2. The contactor 4-1 is connected to the source region 21-S. The contactor 4-2 is connected to the drain region 21-D. When the contactor 4-1 and the contactor 4-2 are not particularly distinguished, they are simply referred to as contactor 4 (e.g., Fig. 3). The material of the contactor 4 may be a metal material as with the material of the contactor 3. Examples of the material include tungsten.

In the example depicted in Figs. 1 to 4, the contactor 4 includes a contact portion 41 and an extraction portion 42.

The contact portion 41 is in contact with the S/D region 21. Specifically, the contact portion 41 includes a base portion 411 and an extension portion 412 so as to be in contact with the top surface 21a and the side surface 21c of the S/D region 21. In this example, the extension portion 412 is a pair of extension portions, one of which is referred to as extension portion 412-1, and the other is referred to and depicted as extension portion 412-2. When they are not particularly distinguished, they are simply referred to as extension portion 412.

The base portion 411 extends to face the top surface 21a of the S/D region 21. The surface on the Z-axis positive direction side in the base portion 411 is referred to and depicted as top surface 411a. The surface on the Z-axis negative direction side is referred to and depicted as bottom surface 411b. The bottom surface 411b of the base portion 411 is in contact with the top surface 21a of the S/D region 21. The contact may be an electrical contact, and may be understood not only as meaning direct contact between two elements but also as including contact through another member such as a conductive film, for example.

Note that the top surface 411a of the base portion 411 may also be regarded as the top surface of the contact portion 41. In the following description, the top surface 411a of the base portion 411 may be simply referred to as the top surface 411a of the contact portion 41.

In the example depicted in Figs. 1 to 4, the top surface 411a of the contact portion 41 is located at the same height as the top surface 23a of the gate electrode 23. The base portion 411 of the contact portion 41 can be said to have the same thickness as the thickness (Z-axial length) of the gate electrode 23. Such a configuration of the contact portion 41 and the gate electrode 23 may be obtained by a typical machining using chemical mechanical polishing (CMP), for example. An example of the manufacturing method is described later with reference to Figs. 17 to 24.

The length of the contact portion 41 in the XY plane direction is also referred to as the width of the contact portion 41. The area of the contact portion 41 in plan view is also referred to as the area of the contact portion 41. Unless otherwise specified, the width and the area of the contact portion 41 mean the width and the area of the base portion 411.

The extension portion 412 extends downward so as to be in contact with the side surface 21c of the S/D region 21 from the end portion of the base portion 411 in the X-axis direction. Specifically, as depicted in Fig. 3, the extension portion 412-1 extends downward from the end portion of the base portion 411 on the X-axis negative direction side. The extension portion 412-2 extends downward from the end portion of the base portion 411 on the X-axis positive direction side.

The extension portion 412 includes a contact surface 412c that is in contact with the side surface 21c of the S/D region 21 and extends downward. Specifically, the contact surface 412c of the extension portion 412-1 is referred to and depicted as contact surface 412c-1. The contact surface 412c-1 is in contact with the side surface 21c-1 of the S/D region 21. The contact surface 412c of the extension portion 412-2 is referred to and depicted as contact surface 412c-2. The contact surface 412c-2 is in contact with the side surface 21c-2 of the S/D region 21. Note that the contact surface 412c of the extension portion 412 may be in contact with the side surface of the semiconductor portion 20 located on the lower side of the S/D region 21.

The extraction portion 42 extends upward from the top surface 411a of the contact portion 41. The surface on the Z-axis positive direction side in the extraction portion 42 is referred to and depicted as top surface 42a. The surface on the Z-axis negative direction side is referred to and depicted as bottom surface 42b. The bottom surface 42b of the extraction portion 42 is in contact with the top surface 411a of the contact portion 41. Note that the contact portion 41 and the extraction portion 42 may be substantially integrally formed with the same material, and in that case, the top surface 411a of the contact portion 41 and the bottom surface 42b of the extraction portion 42 may be understood as a virtual surface.

The length of the extraction portion 42 in the XY plane direction is also referred to as the width of extraction portion 42. The area of the extraction portion 42 in plan view is also referred to as the area of the extraction portion 42. The area of the extraction portion 42 may increase as the width of the extraction portion 42 increases. In this sense, the width and the area of the extraction portion 42 may be appropriately interpreted as being interchangeable with each other.

The extraction portion 42 may extend with a constant area and in that case, the area of the extraction portion 42 at each position in the Z-axis direction is the same. That area is the same as the area of the top surface 42a, and the same as the area of the bottom surface 42b.

In the example depicted in Figs. 1 to 4, in plan view, the extraction portion 42 has an area smaller than the area of the contact portion 41. Specifically, the area of the bottom surface 42b (or the top surface 42a) of the extraction portion 42 is smaller than the area of the top surface 411a of the contact portion 41.

In the embodiment, the area of the extraction portion 42 is smaller than the sum of the area of the side surface 21c and the area of the top surface 21a of the S/D region 21 in contact with the contact portion 41. The following Equation (1) holds, where an area S1 is the area of the contact surface 412c-1, an area S2 is the area of the bottom surface 411b, an area S3 is the area of the contact surface 412c-2, and an area S4 is the area of the extraction portion 42 (the area of the top surface 42a or the bottom surface 42b).$S 4 < S 1 + S 2 + S 3$

In the semiconductor device 100 having the above-described configuration, the contactor 4 is in contact not only with the top surface 21a of the S/D region 21 but also with the side surface 21c. In this manner, the electrical connection to the S/D region 21 is enhanced in comparison with the case where the contactor 4 is in contact only with the top surface 21a of the S/D region 21.

In the transistor 2 configured with the semiconductor portion 20 provided on the insulating layer 1, carriers are likely to remain and accumulate in the portion located on the lower side of the S/D region 21 in the semiconductor portion 20. Specifically, holes are likely to accumulate in the portion located on the lower side of the source region 21-S. Such a phenomenon is also referred to as parasitic bipolar operation. Due to the parasitic bipolar operation, the potential barrier of the electrons is lowered, and the ease of flow of electrons is increased, which might result in an increase in the current when the power is off (OFF leakage current).

With the above-described semiconductor device 100, the contactor 4 is in contact with the S/D region 21 at a position deeper than the top surface 21a of the S/D region 21, and thus the carriers that may be accumulated in the portion located on the lower side of the S/D region 21 in the semiconductor portion 20 are easily discharged. It is possible to suppress the increase in the above-described OFF leakage current. It is also possible to increase the impurity concentration of the S/D region 21. Through the reduction in resistance value, the improvement in conversion efficiency (e.g., transconductance gm), the reduction in random noise and the like, the performance of the transistor 2 can be improved.

To improve the conversion efficiency of the transistor 2, it is also important to address parasitic capacitance. If the surface area of the contactor 4 is large, parasitic capacitance might become prominent. In the present embodiment, the area of the extraction portion 42 of the contactor 4 is smaller than the area of the contact portion 41, and accordingly the overall surface area of the contactor 4 is reduced. In this manner, the parasitic capacitance that might occur due to the size of the surface area of the contactor 4 can be reduced. The reduction in the conversion efficiency of the transistor 2 that might be caused by parasitic capacitance can be suppressed.

### 2. Example/Modification

Some examples or modifications based on the above-described technology of the first embodiment are described below. In the embodiment, the height of the contact portion 41 may be reduced. Description will be made with reference to Figs. 5 and 6.

Figs. 5 and 6 are diagrams depicting an example of a schematic configuration of the semiconductor device 100. (A) in each drawing depicts a cross section of the semiconductor device 100 as viewed in the X-axis negative direction. (B) in each drawing depicts a cross section of the semiconductor device 100 as viewed in the Y-axis positive direction. Note that a wiring line 5 included in the wiring layer located on the upper side of the contactor 4 is also depicted in the drawing. The contactor 4-1 extends from the source region 21-S to the wiring line 5. The contactor 4-2 extends from the drain region 21-D to the wiring line 5.

In the example depicted in Fig. 5, the top surface 411a of the contact portion 41 is located at a position (the Z-axis negative direction side) lower than the top surface 23a of the gate electrode 23. The base portion 411 of the contact portion 41 can be said to have a smaller thickness than the gate electrode 23. Such a configuration of the contact portion 41 and the gate electrode 23 can be obtained by performing dry etching on the material of the contactor 4, for example. An example of the manufacturing method is described later with reference to Figs. 25 to 31.

In the example depicted in Fig. 6, the top surface 411a of the contact portion 41 is further lowered. Such a contact portion 41 may be formed as a silicide film. Examples of silicide include tungsten silicide (SiW). In addition, silicide composed of combinations of silicon and various metals may also be used.

In the embodiment, the extraction portion 42 of only one of the contactor 4-1 and the contactor 4-2 may have an area smaller than the area of the contact portion 41. Description will be made with reference to Fig. 7.

Fig. 7 is a diagram depicting an example of a schematic configuration of the semiconductor device 100. (A) of Fig. 7 depicts a cross section of the semiconductor device 100 as viewed in the X-axis negative direction. (B) of Fig. 7 depicts a cross section as viewed in the Y-axis positive direction. In the example depicted in Fig. 7, the extraction portion 42 of the contactor 4-1 has an area smaller than the area of the contact portion 41 as described above. On the other hand, the contactor 4-2 does not include such a contact portion 41 and an extraction portion 42. The contactor 4-2 has a constant area and extends from the top surface 21a of the drain region 21-D to the wiring line 5.

Note that contrary to the configuration depicted in Fig. 7, the contactor 4-2 may include the extraction portion 42 having an area smaller than the area of the contact portion 41. In that case, the contactor 4-1 may have a constant area and extend from the top surface 21a of the source region 21-S to the wiring line 5.

In the embodiment, the transistor 2 may be a multi-fin-type transistor. Even in this case, the above-described technology may be adopted. Description will be made with reference to Fig. 8.

Fig. 8 is a diagram depicting an example of a schematic configuration of the semiconductor device 100. The transistor 2 is a multi-fin-type transistor. More specifically, in this example, the transistor 2 is a two-fin-type transistor, and the semiconductor portion 20 includes two semiconductor portions provided spaced apart from each other. The first semiconductor portion is referred to and depicted as semiconductor portion 20-1. The second semiconductor portion is referred to and depicted as semiconductor portion 20-2. When the semiconductor portion 20-1 and the semiconductor portion 20-2 are not particularly distinguished, they are simply referred to as semiconductor portion 20.

Note that Fig. 8 also depicts an insulating material 6 provided to fill the region around the semiconductor portion 20. Various publicly known materials may be used, and examples of the material include silicon oxide. Although not depicted in Fig. 8, the region between the insulating material 6 and the wiring line 5 may also be filled with the same material as the insulating material 6. The same applies to the above-described configurations (e.g., Figs. 3 to 7).

The S/D region 21 of the transistor 2 is formed in each of the semiconductor portion 20-1 and the semiconductor portion 20-2. The S/D region 21 formed in the semiconductor portion 20-1 is referred to and depicted as S/D region 21-1. The S/D region 21 formed in the semiconductor portion 20-2 is referred to and depicted as S/D region 21-2. The S/D region 21-1 and the S/D region 21-2 are electrically connected and function as the S/D region 21 (one source region 21-S and one drain region 21-D) as a whole. When the S/D region 21-1 and the S/D region 21-2 are not particularly distinguished, they are simply referred to as S/D region 21.

The S/D region 21-1 and the S/D region 21-2 include the side surfaces 21c exposed on the surfaces of the semiconductor portion 20-1 and the semiconductor portion 20-2, respectively. More specifically, the S/D region 21-1 includes the side surface 21c-1 and the side surface 21c-2, which are a pair of side surfaces exposed on the surface of the semiconductor portion 20-1. The S/D region 21-2 includes the side surface 21c-1 and the side surface 21c-2, which are a pair of side surfaces exposed on the surface of the semiconductor portion 20-2.

The contact portion 41 of the contactor 4 is in contact with the side surfaces 21c of the S/D region 21-1 and the S/D region 21-2. More specifically, the contact portion 41 is in contact with the side surface 21c-1 and the side surface 21c-2 of the S/D region 21-1, and with the side surface 21c-1 and the side surface 21c-2 of the S/D region 21-2.

The base portion 411 of the contact portion 41 extends to face the top surfaces 21a of the S/D region 21-1 and the S/D region 21-2. The base portion 411 includes two bottom surfaces 411b. One bottom surface 411b is in contact with the top surface 21a of the S/D region 21-1. The other bottom surface 411b is in contact with the top surface 21a of the S/D region 21-2.

The extension portion 412-1 of the contact portion 41 includes the contact surface 412c-1 that extends downward and is in contact with the side surface 21c-1 of the S/D region 21-1. The extension portion 412-2 includes the contact surface 412c-2 that extends downward and is in contact with the side surface 21c-2 of the S/D region 21-2.

The contact portion 41 further includes a third extension portion. The third extension portion is referred to and depicted as extension portion 412-3. The extension portion 412-3 extends downward from the center portion of the base portion 411. The extension portion 412-3 includes the contact surface 412c-2 that extends downward and is in contact with the side surface 21c-2 of the S/D region 21-1. In addition, the extension portion 412-3 includes the contact surface 412c-1 that extends downward and is in contact with the side surface 21c-1 of the S/D region 21-2.

The extraction portion 42 has an area smaller than the area of the contact portion 41. In this example, the extraction portion 42 extends upward from a portion of the top surface 411a of the base portion 411 on the side opposite to the base portion 411 with the extension portion 412-3 of the contact portion 41 therebetween. The area of the extraction portion 42 may be smaller than the area of the extension portion 412-3.

By using the contactor 4 including the contact portion 41 and the extraction portion 42 described above, parasitic capacitance can be suppressed as described above. Description will be made with reference also to Fig. 9.

Fig. 9 is a diagram depicting an example of a schematic configuration of the semiconductor device 100. It schematically depicts a planar layout of a part of the semiconductor device 100. For convenience of description, some elements are provided with the same hatching as described above. As the transistor 2 included in the semiconductor device 100, four transistors are exemplified. The first transistor is referred to and depicted as transistor 2-1. The second transistor is referred to and depicted as transistor 2-2. The third transistor is referred to and depicted as transistor 2-3. The fourth transistor is referred to and depicted as transistor 2-4. When they are not particularly distinguished, they are simply referred to as transistor 2. An example of the role of each transistor 2 will be described later with reference to Fig. 69.

In the example depicted in Fig. 9, the transistor 2-1 is a two-fin-type transistor. The cross section taken along line A-A of Fig. 9 may correspond to the configuration of Fig. 8 described above. In the semiconductor portion 20-1, the S/D region 21 of the transistor 2-1 is formed, and the S/D region 21 of the transistor 2-2 electrically connected to the S/D region 21 of the transistor 2-1 is formed. In the semiconductor portion 20-2, the S/D region 21 of the transistor 2-1 is formed.

The parasitic capacitance that might occur at the transistor 2-1 and its surroundings is schematically depicted by a dashed line as a capacitor. For example, the parasitic capacitance occurs between the wiring line 5 and (the surface portion of) the extraction portion 42 of the contactor 4. As described above, the area of the extraction portion 42 of the contactor 4 is smaller than the area of the contact portion 41, and therefore the overall surface area of the contactor 4 is small. The parasitic capacitance that might occur due to the size of the surface area of the contactor 4 can be reduced.

In the contactor 4 connected to the multi-fin-type transistor 2 as well, the height of the base portion 411 of the contact portion 41 can be reduced. Description will be made with reference to Fig. 10.

Fig. 10 is a diagram depicting an example of a schematic configuration of the semiconductor device 100. In comparison with the configuration depicted in Fig. 8 described above, the base portion 411 of the contact portion 41 has a smaller thickness. As the contact portion 41, a silicide film may be used. Since the surface area of the contactor 4 is further reduced, the effect of reducing the parasitic capacitance can be further enhanced.

The shape of the contact portion 41 of the contactor 4 connected to the multi-fin-type transistor 2 is not limited to the configuration depicted in Figs. 8 and 10 described above. Some modifications are described below with reference to Figs. 11 and 12.

Figs. 11 and 12 are diagrams depicting an example of a schematic configuration of the semiconductor device 100. In the example depicted in Fig. 11, the contact portion 41 of the contactor 4 differs from the configuration of Fig. 8 described above in that the extension portion 412-1 is not included. The contact portion 41 includes the extension portion 412-2 and the extension portion 412-3, and is therefore in contact with the side surface 21c-2 of the S/D region 21-1, and the side surface 21c-1 and the side surface 21c-2 of the S/D region 21-2. In the example depicted in Fig. 12, the contact portion 41 of the contactor 4 differs from the configuration of Fig. 8 described above in that the extension portion 412-1 and the extension portion 412-2 are not included. The contact portion 41 includes the extension portion 412-3, and is thus in contact with the side surface 21c-2 of the S/D region 21-1 and the side surface 21c-1 of the S/D region 21-2.

In the embodiment, the extraction portion 42 of the contactor 4 connected to the multi-fin-type transistor 2 may have the same area as the area of the contact portion 41. Description will be made with reference to Fig. 13.

Fig. 13 is a diagram depicting an example of a schematic configuration of the semiconductor device 100. The extraction portion 42 of the contactor 4 has the same area as the area of the contact portion 41. The base portion 411 of the contact portion 41 and the extraction portion 42 have a constant width as a whole and extend in the Z-axis direction. Even in this case, for example, the contact resistance can be reduced, and an increase in the OFF leakage current can be limited, and thus, the performance of the transistor 2 can be improved. In addition, since the extraction portion 42 and the contact portion 41 have the same area, the possibility of facilitating the manufacturing steps such as machining increases.

The contactor 4 having the configuration depicted in Figs. 8 and 10 to 13 described above may be used for one or both of the source region 21-S and the drain region 21-D of the transistor 2.

In the embodiment, the contactor 4 may be used for connecting the S/D region 21-1 formed in the semiconductor portion 20-1 and the S/D region 21-2 formed in the semiconductor portion 20-2. In that case, the connection of the contactor 4 to the wiring line 5 is not essential. Description will be made with reference to Figs. 14 and 15.

Figs. 14 and 15 are diagrams depicting an example of a schematic configuration of the semiconductor device 100. Fig. 14 schematically depicts a planar layout of the semiconductor device 100. In comparison with the above-described Fig. 9, the wiring line 5 is not provided between the transistor 2-1 and the transistor 2-2, and the base portion 411 of the contact portion 41 is exposed. Fig. 15 depicts a cross section taken along line A-A of Fig. 14.

As depicted in Fig. 14, the transistor 2-2 is provided at the succeeding stage of the transistor 2-1. More specifically, the transistor 2-2 is provided at the succeeding stage of the transistor 2-1 such that the S/D regions 21 of the transistor 2-1 and the transistor 2-2 are connected to each other. It is necessary to electrically connect the S/D region 21 of the transistor 2-1 formed in the semiconductor portion 20-1 and the S/D region 21 of the transistor 2-1 formed in the semiconductor portion 20-2. The contact portion 41 of the contactor 4 is used for this connection.

In the example depicted in Fig. 15, the contactor 4 is different from the configuration of Fig. 8 described above in that the extraction portion 42 is not included. The wiring line 5 need not be provided on the upper side of the contactor 4. The contact portion 41 of the contactor 4 is in contact with the S/D region 21-1 and the S/D region 21-2, and thus the S/D region 21-2 and the S/D region 21-1 are electrically connected. Note that the configuration of the contact portion 41 may be the configuration depicted in Figs. 10 to 12 described above.

In the embodiment, the S/D region 21-1 and the S/D region 21-2 may be connected through the contactor 4 and the wiring line 5. Description will be made with reference to Fig. 16.

Fig. 16 is a diagram depicting an example of a schematic configuration of the semiconductor device 100. The contactor 4 includes two contact portions. The first contact portion is referred to and depicted as contact portion 4A-1. The second contact portion is referred to and depicted as contact portion 4A-2.

The contact portion 4A-1 extends from the S/D region 21-1 formed in the semiconductor portion 20-1 to the wiring line 5 of the wiring layer, and in this example, the contact portion 4A-1 extends from the top surface 21a of the S/D region 21-1 to the wiring line 5.

The contact portion 4A-2 extends from the S/D region 21-2 formed in the semiconductor portion 20-2 to the wiring line 5 of the wiring layer, and in this example, the contact portion 4A-2 extends from the top surface 21a of the S/D region 21-2 to the wiring line 5.

The S/D region 21 of the transistor 2-1 formed in the semiconductor portion 20-1 and the S/D region 21 of the transistor 2-1 formed in the semiconductor portion 20-2 are electrically connected through the contact portion 4A-1, the wiring line 5 and the contact portion 4A-2. In this manner, the S/D region 21 of the transistor 2-1 provided across the semiconductor portion 20-1 and the semiconductor portion 20-2 and the S/D region 21 of the transistor 2-2 can be electrically connected. This can contribute to improving the performance of the transistor 2-1.

It is conceivable to form still another region (e.g., a region similar to the S/D region) for the connection of the S/D region 21-1 and the S/D region 21-2, but this entails considerable difficulty in manufacturing steps such as machining. By using the above-described contactor 4, the possibility of facilitating the manufacturing steps increases.

Note that an example has been described above in which the semiconductor portion 20 includes two semiconductor portions, namely the semiconductor portion 20-1 and the semiconductor portion 20-2. It should be noted that the semiconductor portion 20 may include three or more semiconductor portions. The S/D region 21 of the transistor 2-1 may be formed across three or more semiconductor portions. The S/D region 21 of the transistor 2-2 may be formed across a smaller number of (two or more) semiconductor portions. Even in that case, the S/D region 21 of the transistor 2-1 and the S/D region 21 of the transistor 2-2 may be electrically connected by the same method.

### 3. Example of Manufacturing Method

Figs. 17 to 35 depict an example of a manufacturing method for the semiconductor device 100. Some manufacturing steps for the semiconductor device 100 according to the first embodiment are described below.

Figs. 17 to 24 depict manufacturing steps for obtaining the configuration of Figs. 3 and 4 described above, or more specifically, the configuration in which the top surface 411a of the contact portion 41 of the contactor 4 is located at the same height as the top surface 23a of the gate electrode 23.

As depicted in Fig. 17, the insulating layer 1, the semiconductor portion 20 where the S/D region 21 is formed, and the gate electrode 23 are prepared, and the insulating material 6 is provided so as to cover them. The insulating material 6 is a silicon oxide film deposited by chemical vapor deposition (CVD), and has a thickness greater than the thickness of the gate electrode 23, for example.

As depicted in Fig. 18, the insulating material 6 is etched so as to obtain a recess portion 41r corresponding to the contact portion 41. As depicted in Fig. 19, a material 41m (e.g., tungsten) of the contact portion 41 is provided so as to fill the recess portion 41r. As depicted in Fig. 20, planarization is performed by CMP using the gate electrode 23 as an etching stopper layer. The contact portion 41 including the base portion 411 and the extension portion 412 is thus obtained.

As depicted in Fig. 21, the insulating material 6 is further provided. It is possible to use CVD. As depicted in Fig. 22, the insulating material 6 is etched so as to obtain a recess portion 42r corresponding to the extraction portion 42. As depicted in Fig. 23, a material 42m of the extraction portion 42 is provided so as to fill the recess portion 42r. As depicted in Fig. 24, planarization is performed by CMP. The contactor 4 including the contact portion 41 and the extraction portion 42 is thus obtained. Thereafter, the wiring line 5 is provided on the contactor 4 although not depicted in the drawing.

Figs. 25 to 31 depict manufacturing steps for obtaining the configuration depicted in Fig. 5 described above, or more specifically, the configuration in which the top surface 411a of the contact portion 41 of the contactor 4 is located at a position lower than the top surface 23a of the gate electrode 23.

As depicted in Fig. 25, the insulating material 6 is provided so as to cover the semiconductor portion 20 where the S/D region 21 is formed and the gate electrode 23. The insulating material 6 is deposited using CVD so as to have a thickness smaller than the thickness of the gate electrode 23, for example.

As depicted in Fig. 26, the insulating material 6 is etched so as to obtain the recess portion 41r corresponding to the contact portion 41. As depicted in Fig. 27, the material 41m of the contact portion 41 is provided so as to fill the recess portion 41r. As depicted in Fig. 28, a resist mask RM is formed only on the upper side of the contact portion 41, and other portions are subjected to dry etching. The contact portion 41 including the base portion 411 and the extension portion 412 is thus obtained.

As depicted in Fig. 29, the insulating material 6 is further provided. As depicted in Fig. 30, the insulating material 6 is etched so as to obtain the recess portion 42r corresponding to the extraction portion 42. As depicted in Fig. 31, the material 42m of the extraction portion 42 is provided so as to fill the recess portion 42r. The contactor 4 including the contact portion 41 and the extraction portion 42 is thus obtained. Thereafter, the wiring line 5 is provided on the contactor 4 although not depicted in the drawing.

Figs. 32 to 35 depict manufacturing steps for obtaining the configuration depicted in Fig. 6 described above, or more specifically, the configuration in which the contact portion 41 is composed of a silicide film. It is assumed that the manufacturing steps depicted in Figs. 25 and 26 described above have been completed.

As depicted in Fig. 32, a silicide film (e.g., tungsten silicide) is provided so as to fill the recess portion 41r. The contact portion 41 including the base portion 411 and the extension portion 412 having a thickness smaller than that of the configuration depicted in Fig. 29 described above is thus obtained.

As depicted in Fig. 33, the insulating material 6 is further provided. As depicted in Fig. 34, the insulating material 6 is etched so as to obtain the recess portion 42r corresponding to the extraction portion 42. As depicted in Fig. 34, the material 42m of the extraction portion 42 is provided so as to fill the recess portion 42r. The contactor 4 including the contact portion 41 and the extraction portion 42 is thus obtained. Thereafter, the wiring line 5 is provided on the contactor 4 although not depicted in the drawing.

### 4. Brief Summary

The semiconductor device 100 according to the first embodiment described above is specified as follows, for example. As described above with reference to Figs. 1 to 15 and the like, the semiconductor device 100 includes, for example, the semiconductor portion 20 having an island shape provided to protrude from the top surface 1a of the insulating layer 1, the transistor 2 including the S/D region 21 (at least one of the source region 21-S and the drain region 21-D) formed in the semiconductor portion 20, and the contactor 4 connected to the S/D region 21. The contactor 4 includes the contact surface 412c that is in contact with the S/D region 21 and extends downward.

With the above-described semiconductor device 100, the contactor 4 is in contact not only with the top surface 21a of the S/D region 21 but also with the side surface 21c. In this manner, for example, the electrical connection to the S/D region 21 is enhanced in comparison with the case where the contactor 4 is in contact only with the top surface 21a of the S/D region 21. In addition, the carriers that may be accumulated in the portion located on the lower side of the S/D region 21 in the semiconductor portion 20 are easily discharged. The performance of the transistor 2 can be improved through reduction of contact resistance, suppression of OFF leakage current increase and the like.

As described above with reference to Figs. 1 to 6 and 8 to 15 and the like, the contactor 4 may include the contactor 4-1 (first contactor) connected to the source region 21-S and the contactor 4-2 (second contactor) connected to the drain region 21-D. In this manner, the electrical connection to each of the source region 21-S and the drain region 21-D can be enhanced, and the carriers that may be accumulated in the portion located on the lower side of them can be easily discharged.

As described above with reference to Figs. 1 to 15 and the like, the S/D region 21 may include the side surface 21c exposed on the surface of the semiconductor portion 20, and the contact surface 412c of the contactor 4 may be in contact with the side surface 21c of the S/D region 21. The S/D region 21 may include the pair of side surfaces 21c (the side surface 21c-1 and the side surface 21c-2) exposed on the surface of the semiconductor portion 20, and the contact surface 412c (the contact surface 412c-1 and the contact surface 412c-2) of the contactor 4 may be in contact with the pair of side surfaces 21c (the side surface 21c-1 and the side surface 21c-2) of the S/D region 21. In this manner, the contactor 4 can be in surface contact with the S/D region 21 in the vertical direction, for example.

As described above with reference to Figs. 8 to 15 and the like, the semiconductor portion 20 may include the semiconductor portion 20-1 (first semiconductor portion) and the semiconductor portion 20-2 (second semiconductor portion) provided spaced apart from the semiconductor portion 20-1, the S/D region 21 may be formed in each of the semiconductor portion 20-1 and the semiconductor portion 20-2, and the contact surface 412c of the contactor 4 may be in contact with the S/D regions 21 (the S/D region 21-1 and the S/D region 21-2) respectively formed in the semiconductor portion 20-1 and the semiconductor portion 20-2. The S/D region 21 may include the pair of side surfaces 21c (the side surface 21c-1 and the side surface 21c-2) exposed on the surface of the semiconductor portion 20-1, and the pair of side surfaces 21c (the side surface 21c-1 and the side surface 21c-2) exposed on the surface of the semiconductor portion 20-2, and the contact surface 412c (the contact surface 412c-1 and the contact surface 412c-2) of the contactor 4 may be in contact with the pair of side surfaces 21c (the side surface 21c-1 and the side surface 21c-2) exposed on the surface of the semiconductor portion 20-1 of the S/D region 21, and the pair of side surfaces 21c (the side surface 21c-1 and the side surface 21c-2) exposed on the surface of the semiconductor portion 20-2. In this manner, a similar contactor 4 can also be connected to the multi-fin-type transistor 2, and the performance of the transistor 2 can be improved, for example.

As described above with reference to Figs. 1 to 12 and the like, the S/D region 21 may include the top surface 21a and the side surface 21c exposed on the surface of the semiconductor portion 20, the contactor 4 may include the contact portion 41 in contact with the top surface 21a and the side surface 21c of the S/D region 21 and the extraction portion 42 extending upward from the contact portion 41, and the extraction portion 42 may have an area smaller than the area of the contact portion 41 in plan view (as viewed in the Z-axis negative direction). For example, the area of the extraction portion 42 may be smaller than the sum of the area of the side surface 21c and the area of the top surface 21a of the S/D region 21 in contact with the contact portion 41. By using the contactor 4 having such a configuration, the parasitic capacitance that might occur due to the size of the surface area of the contactor 4 can be reduced.

As described above with reference to Figs. 1 and 4 and the like, the transistor 2 may include the gate electrode 23, and the top surface 411a of the contact portion 41 of the contactor 4 may be located at the same height as the top surface 23a of the gate electrode 23. Such a configuration of the contact portion 41 and the gate electrode 23 can be obtained through typical machining using CMP, for example.

As described above with reference to Figs. 5 and 6 and the like, the top surface 411a of the contact portion 41 of the contactor 4 may be located at a position lower than the top surface 23a of the gate electrode 23. Such a contact portion 41 may be a silicide film. By reducing the height of the contact portion 41, the surface area of the contactor 4 can be further reduced.

The semiconductor device 100 described above with reference to Figs. 14 and 16 and the like is also one of the disclosed technologies. The semiconductor device 100 includes a plurality of the semiconductor portions 20 spaced apart from each other and provided to protrude from the top surface 1a of the insulating layer 1, and the contactor 4. The plurality of semiconductor portions 20 includes the semiconductor portion 20-1 (first semiconductor portion) where the S/D region 21-1 of the transistor 2-1 (first transistor) and the S/D region of the transistor 2-2 (second transistor) electrically connected to the S/D region 21 are formed, and the semiconductor portion 20-2 (second semiconductor portion) where the S/D region 21-2 of the transistor of the transistor 2-1 is formed. The contactor 4 includes the contact portion 4A-1 (first contact portion) extending upward from the S/D region 21-1 of the transistor 2-1 formed in the semiconductor portion 20-1, and the contact portion 4A-2 (second contact portion) extending upward from the S/D region 21-2 of the transistor 2-1 formed in the semiconductor portion 20-2. The contact portion 4A-1 may extend from the S/D region 21-1 of the transistor 2-1 to the wiring line 5 of the wiring layer, the contact portion 4A-2 may extend from the S/D region 21-1 of the transistor 2-1 to the wiring line 5, and the S/D region 21-1 of the transistor 2-1 formed in the semiconductor portion 20-1 and the S/D region 21-2 of the transistor 2-1 formed in the semiconductor portion 20-2 may be electrically connected through the contact portion 4A-1, the wiring line 5 and the contact portion 4A-2. In this manner, the S/D region 21 of the transistor 2-1 provided across the semiconductor portion 20-1 and the semiconductor portion 20-2 and the S/D region 21 of the transistor 2-2 can be electrically connected. This can contribute to improving the performance of the transistor 2-1.

### 5. Second Embodiment

In the second embodiment, a more specific configuration particularly regarding suppression of OFF leakage current is proposed.

Figs. 36 to 39 are diagrams depicting an example of a schematic configuration of the semiconductor device 100. Fig. 36 depicts an external appearance of the semiconductor device 100. Fig. 37 depicts a layout (planar layout) of the semiconductor device 100 in plan view. Fig. 38 depicts a cross section taken along line A-A of Fig. 37. Fig. 39 depicts a cross section taken along line B-B of Fig. 37.

The semiconductor portion 20 includes a low-concentration impurity region 201. The low-concentration impurity region 201 has an impurity concentration lower than the impurity concentration of the S/D region 21. The low-concentration impurity region 201 is located at least on the lower side of the semiconductor portion 20 in the S/D region 21. The low-concentration impurity region 201 may be a region other than the S/D region 21 in the semiconductor portion 20. Unless otherwise specified, the low-concentration impurity region 201 is the low-concentration impurity region 201 located on the lower side of the S/D region 21.

In a relative sense with respect to the low-concentration impurity region 201, the S/D region 21 may also be referred to as a high-concentration impurity region. In Figs. 38 and 39, the S/D region 21 is denoted with N++, which indicates a high impurity concentration. The low-concentration impurity region 201 is denoted with N-, which indicates a low impurity concentration.

Numerical examples of the impurity concentrations are described below. The impurity concentration of the S/D region 21 denoted with N++ may be 1 × 10¹⁹ cm⁻³ or greater. In the example depicted in Figs. 38 and 39, the source region 21-S and the drain region 21-D are denoted with N++, and their impurity concentration are the same. The impurity concentration of the low-concentration impurity region 201 denoted with N- may be 1 × 10¹⁸ cm⁻³ or less.

The respective portions of the contactor 4 are referred to and depicted as the contact portion 41 and the extraction portion 42 as in the foregoing. Note that in this example, the extraction portion 42 has the same area as the area of the contact portion 41 in plan view. It should be noted that as described above, the area of the extraction portion 42 may be smaller than the area of the contact portion 41.

The contact portion 41 is in contact with the top surface 21a and the side surface 21c of the S/D region 21. Further, the contact portion 41 is also in contact with (at least a part of) the low-concentration impurity region 201 located on the lower side of the S/D region 21.

The respective portions of the contact portion 41 are referred to and depicted as the base portion 411 and the extension portion 412 as in the foregoing. The base portion 411 is in contact with the top surface of the S/D region 21. The extension portion 412 is in contact with the side surfaces of the S/D region 21 and the low-concentration impurity region 201.

Specifically, the contact surface 412c of the extension portion 412 is in contact with the side surface of the S/D region 21 and the side surface of the low-concentration impurity region 201 located on the lower side thereof. The side surface of the S/D region 21 herein may correspond to the side surface 21c in Fig. 3 described above, i.e., the side surface exposed on the surface of the semiconductor portion 20, for example. The side surface of the low-concentration impurity region 201 may correspond to the surface in the low-concentration impurity region 201 that is continuous with the side surface 21c of the S/D region 21 and extends downward.

In the example depicted in Fig. 39, the extension portion 412 includes the extension portion 412-1 and the extension portion 412-2. The contact surface 412c-1 of the extension portion 412-1 is in contact with one side surface of the S/D region 21 and the side surface of the low-concentration impurity region 201 located on the lower side thereof. In addition, the contact surface 412c-2 of the extension portion 412-2 is in contact with the other side surface of the S/D region 21 and the side surface of the low-concentration impurity region 201 located on the lower side thereof.

In the semiconductor device 100 having the above-described configuration, the contact portion 41 of the contactor 4 is in contact not only with the S/D region 21 but also with the low-concentration impurity region 201 located on the lower side thereof. The carriers accumulated (trapped) in the lower portion of the S/D region 21 are easily discharged, thereby enhancing the effect of suppressing an increase in OFF leakage current. The performance of the transistor 2 can be improved. Description will be made with reference also to Figs. 40 to 43.

Figs. 40 to 43 depict an example of a simulation. As depicted in Fig. 40, the depth (length) of the extension portion 412 of the contact portion 41 of the contactor 4-1 connected to the source region 21-S of the transistor 2 is referred to as depth D412. The depth of the source region 21-S is referred to as depth D21. The depth D412 and the depth D21 may correspond to the length of the Z-axis negative direction with reference to the bottom surface 411b of the base portion 411 of the contact portion 41 of the contactor 4 or the top surface 21a of the source region 21-S. In addition, the height of the semiconductor portion 20 (fin height) is referred to as height H20. Here, the height H20 is the length of the Z-axis negative direction with reference to the top surface 411a of the base portion 411 or the top surface 21a of the S/D region 21. In the case where the depth D412 is greater than the depth D21, the extension portion 412 is in contact not only with the source region 21-S but also with the low-concentration impurity region 201.

Figs. 41 and 42 depict an improvement in the performance of the transistor 2 resulting from an improvement in the threshold voltage. In the graph of Fig. 41, the abscissa indicates the depth D412, and the ordinate indicates a threshold voltage Vth (V) of the transistor 2. In the graph of Fig. 42, the abscissa indicates a gate voltage (V), and the ordinate indicates a drain current (A). As can be understood, when the depth D412 becomes greater than the depth D21, the increase in OFF leakage current is suppressed and the reduction in the threshold voltage Vth is improved in comparison with when the depth D412 is smaller than the depth D21.

In the graph of Fig. 43, the abscissa indicates the position z in the Z-axis direction in the semiconductor portion 20, and the ordinate indicates a potential in the semiconductor portion 20. In the region whose position z is lower than the depth D21, the potential is low, and holes are accumulated as schematically indicated by the white arrow. With the extension portion 412 extended to and brought into contact with that region, the holes accumulated therein are easily discharged. The influence of parasitic bipolar operation is reduced, and accordingly the increase in OFF leakage current is suppressed, thereby enhancing the threshold voltage Vth.

### 6. Example/Modification

Some examples or modifications based on the above-described technology of the second embodiment are described below. In the embodiment, only one of the contactor 4-1 and the contactor 4-2 may include the contact portion 41 that is in contact with the S/D region 21 and the low-concentration impurity region 201. Description will be made with reference to Fig. 44.

Fig. 44 is a diagram depicting an example of a schematic configuration of the semiconductor device 100. As described above, the contact portion 41 of the contactor 4-1 is in contact with the source region 21-S and the low-concentration impurity region 201. On the other hand, the contactor 4-2 does not include such a contact portion 41. The contactor 4-2 has a constant area and extends from the top surface 21a of the drain region 21-D to the wiring line 5.

Accumulation of holes, which causes parasitic bipolar operation, occurs especially in the low-concentration impurity region 201 located on the lower side of the source region 21-S. With the contact portion 41 of the contactor 4-1 in contact with that region, the holes can be effectively discharged. The increase in OFF leakage current can thus be effectively suppressed.

In the embodiment, the contact portion 41 of the contactor 4 may be in contact only with one of the pair of side surfaces of the S/D region 21. Description will be made with reference to Fig. 45.

Fig. 45 is a diagram depicting an example of a schematic configuration of the semiconductor device 100. (A) of Fig. 45 depicts a planar layout of the semiconductor device 100. (B) of Fig. 45 depicts a cross section taken along line B-B of (A) of Fig. 45.

The contact portion 41 of the contactor 4 is different from the configuration of Fig. 39 described above in that the extension portion 412-2 is not included. The contact portion 41 includes the extension portion 412-1, and is thus in contact with one side surface of the S/D region 21 (which corresponds to the side surface 21c-1 of Fig. 3 described above in this example). Note that conversely, the contact portion 41 may include the extension portion 412-2 without including the extension portion 412-1.

In the embodiment, the impurity concentration of the source region 21-S and the impurity concentration of the drain region 21-D may be different from each other. Description will be made with reference to Fig. 46.

Fig. 46 is a diagram depicting an example of a schematic configuration of the semiconductor device 100. The impurity concentration of the drain region 21-D is lower than the impurity concentration of the source region 21-S, and higher than the impurity concentration of the low-concentration impurity region 201. In Fig. 46, the drain region 21-D is denoted with "N+", which indicates that the impurity concentration is lower than N++ and higher than N-. The impurity concentration of the drain region 21-D denoted with N+ may be less than 1 × 10¹⁹ cm⁻³, and greater than 1 × 10¹⁸ cm⁻³.

### 7. Brief Summary

The semiconductor device 100 according to the second embodiment described above is specified as follows, for example. As described above with reference to Figs. 36 to 39 and 44 to 46 and the like, the semiconductor portion 20 may include the low-concentration impurity region 201 having an impurity concentration lower than the impurity concentration of the S/D region 21 on the lower side of the S/D region 21, and the contact surface 412c of the contactor 4 may be in contact with the S/D region 21 and the low-concentration impurity region 201. In this manner, the carriers accumulated in a lower portion of the S/D region 21 are easily discharged, thereby enhancing the effect of suppressing an increase in OFF leakage current.

As described above with reference to Figs. 38, 39, 44 and 46 and the like, the S/D region 21 may include a pair of side surfaces (which correspond to, for example, the side surface 21c-1 and the side surface 21c-2 in Fig. 3) exposed on the surface of the semiconductor portion 20, and the contact surface 412c of the contactor 4 may be in contact with the pair of side surfaces of the S/D region 21 and the pair of side surfaces of the low-concentration impurity region 201 extending downward therefrom. In this manner, the contactor 4 can be in contact with the S/D region 21 and the low-concentration impurity region 201, for example.

As described above with reference to Figs. 39 and 44 to 46 and the like, the contactor 4 may include the contactor 4-1 connected to the source region 21-S. In this manner, holes that may be accumulated in the low-concentration impurity region 201 located on the lower side of the source region 21-S can be effectively discharged, thereby effectively suppressing the increase in OFF leakage current.

As described above with reference to Figs. 38, 39 and 46 and the like, the impurity concentration of the S/D region 21 may be 1 × 10¹⁹ cm⁻³ or greater, and the impurity concentration of the low-concentration impurity region 201 may be 1 × 10¹⁸ cm⁻³ or less. The impurity concentration of the drain region 21-D may be lower than the impurity concentration of the source region 21-S, and higher than the impurity concentration of the low-concentration impurity region 201. By using the contactor 4 in the configuration having such an impurity concentration difference, the carriers accumulated in a lower portion of the S/D region 21 can be discharged, for example.

### 8. Third Embodiment

A third embodiment proposes a configuration that achieves reduction in contact resistance, suppression of the increase in parasitic capacitance, enhancement of the layout efficiency in the contactor 4, suppression of the OFF leakage current and the like by ensuring the contact area of the contactor 4 and the semiconductor portion 20.

Figs. 47 to 50 are diagrams depicting an example of a schematic configuration of the semiconductor device 100. Fig. 47 depicts an external appearance of the semiconductor device 100. Fig. 48 depicts a planar layout of the semiconductor device 100. Fig. 49 depicts a cross section taken along line A-A of Fig. 48. Note that Fig. 49 also depicts the wiring line 5 of the wiring layer located on the upper side of the contactor 4. Fig. 50 depicts a cross section taken along line B-B of Fig. 48.

The contactor 4 is broadly classified into two portions, which are referred to as contact portions. Specifically, the first contact portion of the two contact portions is referred to and depicted as contact portion 7. The second contact portion is referred to and depicted as contact portion 8.

The contact portion 7 extends from the wiring line 5 of the wiring layer to the S/D region 21. More specifically, in this example, the contact portion 7 extends into the S/D region 21. The surface of the contact portion 7 on the Z-axis negative direction side is referred to and depicted as bottom surface 7b. The bottom surface 7b of the contact portion 7 is located on the lower side of the top surface 21a of the S/D region 21.

The contact portion 8 includes a contact surface 8c that extends downward so as to be in contact with the S/D region 21. In this example, the contact surface 8c includes a contact surface 8c-1, a contact surface 8c-2, a contact surface 8c-3 and a contact surface 8c-4. The contact surface 8c-1 is the surface of the contact portion 8 on the X-axis negative direction side. The contact surface 8c-2 is the surface of the contact portion 8 on the X-axis positive direction side. The contact surface 8c-3 is the surface of the contact portion 8 on the Y-axis negative direction side. The contact surface 8c-4 is the surface of the contact portion 8 on the Y-axis positive direction side. When the contact surface 8c-1, the contact surface 8c-2, the contact surface 8c-3 and the contact surface 8c-4 are not particularly distinguished, they are simply referred to as contact surface 8c.

The contact portion 8 extends to a position lower than the S/D region 21. The contact surface 8c of the contact portion 8 is in contact not only with the S/D region 21 but also with the portion located on the lower side of the S/D region 21 in the semiconductor portion 20. This portion may correspond to the low-concentration impurity region 201 in Figs. 38 and 39 described above, for example.

In the example depicted in Figs. 49 and 50, in the vertical direction, the contact portion 7 and the contact portion 8 are continuous with each other. In the Z-axis negative direction, the contact portion 7 and the contact portion 8 are located in this order. The surface of the contact portion 8 on the Z-axis positive direction side is referred to and depicted as top surface 8a. The bottom surface 7b of the contact portion 7 is in surface contact with the top surface 8a of the contact portion 8. As described above, the contact portion 7 extends into the S/D region 21, and thus the contact portion 7 and the contact portion 8 are continuous with each other inside the S/D region 21. In addition, in plan view, the contact portion 7 and the contact portion 8 are located inside the S/D region 21.

The length of the contact portion 7 in the XY plane direction is also referred to as the width of the contact portion 7. The area of the contact portion 7 in plan view is also referred to as the area of the contact portion 7. The contact portion 7 may extend with a constant area (or width), and in that case, the area of the contact portion 7 is the same as the area of the bottom surface 7b. The contact portion 8 may extend with a constant area (or width), and in that case, the area of the contact portion 8 is the same as the area of the top surface 8a.

In plan view, the contact portion 7 may have the same area as the area of the contact portion 8, or an area different from the area of the contact portion 8. In the example depicted in Figs. 48 to 50, the contact portion 7 has an area greater than the area of the contact portion 8. The contact portion 8 is located inside the contact portion 7.

With the contact portion 7 having an area different from the area of the contact portion 8, the contact portion 7 and the contact portion 8 are continuous with each other so as to have a step portion inside the S/D region 21. This step portion is referred to and depicted as step portion S. The step portion S is formed due to the difference between the area of the bottom surface 7b of the contact portion 7 and the area of the top surface 8a of the contact portion 8.

In the example depicted in Figs. 49 and 50, the area of the bottom surface 7b of the contact portion 7 is greater than the area of the top surface 8a of the contact portion 8. In the S/D region 21, the portion of the bottom surface 7b of the contact portion 7 that is not in contact with the top surface 8a of the contact portion 8 is in contact with the S/D region 21. Accordingly, the electrical connection with the S/D region 21 is enhanced.

In the semiconductor device 100 having the above-described configuration, the contactor 4 includes the two portions, namely the contact portion 7 and the contact portion 8. The contact portion 8 is in contact with the S/D region 21. In this manner, for example, in comparison with the case where the contactor 4 includes only the contact portion 7, the contact area between the contactor 4 and the semiconductor portion 20 is larger, and the contact resistance can be reduced. For example, in comparison with the case where the contactor 4 having a shape protruding in the width direction (the X-axis direction) is used for the semiconductor portion 20 as in the first embodiment and second embodiment described above, the space occupied by the contactor 4 can be suppressed. Accordingly, the space between the contactors 4 and the space with other structures can be easily ensured. This increases the possibility of achieving effects such as enhancement of layout efficiency and suppression of parasitic capacitance.

In addition, the contact portion 8 is in contact not only with the S/D region 21 but also with a portion on a lower side of the S/D region 21 in the semiconductor portion 20. The carriers such as holes that may be accumulated in that portion are easily discharged, and thus the increase in OFF leakage current can be suppressed. The performance of the transistor 2 can be improved.

### 9. Example/Modification

Some examples or modifications based on the above-described technology of the third embodiment are described below. In the embodiment, only one of the contactor 4-1 and the contactor 4-2 of the contactor 4 may include the contact portion 7 and the contact portion 8 described above. The other contactor 4 needs only to extend upward from the top surface 21a of the S/D region 21 with a constant area (width), for example.

In the embodiment, a barrier metal, a side wall (side wall portion) and the like may be provided. In addition, the S/D region 21 may include a plurality of regions having different impurity concentrations. Description will be made with reference to Fig. 51.

Fig. 51 is a diagram depicting an example of a schematic configuration of the semiconductor device 100. In this example, a barrier metal BM is provided on the surface of the contactor 4. The barrier metal BM functions as a diffusion barrier film, for example. In addition, a side wall 9 (side wall portion) is provided on the side surface of the gate electrode 23. The side wall 9 imparts insulation to the side surface of the gate electrode 23, for example. For the barrier metal BM and the side wall 9, various publicly known materials may be used.

The S/D region 21 includes a first region 211 and a second region 212. The first region 211 is formed to include the top surface 21a of the S/D region 21. The second region 212 is formed between the first region 211 and the region other than the S/D region 21 in the semiconductor portion 20. The impurity concentration increases in the order of the second region 212 and the first region 211.

Note that the above-described configuration of the S/D region 21 including the barrier metal BM, the side wall 9, the first region 211 and the second region 212 may also be adopted in the first embodiment and second embodiment described above.

In the embodiment, the size relationship between the area of the contact portion 7 and the area of the contact portion 8 may be the reverse of the configurations of Figs. 48 to 51 described above. Description will be made with reference to Figs. 52 to 54.

Figs. 52 to 54 are diagrams depicting an example of a schematic configuration of the semiconductor device 100. Fig. 52 depicts a planar layout of the semiconductor device 100. Fig. 53 depicts a cross section taken along line A-A of Fig. 52. Fig. 54 depicts a cross section taken along line B-B of Fig. 52.

In this example, in plan view, the contact portion 8 has an area greater than the area of the contact portion 7. The contact portion 7 is located inside the contact portion 8. Due to the larger area of the contact portion 8, the electrical connection with the S/D region 21 is enhanced, and the effect of suppressing the parasitic bipolar operation is further improved.

Even in this case, the step portion S is formed due to the difference between the area of the bottom surface 7b of the contact portion 7 and the area of the top surface 8a of the contact portion 8. In the S/D region 21, the portion of the top surface 8a of the contact portion 8 that is not in contact with the bottom surface 7b of the contact portion 7 is in contact with the S/D region 21. Accordingly, the electrical connection with the S/D region 21 is enhanced.

Note that the configuration of the contactor 4 depicted in Figs. 52 to 54 may be adopted for only one of the contactor 4-1 and the contactor 4-2 of the contactor 4.

In the embodiment, the contact portion 7 and the contact portion 8 may be separately provided without being continuous with each other. Description will be made with reference to Figs. 55 to 58.

Figs. 55 to 58 are diagrams depicting an example of a schematic configuration of the semiconductor device 100. Fig. 55 depicts a planar layout of the semiconductor device 100. Fig. 56 depicts a cross section taken along line A-A of Fig. 55. Fig. 57 depicts a cross section taken along line B-B of Fig. 55. Fig. 58 depicts a cross section taken along line C-C of Fig. 55.

The contact portion 8 extends from the wiring line 5 separately from the contact portion 7. The contact portion 7 and the contact portion 8 are connected to the same wiring line 5 at different positions. In plan view, the contact portion 7 and the contact portion 8 are spaced apart from each other. In this example, the contact portion 8 is located on the side opposite to the contact portion 7 with the gate electrode 23 therebetween.

Since the contactor 4 includes the contact portion 7 and the contact portion 8, the above-described effects are achieved. In addition, since the contact portion 7 and the contact portion 8 may be formed at different locations, the possibility of facilitating the manufacturing steps such as machining increases in comparison with the case where the contact portion 7 and the contact portion 8 are continuous with each other, for example.

Note that the configuration of the contactor 4 depicted in Figs. 55 to 58 may also be adopted for only one of the contactor 4-1 and the contactor 4-2 of the contactor 4.

In the embodiment, at least a part of the contact portion 8 may be located outside the semiconductor portion 20. Description will be made with reference to Figs. 59 to 62.

Figs. 59 to 62 are diagrams depicting an example of a schematic configuration of the semiconductor device 100. Fig. 59 depicts a planar layout of the semiconductor device 100. Fig. 60 depicts a cross section taken along line A-A of Fig. 59. Fig. 61 depicts a cross section taken along line B-B of Fig. 59. Fig. 62 depicts a cross section taken along line C-C of Fig. 59. Note that in this example, the area of the contact portion 7 and the area of the contact portion 8 are the same, but they may be different from each other.

The surface on the Y-axis negative direction side in the S/D region 21 is referred to and depicted as side surface 21c-3. The surface on the Y-axis positive direction side is referred to and depicted as side surface 21c-4. The side surface 21c-3 of the source region 21-S in the S/D region 21 is exposed on the surface of the semiconductor portion 20. In addition, the side surface 21c-4 of the drain region 21-D is exposed on the surface of the semiconductor portion 20.

The contact surface 8c of the contact portion 8 of the contactor 4 is in contact with the side surface of the S/D region 21 exposed on the surface of the semiconductor portion 20 described above. Specifically, in this example, the contact surface 8c-4 of the contact portion 8 of the contactor 4-1 is in contact with the side surface 21c-3 of the source region 21-S. The contact surface 8c-4 of the contact portion 8 of the contactor 4-2 is in contact with the side surface 21c-4 of the drain region 21-D.

The contact portion 8 may extend to the bottom surface of the semiconductor portion 20. In that case, the contact portion 8 may be configured using a contact (e.g., through-via) extending through the semiconductor portion 20.

Even with the above-described configuration, the above-described effects are achieved since the contactor 4 includes the contact portion 7 and the contact portion 8. In addition, since the contact portion 7 and the contact portion 8 may be formed at different locations, the possibility of facilitating the manufacturing steps such as machining increases in comparison with the case where the contact portion 7 and the contact portion 8 are continuous with each other, for example.

### 10. Example of Manufacturing Method

Figs. 63 to 66 depict an example of a manufacturing method for the semiconductor device 100. Some manufacturing steps for the semiconductor device 100 according to the third embodiment described above will be described. (A) in each drawing depicts a cross section as viewed in the X-axis negative direction. (B) in each drawing depicts a cross section as viewed in the Y-axis positive direction.

As depicted in Fig. 63, the semiconductor portion 20 where the S/D region 21 is formed, the gate electrode 23 and the side wall 9 are prepared, and the insulating material 6 is provided so as to cover them. As depicted in Fig. 64, the insulating material 6 is etched so as to obtain a recess portion 8r corresponding to the contact portion 8. As depicted in Fig. 65, the insulating material 6 is etched so as to obtain a recess portion 7r corresponding to the contact portion 7. As depicted in Fig. 66, the material of the contactor 4 is provided. The barrier metal BM is also provided. The contactor 4 including the contact portion 7 and the contact portion 8 as described above is obtained. Thereafter, the wiring line 5 is provided on the contactor 4 although not depicted in the drawing.

In the above-described manner, the configuration depicted in Figs. 47 to 51 described above is obtained, for example. It will be understood by those skilled in the art that, by appropriately modifying the above-described manufacturing method, the configuration depicted in Figs. 52 to 62 can also be obtained.

### 11. Brief Summary

The semiconductor device 100 according to the third embodiment described above is specified as follows, for example. As described above with reference to Figs. 47 to 62 and the like, the contactor 4 includes the contact portion 7 (first contact portion) that extends from the wiring line 5 of the wiring layer to the S/D region 21, and the contact portion 8 (second contact portion) includes the contact surface 8c that extends downward and is in contact with the S/D region 21. In this manner, for example, in comparison with the case where the contactor 4 includes only the contact portion 7, the contact area between the contactor 4 and the semiconductor portion 20 is larger, and the contact resistance can be reduced. In addition, this increases the possibility of achieving effects such as enhancement of layout efficiency and suppression of parasitic capacitance.

As described above with reference to Figs. 47 to 62 and the like, the contact surface 8c of the contact portion 8 may be in contact not only with the S/D region 21 but also with the portion located on the lower side of the S/D region 21 in the semiconductor portion 20. The carriers such as holes that may be accumulated in that portion are easily discharged, and thus the increase in OFF leakage current can be suppressed.

As described above with reference to Figs. 47 to 54 and the like, in the vertical direction, the contact portion 7 and the contact portion 8 may be continuous with each other. The contact portion 7 may extend into the S/D region 21, the contact portion 7 may have an area different from the area of the contact portion 8 in plan view, and the contact portion 7 and the contact portion 8 may be continuous with each other so as to include the step portion S in the S/D region 21. In this manner, at the step portion S, a part of the top surface 8a of the contact portion 8 or the bottom surface 7b of the contact portion 7 may be in contact with the S/D region 21. Accordingly, electrical connection can be enhanced.

As described above with reference to Figs. 55 to 62 and the like, the contact portion 8 may extend from the wiring line 5 of the wiring layer separately from the contact portion 7, and in plan view, the contact portion 7 and the contact portion 8 may be spaced apart from each other. In addition, the S/D region 21 may include the side surface 21c (the side surface 21c-3 and the side surface 21c-4) exposed on the surface of the semiconductor portion 20, and the contact surface 8c (the contact surface 8c-4 and the contact surface 8c-3) of the contact portion 8 may be in contact with the side surface 21c (the side surface 21c-3 and the side surface 21c-4) of the S/D region 21. Since the contact portion 7 and the contact portion 8 may be formed at different locations, the possibility of facilitating the manufacturing steps such as machining increases.

As described above with reference to Figs. 47 to 51 and 55 to 58 and the like, in plan view, the contact portion 7 may have an area greater than the area of the contact portion 8. Conversely, as described above with reference to Figs. 52 to 54 and the like, the contact portion 8 may have an area greater than the area of the contact portion 7. In the latter case, for example, since the area of the contact portion 8 is larger, the electrical connection with the S/D region 21 is enhanced, and the effect of suppressing the parasitic bipolar operation is further improved.

### 12. Application Example

Some application examples of the above-described semiconductor device 100 are described below.

### 12.1 Example of Light Detection Apparatus

One application example of the semiconductor device 100 is a light detection apparatus. Description will be made with reference to Figs. 67 to 69.

Fig. 67 is a diagram depicting an example of a schematic configuration of a light detection apparatus 101. The exemplified light detection apparatus 101 may be used as a solid-state imaging device. The light detection apparatus 101 includes a pixel region (a so-called imaging region) 103 in which pixels 102 including a plurality of photoelectric conversion elements are regularly two-dimensionally arranged on a semiconductor substrate 111 (e.g., a silicon substrate), and a peripheral circuit section. The pixel 102 includes, for example, a photodiode serving as a photoelectric conversion element, and a plurality of pixel transistors (so-called MOS transistors), for example. The plurality of pixel transistors may be composed of three transistors, namely a transfer transistor, a reset transistor and an amplification transistor, for example. Alternatively, a selection transistor may be added to form a four-transistor configuration. In addition, a conversion efficiency switching transistor for switching the charge-to-voltage conversion efficiency in the floating diffusion may be additionally provided between the floating diffusion and the reset transistor to form a five-transistor configuration. Since the equivalent circuit of a unit pixel is the same as typical ones, detailed description is omitted. The pixel 102 may have a shared pixel structure. This pixel shared structure includes a plurality of photodiodes, a plurality of transfer transistors, one floating diffusion to be shared, and each one of other pixel transistors to be shared.

The peripheral circuit section includes a vertical driving circuit 104, a column signal processing circuit 105, a horizontal driving circuit 106, an output circuit 107, a control circuit 108 and the like.

The control circuit 108 receives an input clock and command data that instructs an operation mode or the like, and outputs data such as internal information of the light detection apparatus. Specifically, based on a vertical synchronization signal, a horizontal synchronization signal and a master clock, the control circuit 108 generates clock signals and control signals serving as references of the operations of the vertical driving circuit 104, the column signal processing circuit 105, the horizontal driving circuit 106 and the like. Then, these signals are input to the vertical driving circuit 104, the column signal processing circuit 105, the horizontal driving circuit 106 and the like.

The vertical driving circuit 104, which is composed of a shift register, selects a pixel driving wiring line, and supplies a pulse for driving the pixel to the selected pixel driving wiring line, thereby driving the pixel on a row-by-row basis, for example. Specifically, the vertical driving circuit 104 sequentially selects and scans each pixel 102 in the pixel region 103 on a row-by-row basis in the perpendicular direction, and supplies a pixel signal, based on the signal charge generated in accordance with the light reception amount at the photodiode serving as the photoelectric conversion element of each pixel 102, to the column signal processing circuit 105 through a vertical signal line 109, for example.

The column signal processing circuit 105 is disposed, for example, for each column of pixels 102, and performs signal processing such as noise removal on signals output from the pixels 102 of the pixels of one row for each column. Specifically, the column signal processing circuit 105 performs signal processing such as CDS for removing fixed pattern noise inherent to the pixel 102, signal amplification, and AD conversion. At the output stage of the column signal processing circuit 105, a horizontal selection switch (not depicted in the drawing) is connected between it and a horizontal signal line 110.

The horizontal driving circuit 106, which is composed of, for example, a shift register, sequentially selects each column signal processing circuit 105 by sequentially outputting horizontal scanning pulses, thereby causing each column signal processing circuit 105 to output a pixel signal to the horizontal signal line 110.

The output circuit 107 performs signal processing on the signal sequentially supplied from each column signal processing circuit 105 through the horizontal signal line 110. For example, there may be cases in which only buffering is performed, or there may be cases in which black level adjustment, column variation correction, various digital signal processing, and the like are performed. An input/output terminal 112 exchanges signals with the outside.

The technologies (such as the contactor 4) of the above-described first to third embodiments may be used for the configuration of the transistor and its surroundings included in the semiconductor substrate 111 described above, for example. The transistor 2-1, the transistor 2-2, the transistor 2-3 and the transistor 2-4 depicted in Fig. 9 or 14 described above may be the above-described amplification transistor, selection transistor, conversion efficiency switching transistor and reset transistor.

A light detection apparatus including a configuration different from the above-described configuration is described below with reference to Fig. 68.

Fig. 68 is a diagram depicting an example of a schematic configuration of a light detection apparatus 121. The light detection apparatus 121 includes three substrates (first substrate 130, second substrate 140, and third substrate 150). The light detection apparatus 121 has a three-dimensional structure composed of the three substrates (the first substrate 130, the second substrate 140, the third substrate 150) bonded to each other. The first substrate 130, the second substrate 140 and the third substrate 150 are stacked in this order.

The first substrate 130 includes, over a semiconductor substrate 131, a plurality of sensor pixels 132 that perform photoelectric conversion. The plurality of sensor pixels 132 are provided in a matrix in a pixel region 133 in the first substrate 130. The second substrate 140 includes one readout circuit 142, which outputs a pixel signal based on the charge output from the sensor pixel 132, for every four sensor pixels 132 over a semiconductor substrate 141. The second substrate 140 includes a plurality of pixel drive lines 143 extending in the row direction, and a plurality of vertical signal lines 144 (which is also referred to as vertical signal line VSL) extending in the column direction. The third substrate 150 includes, over a semiconductor substrate 151, a logic circuit 152 that processes the pixel signal. The logic circuit 152 includes a vertical driving circuit 153, a column signal processing circuit 154, a horizontal driving circuit 155 and a system control circuit 156, for example. The logic circuit 152 (more specifically, the horizontal driving circuit 155) outputs an output voltage Vout of each sensor pixel 132 to the outside. In the logic circuit 152, for example, a low-resistance region composed of silicide formed by a salicide (Self-Aligned Silicide) process such as CoSi₂ or NiSi may be formed on the surface of the impurity diffusion region in contact with the source and drain electrodes.

The vertical driving circuit 153 sequentially selects the plurality of sensor pixels 132 on a row-by-row basis, for example. The column signal processing circuit 154 performs correlated double sampling (CDS) processing on the pixel signal output from the sensor pixel 132 of the row selected by the vertical driving circuit 153, for example. The column signal processing circuit 154 extracts the signal level of the pixel signal by performing the CDS processing, and holds pixel data corresponding to the light reception amount of each sensor pixel 132, for example. The horizontal driving circuit 155 sequentially outputs the pixel data held in the column signal processing circuit 154 to the outside, for example. The system control circuit 156 controls the driving of each block (the vertical driving circuit 153, the column signal processing circuit 154 and the horizontal driving circuit 155) in the logic circuit 152, for example.

Fig. 69 is a diagram depicting examples of the sensor pixel 132 and the readout circuit 142. The following describes a case where four sensor pixels 132 share one readout circuit 142 as depicted in Fig. 69. Here, the term "share" means that the outputs of the four sensor pixels 132 are input to the common readout circuit 142.

Each sensor pixel 132 includes components common to one another. In Fig. 69, identification numbers (1, 2, 3, 4) are applied at the end of the reference numerals of the components of the sensor pixels 132 for the purpose of discriminating the components of the sensor pixels 132. In the following description, when it is necessary to distinguish the components of each sensor pixel 132 from one another, an identification number will be added to the end of the reference numeral of each component of the sensor pixels 132. However, when it is not necessary to distinguish the components of the sensor pixels 132 from one another, the identification number at the end of the reference numeral of each component of the sensor pixels 132 will be omitted.

Each sensor pixel 132 includes a photodiode PD (an example of the photoelectric conversion element), a transfer transistor TR electrically connected to the photodiode PD, and a floating diffusion FD that temporarily holds the charge output from the photodiode PD through the transfer transistor TR, for example. The photodiode PD performs photoelectric conversion to generate a charge corresponding to the light reception amount. The cathode of the photodiode PD is electrically connected to a source of the transfer transistor TR, and the anode of the photodiode PD is electrically connected to a reference potential line (for example, ground). The drain of the transfer transistor TR is electrically connected to the floating diffusion FD, and the gate of the transfer transistor TR is electrically connected to the pixel drive line 143. The transfer transistor TR is a complementary metal oxide semiconductor (CMOS) transistor, for example.

The floating diffusions FD of the sensor pixels 132 sharing one readout circuit 142 are electrically connected to each other, and electrically connected to the input terminal of the common readout circuit 142. The readout circuit 142 includes a reset transistor RST, a selection transistor SEL, and an amplification transistor AMP, for example. It is to be noted that the selection transistor SEL may be omitted as necessary. The source (the input terminal of the readout circuit 142) of the reset transistor RST is electrically connected to the floating diffusion FD, and the drain of the reset transistor RST is electrically connected to the drain of the amplification transistor AMP and a power source line VDD. The gate of the reset transistor RST is electrically connected to the pixel drive line 143 (Fig. 68). The source of the amplification transistor AMP is electrically connected to the drain of the selection transistor SEL, and the gate of the amplification transistor AMP is electrically connected to the source of the reset transistor RST. The source of the selection transistor SEL (the output terminal of the readout circuit 142) is electrically connected to the vertical signal line 144, and the gate of the selection transistor SEL is electrically connected to the pixel drive line 143 (Fig. 68).

When the transfer transistor TR is set to an on state, the transfer transistor TR transfers the charge of the photodiode PD to the floating diffusion FD. The gate of the transfer transistor TR (transfer gate TG) extends from the surface of the semiconductor substrate 131 to a depth that reaches the PD through the well layer, for example. The reset transistor RST resets the potential of the floating diffusion FD to a predetermined potential. When the reset transistor RST is set to an on state, the potential of the floating diffusion FD is reset to the potential of the power source line VDD. The selection transistor SEL controls the output timing of the pixel signal from the readout circuit 142. The amplification transistor AMP generates, as a pixel signal, a voltage signal corresponding to the level of the charge held in the floating diffusion FD. The amplification transistor AMP constitutes a source follower type amplifier, and outputs a pixel signal of a voltage corresponding to the level of the charge generated in the photodiode PD. When the selection transistor SEL is set to an on state, the amplification transistor AMP amplifies the potential of the floating diffusion FD, and outputs a voltage corresponding to that potential to the column signal processing circuit 154 through the vertical signal line 144. The reset transistor RST, the amplification transistor AMP and the selection transistor SEL are CMOS transistors, for example. Note that although not depicted in Fig. 69, a conversion efficiency switching transistor FDG (e.g., CMOS transistor) may be provided between the floating diffusion FD and the reset transistor RST.

The technologies (such as the contactor 4) of the above-described first to third embodiments may be used for the configuration of the transistor and its surroundings included in the first substrate 130, the second substrate 140 and the like as described above, for example. The transistor 2-1, the transistor 2-2, the transistor 2-3 and the transistor 2-4 depicted in Fig. 9 or 14 described above may be the amplification transistor AMP, the selection transistor SEL, the conversion efficiency switching transistor FDG and the reset transistor RST described above, for example.

### 12.2 Example of Electronic Apparatus

The above-described semiconductor device 100 may be applied to various types of electronic apparatuses, such as imaging systems including digital still cameras and digital video cameras, mobile phones (such as smartphones) equipped with imaging functions, or other devices having imaging functions. An example of the electronic apparatus is described below with reference to Fig. 70.

Fig. 70 is a block diagram depicting an example of a configuration of an electronic apparatus 161. The electronic apparatus 161 includes an optical system 162, a light detection apparatus 163, and a digital signal processor (DSP) 164, with the DSP 164, a display apparatus 165, an operation system 166, a memory 168, a recording apparatus 169, and a power source system 170 connected through a bus 167, and thus the electronic apparatus 161 can capture still images and moving images.

The optical system 162 includes one or more lenses, guides the image light (incident light) from the subject to the light detection apparatus 163, and forms an image on the light-receiving surface (sensor section) of the light detection apparatus 163.

The light detection apparatus 163 is implemented using the configuration of the above-described semiconductor device 100. The light detection apparatus 163 accumulates electrons for a certain period in accordance with the image that is formed on the light-receiving surface through the optical system 162. Then, a signal corresponding to the electrons accumulated in the light detection apparatus 163 is supplied to the DSP 164.

The DSP 164 acquires an image by performing various signal processing on the signal from the light detection apparatus 163, and temporarily stores the data of the image in the memory 168. The data of the image stored in the memory 168 is recorded in the recording apparatus 169, or supplied to the display apparatus 165 for image display. In addition, the operation system 166 receives various operations of the user and supplies the operation signal to each block of the electronic apparatus 161, and the power source system 170 supplies the power required for driving each block of the electronic apparatus 161.

The electronic apparatus 161 including the above-described semiconductor device 100 is specified as follows, for example. As described above with reference to Figs. 1 to 15, 36 to 39, 44 to 62 and 70 and the like, the electronic apparatus 161 includes the semiconductor device 100 (e.g., the light detection apparatus 163). The semiconductor device 100 includes the semiconductor portion 20 having an island shape, the transistor 2 including the S/D region 21 (at least one of the source region 21-S and the drain region 21-D) formed in the semiconductor portion 20, and the contactor 4 connected to the S/D region 21. The contactor 4 includes the contact surface 412c that is in contact with the S/D region 21 and extends downward. In such an electronic apparatus 161, the performance of the transistor 2 can be improved as described above, and accordingly the possibility of improving the overall performance of the electronic apparatus 161 increases.

The electronic apparatus 161 described above with reference to Figs. 14, 16 and 70 and the like is also one of the disclosed technologies. The electronic apparatus 161 includes the semiconductor device 100. The semiconductor device 100 includes the plurality of semiconductor portions 20 having island shapes provided spaced apart from each other, and the contactor 4. The plurality of semiconductor portions 20 includes the semiconductor portion 20-1 (first semiconductor portion) where the S/D region 21-1 of the transistor 2-1 (first transistor) and the S/D region of the transistor 2-2 (second transistor) electrically connected to the S/D region 21 are formed, and the semiconductor portion 20-2 (second semiconductor portion) where the S/D region 21-2 of the transistor of the transistor 2-1 is formed. The contactor 4 includes the contact portion 4A-1 (first contact portion) extending upward from the S/D region 21-1 of the transistor 2-1 formed in the semiconductor portion 20-1, and the contact portion 4A-2 (second contact portion) extending upward from the S/D region 21-2 of the transistor 2-1 formed in the semiconductor portion 20-2. Even in such an electronic apparatus 161, the performance of the transistor 2 can be improved, and thus the possibility of improving the overall performance of the electronic apparatus 161 increases.

### 13. Application Example to Mobile Body

The above-described technology can be applied to various products. For example, the above-described semiconductor device 100 or electronic apparatus 161 may be implemented, for example, as a device mounted on any type of mobile bodies such as a vehicle, an electric vehicle, a hybrid electric vehicle, a motorcycle, a bicycle, a personal mobility, an airplane, a drone, a ship, and a robot.

Fig. 71 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 71, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 71, an audio speaker 12061, a display section 12062, and an instrument panel 12063 are illustrated as the output device. The display section 12062 may, for example, include at least one of an on-board display and a head-up display.

Fig. 72 is a diagram depicting an example of the installation position of the imaging section 12031.

In Fig. 72, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 72 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The technology according to the present disclosure may be applied to the imaging section 12031 and the like among the above-described configurations. For example, the above-described semiconductor device 100 may be applied to the imaging section 12031. Since the performance of the transistor 2 in the semiconductor device 100 is improved, it is possible to obtain, for example, clearer captured images accordingly, thereby reducing driver fatigue.

### 14. Application Example to Endoscopic Surgery System

It is also applicable to endoscopic surgery systems.

Fig. 73 is a view depicting an example of a schematic configuration of an endoscopic surgery system to which the technology according to an embodiment of the present disclosure (present technology) can be applied.

In Fig. 73, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

Fig. 74 is a block diagram depicting an example of a functional configuration of the camera head 11102 and the CCU 11201 depicted in Fig. 73.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

Hereinabove, an example of an endoscopic surgery system to which the technology according to the present disclosure can be applied is described. The technology according to the present disclosure may be applied to the endoscope 11100, (the imaging section 11402 of) the camera head 11102, (the image processing unit 11412 of) the CCU 11201, and the like among the above-described configurations, for example. For example, the semiconductor device 100 or the electronic apparatus 161 may be applied to the imaging section 11402. Since the performance of the transistor 2 in the semiconductor device 100 is improved, it is possible to obtain, for example, clearer surgical images accordingly, thereby allowing the surgeon to reliably check the surgical region.

Note that, although the endoscopic surgery system has been described as an example here, the technology according to the present disclosure may be applied to, for example, a microscopic surgery system or the like.

### 15. Fourth Embodiment

The semiconductor device 100 according to a fourth embodiment is a solid-state imaging device (also called an image sensor or the like). In this case, various transistors used to generate or output pixel signals are included in the semiconductor device 100 as the transistor 2. Examples of the transistor 2 include the reset transistor RST, the amplification transistor AMP, the selection transistor SEL and the like described above with reference to Fig. 69. Note that when these transistors are not particularly distinguished, they are simply referred to as transistor 2.

The required performance may vary depending on the role of the transistor 2. For example, for the selection transistor SEL, it is important to ensure the dynamic range (operation margin). In addition, for the transistor 2 (the reset transistor RST or a conversion efficiency switching transistor FDG described later) connected to the floating diffusion FD, it is important to suppress minute leakage so as to avoid FD white points. Such minute leakage becomes noise in image signals, and causes white points in images generated based on the pixel signals, for example.

To address at least part of the above-described problems, in the fourth embodiment, different types (kinds) of contactors are selectively used as the contactor 4 connected to the S/D region 21 of the transistor 2. Note that the following description assumes that the semiconductor device 100 includes a plurality of semiconductor substrates such as the first substrate 130 and the second substrate 140 as depicted in Figs. 68 and 69 described above.

Figs. 75 to 79 are diagrams depicting an example of a schematic configuration of the semiconductor device 100. Fig. 75 depicts a planar layout of the second substrate 140 of the semiconductor device 100. Fig. 76 depicts a cross section taken along line A-A of Fig. 75. Fig. 77 depicts a cross section taken along line B-B of Fig. 75. Fig. 78 depicts a cross section taken along line C-C of Fig. 75. Fig. 79 depicts a cross section taken along line D-D of Fig. 75. Note that some components (e.g., the contactor 3) are omitted in the crosssectional views.

In the example depicted in Fig. 75, three transistors 2, or more specifically the reset transistor RST, the amplification transistor AMP and the selection transistor SEL, are provided over the second substrate 140. The contactor 4 is connected to the S/D region 21 of each transistor 2.

The semiconductor device 100 includes two types (kinds) of contactors 4. The contactor 4 of the first type is referred to and depicted as contactor 4-α. The contactor 4 of the second type is referred to and depicted as contactor 4-β. The contactors 4 described above, such as the contactors 4 according to the first embodiment and second embodiment, correspond to the contactor 4-β. Note that when the contactor 4-α and the contactor 4-β are not particularly distinguished, they are simply referred to as contactor 4.

The transistor 2 provided over the second substrate 140 includes the transistor 2 in which the contactor 4-α is connected to the S/D region 21, and the transistor 2 in which the contactor 4-β is connected to the S/D region 21. It can be said that the transistors 2 to which different types of contactors 4 are connected are mixed.

In this example, the contactor 4-α is connected to the S/D region 21 of the reset transistor RST, or more specifically each of the source region 21-S and the drain region 21-D. The contactor 4-β is connected to the S/D region 21 of the amplification transistor AMP, or more specifically the drain region 21-D. The contactor 4-β is connected to the S/D region 21 of the selection transistor SEL, or more specifically the source region 21-S.

Fig. 75 depicts the wiring line 5 that connects the source region 21-S of the reset transistor RST and the gate electrode 23 of the amplification transistor AMP, and further connects them to an inter-substrate contactor 10. The inter-substrate contactor 10 provides the contact of the second substrate 140 and the first substrate 130 (Fig. 68).

Figs. 76 and 77 depict the contactor 4-α connected to the S/D region 21 of the reset transistor RST as an example of the contactor 4-α. The contactor 4-α includes a contact surface 41c that is in contact with the S/D region 21. In this example, the contact surface 41c does not extend downward (the Z-axis negative direction), but extends in the XY plane direction so as to be in contact only with the top surface 21a of the S/D region 21.

Specifically, the contactor 4-α includes the contact portion 41 that is in contact with the S/D region 21, and the extraction portion 42 that extends upward (the Z-axis positive direction) from the contact portion 41. The contact portion 41 is in contact only with the top surface 21a of the S/D region 21, and thus the bottom surface (the surface on the Z-axis negative direction side) of the contact portion 41 corresponds to the contact surface 41c.

Figs. 78 and 79 depict the contactor 4-β connected to the source region 21-S of the selection transistor SEL as an example of the contactor 4-β. The contactor 4-β is also in contact with the side surface of the S/D region 21 (which corresponds to the side surface 21c of Fig. 3 described above and the like), or more specifically, also in contact with the low-concentration impurity region 201 located on the lower side thereof. Such a contactor 4-β is specifically described above in the second embodiment (Figs. 36 to 39 and the like) for example, and therefore the description will not be repeated.

Note that Figs. 76 to 79 also depict the side wall 9 provided to the gate electrode 23. By providing the side wall 9, excessive approach of ion implantation to the gate electrode 23 can be avoided. In this example, the side wall 9 includes a film 91 and a film 92. An example of the film 91 is a silicon oxide film (SiO2 film). An example of the film 92 is a silicon nitride film (SiN film). In the example depicted in Figs. 76 to 79, the semiconductor device 100 further includes a SiN layer 11. The insulating layer 1 (e.g., SiO) is provided on the SiN layer 11. In addition, a film 12 is provided so as to cover the side wall 9 and the gate electrode 23. The film 12 is a silicon nitride film (SiN film), and functions as a dry etching stopper during formation of the contactor 4, for example.

In the above-described semiconductor device 100, the contactor 4-β is connected to the amplification transistor AMP and the S/D region 21 of the selection transistor SEL. The contactor 4-β is the same as the contactor 4 according to the first embodiment and second embodiment and the like described above. Through suppression of OFF leakage current and the like, the cutoff margin can be ensured, or in other words, the dynamic range can be ensured. In addition, the contactor 4-α is connected to the S/D region 21 of the reset transistor RST, or more specifically the source region 21-S connected to the floating diffusion FD. The contactor 4-α is not in contact with the low-concentration impurity region 201 on the lower side of the source region 21-S. If the contactor 4-α is also in contact with the low-concentration impurity region 201 and there is a defect (resulting from, for example, the barrier metal BM) in that portion due to formation of the contactor, that portion is not covered with the high-concentration impurity region such as the source region 21-S. FD white points might occur due to minute leakage. By avoiding the contact of the contactor 4-α to the low-concentration impurity region 201, FD white points can be suppressed.

As long as there is no contact with the low-concentration impurity region 201, the contactor 4-α may be in contact not only with the top surface 21a of the S/D region 21 but also with the side surface of the S/D region 21. Description will be made with reference to Figs. 80 to 82.

Figs. 80 to 82 are diagrams depicting an example of a schematic configuration of the semiconductor device 100. Fig. 80 depicts a planar layout of the second substrate 140 of the semiconductor device 100. Fig. 81 depicts a cross section taken along line A-A of Fig. 80. Fig. 82 depicts a cross section taken along line B-B of Fig. 80.

In this example, the contact surface 41c of the contactor 4-α connected to the drain region 21-D of the reset transistor RST is in contact only with the top surface 21a of the drain region 21-D as described above. On the other hand, the contactor 4-α connected to the source region 21-S of the reset transistor RST extends not only in the XY plane direction so as to be in contact with the top surface 21a of the source region 21-S but also extends downward (the Z-axis negative direction) so as to be in contact with the side surface of the S/D region 21. It should be noted that this downward extension length (Z-axial length) is smaller than the downward extension length of the contactor 4-β.

Specifically, as with the contactor 4-β, the contactor 4-α includes the base portion 411 and the extension portion 412 extending downward therefrom. The contact surface 41c extends downward by the amount corresponding to the extension portion 412. It should be noted that the contact surface 41c of the contactor 4-α is in contact with the side surface of the source region 21-S, but is not in contact with the low-concentration impurity region 201. It can be said that the contact surface 41c is separated from the interface therebetween. On the other hand, the contact surface of the contactor 4-β (which corresponds to the contact surface 412c of Fig. 3 and the like described above) extends downward so as to be in contact with the low-concentration impurity region 201.

Even with the above-described configuration, the contactor 4-α is not in contact with the low-concentration impurity region 201 on the lower side of the source region 21-S of the reset transistor RST, and thus FD white points can be suppressed.

With the contactor 4-α that is also in contact with the side surface of the S/D region 21, the possibility of reducing the contact resistance increases, for example. In the case where the contactor 4-α is in contact only with the top surface 21a of the S/D region 21 as described above, suppression of an increase in footprint can be expected. Note that unless otherwise specified, the following description assumes that the contactor 4-α is configured to be in contact only with the top surface 21a of the S/D region 21 as in Figs. 75 to 77 described above.

Still another transistor 2 may be provided over the second substrate 140 of the semiconductor device 100. An example of the transistor 2 is the conversion efficiency switching transistor FDG. Description will be made with reference to Figs. 83 to 86.

Fig. 83 is a diagram depicting an example of a circuit. This circuit is different from the circuit of Fig. 69 described above in that the conversion efficiency switching transistor FDG is further included. Although there is some overlap with the previous description, each element will be briefly described below. Note that in the following description, a configuration in which a certain transistor is disposed between two elements may be understood to mean that one of the drain and source of the transistor is connected to one element, and the other of the drain and source is connected to the other element.

The first substrate 130 is provided with a photodiode PD, a transfer transistor TRG and a floating diffusion FD. Fig. 83 exemplifies four photodiodes PD (PD 1 to PD 4), four transfer transistors TRG (TRG 1 to TRG 4) and four floating diffusions FD (FD 1 to FD 4).

The photodiode PD is an example of a photoelectric conversion element that generates a charge corresponding to the light reception amount. The floating diffusion FD accumulates the charge of the photodiode PD. The transfer transistor TRG is connected between the photodiode PD and the floating diffusion FD, and transfers the charge of the photodiode PD to the floating diffusion FD.

The second substrate 140 is provided with the conversion efficiency switching transistor FDG, the reset transistor RST, the amplification transistor AMP and the selection transistor SEL.

The conversion efficiency switching transistor FDG and the reset transistor RST are connected between the floating diffusion FD and the power source line VDD (this may also be referred to as a cascode connection). Through these transistors 2, the charge accumulated in the floating diffusion FD is discharged to the power source line VDD.

The conversion efficiency switching transistor FDG is connected between the floating diffusion FD and the reset transistor RST. The connecting portion between the conversion efficiency switching transistor FDG and the reset transistor RST is configured to have a capacitance, for example, by including a wiring of a certain length. This capacitance is connected to the floating diffusion FD through the conversion efficiency switching transistor FDG, thereby changing the capacitance of the floating diffusion FD. The charge-to-voltage conversion efficiency at the floating diffusion FD is switched. An element such as the wiring line that provides the capacitance is also referred to as subFD.

The amplification transistor AMP and the selection transistor SEL are connected between the power source line VDD and the vertical signal line VSL. Through these transistors 2, the voltage signal corresponding to the charge of the floating diffusion FD, i.e., the charge of the photodiode PD is output to the vertical signal line VSL.

The gate of the amplification transistor AMP is connected to the floating diffusion FD. The amplification transistor AMP outputs the voltage corresponding to the voltage of the floating diffusion FD, i.e., the charge accumulated in the FD. The selection transistor SEL is connected between the amplification transistor AMP and the vertical signal line VSL, and selectively outputs, to the vertical signal line VSL, the voltage output by the amplification transistor AMP.

Figs. 84 to 86 are diagrams depicting an example of a schematic configuration of the semiconductor device 100. Fig. 84 depicts a planar layout of the second substrate 140 of the semiconductor device 100. Fig. 85 depicts a cross section taken along line A-A of Fig. 84. Fig. 86 depicts a cross section taken along line B-B of Fig. 84.

The contactor 4-α is connected to the S/D region 21 of the conversion efficiency switching transistor FDG, or more specifically the source region 21-S. The details of the contactor 4-α are the same as Figs. 75 to 77 described above, and therefore the description will not be repeated.

Note that in the example depicted in Fig. 84, the contactor 4-α is also connected to the connecting portion between the connection point of the conversion efficiency switching transistor FDG and the reset transistor RST and the subFD. In addition, the contactor 4-α is also connected to the drain region 21-D of the reset transistor RST. It should be noted that the contactor 4-β may be connected to the drain region 21-D of the reset transistor RST.

### 16. Example/Modification

Some examples or modifications based on the above-described technology of the fourth embodiment are described below. In the embodiment, in plan view (as viewed in the Z-axis negative direction), the contactor 4-α and the contactor 4-β may have the same shape. Even in this case, by devising the arrangement of the contactor 4 or devising the width of the S/D region 21 of the transistor 2 (the width of the semiconductor portion 20), the two types of contactors 4, namely the contactor 4-α and the contactor 4-β, can be obtained. Description will be made with reference to Figs. 87 to 92.

Figs. 87 to 90 are diagrams depicting an example of a schematic configuration of the semiconductor device 100. Fig. 87 depicts a planar layout of the second substrate 140 of the semiconductor device 100. Fig. 88 depicts a cross section taken along line D-D of Fig. 87. Fig. 89 depicts another example of a planar layout of the second substrate 140 of the semiconductor device 100. Fig. 90 depicts a cross section taken along line D-D of Fig. 89.

In plan view, the contactor 4-α and the contactor 4-β have the same shape. The same shape may be understood to include the same size (dimensions). In the example depicted in Fig. 87, the contactor 4-α and the contactor 4-β have the same square shape.

The length of the semiconductor portion 20 in the short-side direction in plan view is referred to as the width of the semiconductor portion 20 or the width of the S/D region 21. In addition, the length of the contactor 4-α and the length of the contactor 4-β in the same direction as the width direction of the corresponding S/D region 21 is referred to as the width of the contactor 4-α and the width of the contactor 4-β. The width of the contactor 4-α and the width of the contactor 4-β are the same, and they are smaller than the width of the corresponding S/D region 21.

In plan view, the relative position of the contactor 4-β with respect to the S/D region 21 is shifted from the relative position of the contactor 4-α with respect to the S/D region 21. Specifically, the contactor 4-α overlaps the S/D region 21 in its entirety, and is in contact only with the top surface 21a of the S/D region 21. The contactor 4-β only partially overlaps the S/D region 21, and the remaining portion is located outside (protruded from) the S/D region 21.

In the example depicted in Figs. 87 and 88, the contactor 4-β connected to the source region 21-S of the selection transistor SEL is shifted in the width direction (the X-axis direction) of the source region 21-S. This contactor 4-β is in contact with one side surface (in this example, the side surface on the X-axis positive direction side) of the source region 21-S and the side surface of the low-concentration impurity region 201 on the lower side thereof.

In the example depicted in Figs. 89 and 90, the contactor 4-β connected to the source region 21-S of the selection transistor SEL is shifted in the longitudinal direction (the Y-axis direction) of the source region 21-S. This contactor 4-β is in contact with one side surface (in this example, the side surface on the Y-axis negative direction side) of the source region 21-S and the side surface of the low-concentration impurity region 201 on the lower side thereof.

Figs. 91 and 92 are diagrams depicting an example of a schematic configuration of the semiconductor device 100. Fig. 91 depicts a planar layout of the second substrate 140 of the semiconductor device 100. (B) and (D) of Fig. 92 depict cross sections taken along line B-B and line D-D of Fig. 92.

As described above, in plan view, the contactor 4-α and the contactor 4-β have the same shape. In the example depicted in Figs. 91 and 92, the width of the S/D region 21 to which the contactor 4-β is connected is smaller than the width of the S/D region 21 to which the contactor 4-α is connected. Specifically, the contactor 4-α overlaps the S/D region 21 in its entirety, and is in contact only with the top surface 21a of the S/D region 21. The contactor 4-β only partially overlaps the S/D region 21, and the remaining portion is located outside (protruded from) the S/D region 21. The contactor 4-β is in contact not only with the top surface 21a of the S/D region 21 but also with the two side surfaces of the S/D region 21 and the side surfaces of the low-concentration impurity region 201 on the lower side thereof.

With the above-described configuration, in which the contactor 4-α and the contactor 4-β have the same shape, the contactor 4-α and the contactor 4-β can be separately created without changing the planar layout of the contactor 4. Since the width of the contactor 4-β is shorter in comparison with the configuration of Fig. 75 described above, the parasitic capacitance between the contactor and the gate can be reduced accordingly.

Although there is some overlap with the previous description, of the drain region 21-D of the amplification transistor AMP and the source region 21-S of the selection transistor SEL, the contactor 4-β is connected to at least the source region 21-S of the selection transistor SEL. Either the contactor 4-α or the contactor 4-β may be connected to the drain region 21-D of the amplification transistor AMP. Description will be made with reference to Figs. 93 to 96.

Figs. 93 and 94 are diagrams depicting an example of a schematic configuration of the semiconductor device 100. Fig. 93 depicts a planar layout of the second substrate 140 of the semiconductor device 100. (A) of Fig. 94 depicts a cross section taken along line A-A of Fig. 93. (B) of Fig. 94 depicts a cross section taken along line B-B of Fig. 93. In this example, the contactor 4-β is connected to the source region 21-S of the selection transistor SEL. The contactor 4-β is also connected to the drain region 21-D of the amplification transistor AMP.

Figs. 95 and 96 are diagrams depicting an example of a schematic configuration of the semiconductor device 100. Fig. 95 depicts a planar layout of the second substrate 140 of the semiconductor device 100. (A) of Fig. 96 depicts a cross section taken along line A-A of Fig. 95. (B) of Fig. 96 depicts a cross section taken along line B-B of Fig. 95. In this example, the contactor 4-β is connected to the source region 21-S of the selection transistor SEL. The contactor 4-α is connected to the drain region 21-D of the amplification transistor AMP. The parasitic capacitance between the contactor and the gate can be reduced in comparison with the case where the contactor 4-β is connected.

In the embodiment, the contactor 4-β may be used to electrically connect the S/D regions 21 of two transistors 2. Description will be made with reference to Figs. 97 and 98.

Figs. 97 and 98 are diagrams depicting an example of a schematic configuration of the semiconductor device 100. The S/D regions 21 of two transistors 2 are formed in different semiconductor portions 20. The semiconductor portions 20 are provided spaced apart from each other in the width direction, and they are connected using the contactor 4-β.

In the example depicted in Fig. 97, the contactor 4-β is connected to the drain region 21-D of the conversion efficiency switching transistor FDG. In addition, the contactor 4-β is connected to the source region 21-S of the reset transistor RST. The two contactors 4-β are connected to each other. The two contactors 4-β may be integrally formed to constitute a single contactor 4-β as a whole.

In the example depicted in Fig. 98, the contactor 4-β is connected to the source region 21-S of the amplification transistor AMP. The contactor 4-β is connected to the drain region 21-D of the selection transistor SEL. The two contactors 4-β are connected to each other.

By using the contactor 4-β that is in contact with the side surface of the S/D region 21 as described above, the S/D regions 21 of two transistors can be electrically connected. Since another element for connecting them is unnecessary, the configuration can be simplified accordingly. Description will also be made using a comparative example.

Figs. 99 and 100 depict a comparative example. As two transistors 2, the amplification transistor AMP and the selection transistor SEL are exemplified.

In the comparative example depicted in Fig. 99, the contactor 4-α is connected to the drain region 21-D of the amplification transistor AMP. The contactor 4-α is connected to the source region 21-S of the amplification transistor AMP. The two contactors 4-α are connected to a common wiring line 5. Through the two contactors 4-α and the wiring line 5, the source region 21-S of the amplification transistor AMP and the drain region 21-D of the selection transistor SEL are electrically connected. Since the wiring line 5 is required, the connection configuration is complicated accordingly.

In the comparative example depicted in Fig. 100, another semiconductor portion 20 for connecting the source region 21-S of the amplification transistor AMP and the source region 21-S of the selection transistor SEL is provided. The source region 21-S of the amplification transistor AMP and the drain region 21-D of the selection transistor SEL are electrically connected. Another semiconductor portion 20 that extends in the direction orthogonal to the extending direction of the semiconductor portion 20 of the amplification transistor AMP and the selection transistor SEL becomes necessary, and as a result the connection configuration is complicated accordingly.

With the configuration of Figs. 97 and 98 described above, the source region 21-S of the amplification transistor AMP and the drain region 21-D of the selection transistor SEL can be electrically connected only with the contactor 4-β. The connection configuration can thus be simplified in comparison with the comparative example.

### 17. Example of Manufacturing Method

Figs. 101 to 104 depict an example of a manufacturing method for the semiconductor device 100. As an example, in the case where the contactor 4-α is connected to the drain region 21-D of the amplification transistor AMP and the contactor 4-β is connected to the source region 21-S of the selection transistor SEL as depicted in Fig. 101, some manufacturing steps for these portions are depicted in Figs. 102 to 104. (A) in Figs. 102 to 104 depicts a cross section taken along line A-A of Fig. 101. (B) in Figs. 102 to 104 depicts a cross section taken along line B-B of Fig. 101. (C) in Figs. 102 to 104 depicts a cross section taken along line C-C of Fig. 101.

As depicted in Fig. 102, the semiconductor portion 20 where the S/D region 21 is formed, the gate electrode 23, the side wall 9 and the like are prepared, and the insulating material 6 is provided so as to cover them. As depicted in Fig. 103, the insulating material 6 is etched so as to obtain a recess portion 4r-α corresponding to the contactor 4-α and a recess portion 4r-β corresponding to the contactor 4-β. As depicted in Fig. 104, the materials of the contactor 4-α and the contactor 4-β are provided. The barrier metal BM is also provided.

In the above-described manner, the semiconductor device 100 including the transistor 2 in which the contactor 4-α is connected to the S/D region 21 and the transistor 2 in which the contactor 4-β is connected to the S/D region 21 is obtained, for example.

### 18. Brief Summary

The semiconductor device 100 according to the fourth embodiment described above is specified as follows, for example. As described above with reference to Figs. 75 to 96 and the like, the transistor 2 includes the transistor 2 in which the contactor 4-α (first-type contactor) is connected to the S/D region 21 (at least one of the source region 21-S and the drain region 21-D), and the transistor 2 in which the contactor 4-β (second-type contactor) is connected to the S/D region 21. The contactor 4 described above in the first embodiment and second embodiment and the like is the contactor 4-β, and the semiconductor device 100 also includes the contactor 4-α. The contactor 4-α includes the contact surface 41c that is in contact with the S/D region 21, and the contact surface 41c of the contactor 4-α does not extend downward (the Z-axis negative direction) or extends downward with a length shorter than the downward extension length of the contact surface of the contactor 4-β (which corresponds to the contact surface 412c of Figs. 3 and 4 and the like). In the former case, as in Figs. 75 to 77 and the like, the contact surface 41c of the contactor 4-α may be in contact only with the top surface 21a of the S/D region 21. In the latter case, as in Figs. 80 to 82, the contact surface 41c of the contactor 4-α may extend downward so as not to be in contact with the low-concentration impurity region 201 (a region having a lower impurity concentration on the lower side of the S/D region 21), and the contact surface of the contactor 4-β may extend downward so as to be in contact with the low-concentration impurity region 201.

With the above-described semiconductor device 100, by selectively using the contactor to be connected to the S/D region 21 of the transistor 2, the performance of the transistor 2 can be improved. For example, with the transistor 2 to which the contactor 4-β is connected, the operation margin (dynamic range) of the transistor 2 can be ensured through suppression of OFF leakage current and the like. With the transistor 2 to which the contactor 4-α is connected, even if there is a defect due to formation of the contactor (resulting from, for example, the barrier metal BM), such a portion is covered with a high-concentration impurity region such as the S/D region 21. It is possible to suppress minute leakage that might occur due to a defective portion in contact with the low-concentration impurity region 201.

As described above with reference to Figs. 68, 69 and 75 to 96 and the like, the semiconductor device 100 may be a solid-state imaging device. Specifically, the semiconductor device 100 may include the PD (an example of the photoelectric conversion element), the FD, the transfer transistor TRG connected between the PD and the FD, the transistor 2 of at least one of the conversion efficiency switching transistor FDG and the reset transistor RST connected between the FD and the power source line VDD, the amplification transistor AMP that outputs a voltage corresponding to the charge accumulated in the FD, and the selection transistor SEL connected between the amplification transistor AMP and the vertical signal line VSL (an example of the signal line), the contactor 4-α may be connected to the S/D region 21 of at least one of the conversion efficiency switching transistor FDG and the reset transistor RST, and the contactor 4-β may be connected to the S/D region 21 of at least the selection transistor SEL of the amplification transistor AMP and the selection transistor SEL. For example, by selectively using the contactor 4-α and the contactor 4-β for the various transistors 2 in the semiconductor device 100 as a solid-state imaging device, the performance of the transistor 2 can be improved.

Some specific examples are described below. As described above with reference to Figs. 75 to 77, 80 to 82 and 84 to 86 and the like, the contactor 4-α may be connected to the source region 21-S of at least one of the conversion efficiency switching transistor FDG and the reset transistor RST. The contactor 4-α may be connected to the source region 21-S of the conversion efficiency switching transistor FDG. In the case where the semiconductor device 100 includes the transistors 2 of both the conversion efficiency switching transistor FDG and the reset transistor RST, the contactor 4-α may be connected to the source region 21-S of the conversion efficiency switching transistor FDG. In this manner, minute leakage in the source region 21-S connected to the floating diffusion FD can be suppressed, and in turn, FD white points that may occur due to the minute leakage can be suppressed.

The contactor 4 connected to the amplification transistor AMP is not particularly limited. For example, as described above with reference to Figs. 93 and 94 and the like, the contactor 4-β may be connected to the S/D region 21 of the amplification transistor AMP. Effects of suppressing OFF leakage current and the like can thus be obtained. Alternatively, as described above with reference to Figs. 95 and 96 and the like, the contactor 4-α may be connected to the S/D region 21 of the amplification transistor AMP. The possibility of reducing the parasitic capacitance between the contactor and the gate increases.

As described above with reference to Figs. 68, 69 and 83 and the like, the semiconductor device 100 may include the first substrate 130 (first semiconductor substrate) and the second substrate 140 (second semiconductor substrate), and the PD, the FD and the transfer transistor TRG may be provided over the first substrate 130, and the transistor 2 of at least one of the conversion efficiency switching transistor FDG and the reset transistor RST, the amplification transistor AMP, and the selection transistor SEL may be provided over the second substrate 140. In this case, the performance of the various transistors 2 provided over the second substrate 140 can be improved.

As described above with reference to Figs. 87 to 92 and the like, in plan view (as viewed in the Z-axis negative direction), the contactor 4-α and the contactor 4-β may have the same shape (e.g., a square shape). For example, as described above with reference to Figs. 87 to 90 and the like, the relative position of the contactor 4-β with respect to the S/D region 21 may be shifted from the relative position of the contactor 4-α with respect to the S/D region 21. Alternatively, as described above with reference to Figs. 91 and 92 and the like, the width (e.g., the X-axial length) of the S/D region 21 to which the contactor 4-β is connected may be smaller than the width of the S/D region 21 to which the contactor 4-α is connected. In this manner, the contactor 4-α and the contactor 4-β can be separately created without changing the planar layout of the contactor 4.

The contactor 4-α may be used to connect between the drain regions 21-D of two transistors 2. For example, as described above with reference to Fig. 97 and the like, the contactor 4-β may be connected to the drain region 21-D of the conversion efficiency switching transistor FDG, the contactor 4-β may be connected to the source region 21-S of the reset transistor RST, and the contactor 4-β connected to the drain region 21-D of the conversion efficiency switching transistor FDG and the contactor of the contactor 4-β connected to the source region 21-S of the reset transistor RST may be connected to each other. Alternatively, as described above with reference to Fig. 98 and the like, the contactor 4-β may be connected to the source region 21-S of the amplification transistor AMP, the contactor 4-β may be connected to the drain region 21-D of the selection transistor SEL, and the contactor 4-β connected to the source region 21-S of the amplification transistor AMP and the contactor 4-β connected to the drain region 21-D of the reset transistor RST may be connected to each other. In this manner, the connection configuration can be simplified in comparison with the case where the S/D regions 21 of two transistors 2 are connected through the wiring line 5 or through another semiconductor portion 20, for example.

It should be noted that the effects described in the present disclosure are merely illustrative and are not limited to the disclosed content. Other effects may also be achieved.

While the embodiments of the present disclosure have been described above, the technical scope of the present disclosure is not limited to the embodiments as described, and various modifications may be made without departing from the gist of the present disclosure. Further, components across different embodiments and modifications may be appropriately combined.

Note that the present technology may be configured as follows.
(1) A semiconductor device including:
   a semiconductor portion having an island shape;
   a transistor including at least one of a source region and a drain region formed in the semiconductor portion; and
   a contactor connected to the at least one of the source region and the drain region, in which
   the contactor includes a contact surface being in contact with the at least one of the source region and the drain region and extending downward.
(2) The semiconductor device according to (1), in which the contactor includes:
   a first contactor connected to the source region, and
   a second contactor connected to the drain region.
(3) The semiconductor device according to (1) or (2), in which
   the at least one of the source region and the drain region includes a side surface exposed on a surface of the semiconductor portion, and
   the contact surface of the contactor is in contact with the side surface of the at least one of the source region and the drain region.
(4) The semiconductor device according to any one of (1) to (3), in which
   at least one of the source region and the drain region includes a pair of side surfaces exposed on a surface of the semiconductor portion, and
   the contact surface of the contactor is in contact with the pair of side surfaces of the at least one of the source region and the drain region.
(5) The semiconductor device according to any one of (1) to (4), in which
   the semiconductor portion includes:
   a first semiconductor portion, and
   a second semiconductor portion provided spaced apart from the first semiconductor portion,
   the at least one of the source region and the drain region is formed in each of the first semiconductor portion and the second semiconductor portion, and
   the contact surface of the contactor is in contact with the at least one of the source region and the drain region formed in each of the first semiconductor portion and the second semiconductor portion.
(6) The semiconductor device according to (5), in which
   at least one of the source region and the drain region includes a pair of side surfaces exposed on a surface of the first semiconductor portion, and a pair of side surfaces exposed on a surface of the second semiconductor portion, and
   the contact surface of the contactor is in contact with the pair of side surfaces exposed on the surface of the first semiconductor portion and the pair of side surfaces exposed on the surface of the second semiconductor portion of the at least one of the source region and the drain region.
(7) The semiconductor device according to any one of (1) to (6), in which
   at least the one of the source region and the drain region includes a top surface and a side surface exposed on a surface of the semiconductor portion,
   the contactor includes:
      a contact portion being in contact with the top surface and the side surface of the at least one of the source region and the drain region, and
      an extraction portion extending upward from the contact portion, and
      in plan view, the extraction portion has an area smaller than an area of the contact portion.
(8) The semiconductor device according to (7), in which the area of the extraction portion is smaller than a sum of an area of the top surface and an area of the side surface of the at least one of the source region and the drain region in contact with the contact portion.
(9) The semiconductor device according to (7) or (8), in which
   the transistor includes a gate electrode, and
   a top surface of the contact portion of the contactor is located at the same height as a top surface of the gate electrode.
(10) The semiconductor device according to (7) or (8), in which
   the transistor includes a gate electrode, and
   a top surface of the contact portion of the contactor is located at a position lower than a top surface of the gate electrode.
(11) The semiconductor device according to (10), in which the contact portion is a silicide film.
(12) The semiconductor device according to any one of (1) to (11), in which
   the semiconductor portion includes a low-concentration impurity region having an impurity concentration lower than an impurity concentration of the at least one of the source region and the drain region on a lower side of the at least one of the source region and the drain region, and
   the contact surface of the contactor is in contact with the at least one of the source region and the drain region and the low-concentration impurity region.
(13) The semiconductor device according to (12), in which
   the at least one of the source region and the drain region includes the pair of side surfaces exposed on the surface of the semiconductor portion, and
   the contact surface of the contactor is in contact with the pair of side surfaces of the at least one of the source region and the drain region and a pair of side surfaces of the low-concentration impurity region extending downward therefrom.
(14) The semiconductor device according to (12) or (13), in which the contactor includes a contactor connected to the source region.
(15) The semiconductor device according to any one of (12) to (14), wherein an impurity concentration of at least one of the source region and the drain region is 1 × 10¹⁹ cm⁻³ or greater, and
   the impurity concentration of the low-concentration impurity region is 1 × 10¹⁸ cm⁻³ or less.
(16) The semiconductor device according to any one of (12) to (15), in which an impurity concentration of the drain region is lower than an impurity concentration of the source region and higher than the impurity concentration of the low-concentration impurity region.
(17) The semiconductor device according to any one of (1) to (16), in which
   the transistor includes:
   a transistor in which a first-type contactor is connected to at least one of a source region and a drain region, and
   a transistor in which a second-type contactor is connected to at least one of a source region and a drain region,
   the contactor is the second-type contactor,
   the semiconductor device further includes the first-type contactor,
   the first-type contactor includes a contact surface being in contact with the at least one of the source region and the drain region, and
   the contact surface of the first-type contactor does not extend downward, or extends downward with a length shorter than a downward extension length of a contact surface of the second-type contactor.
(18) The semiconductor device according to (17), in which the contact surface of the first-type contactor does not extend downward, and is in contact only with a top surface of the at least one of the source region and the drain region.
(19) The semiconductor device according to (17), in which
   the semiconductor portion includes a low-concentration impurity region having an impurity concentration lower than an impurity concentration of the at least one of the source region and the drain region on a lower side of the at least one of the source region and the drain region,
   the contact surface of the first-type contactor extends downward so as not to be in contact with the low-concentration impurity region, and
   the contact surface of the second-type contactor extends downward so as to be in contact with the low-concentration impurity region.
(20) The semiconductor device according to (18) or (19), further including:
   a photoelectric conversion element;
   a floating diffusion;
   a transfer transistor connected between the photoelectric conversion element and the floating diffusion;
   at least one of a reset transistor and a conversion efficiency switching transistor connected between the floating diffusion and a power source line;
   an amplification transistor configured to output a voltage corresponding to a charge accumulated in the floating diffusion; and
   a selection transistor connected between the amplification transistor and a signal line, in which
   the first-type contactor is connected to at least one of the source region and the drain region of the at least one of the conversion efficiency switching transistor and the reset transistor, and
   the second-type contactor is connected to at least one of the source region and the drain region of at least the selection transistor of the amplification transistor and the selection transistor.
(21) The semiconductor device according to (20), in which the first-type contactor is connected to the source region of the at least one of the conversion efficiency switching transistor and the reset transistor.
(22) The semiconductor device according to (20) or (21) including both the conversion efficiency switching transistor and the reset transistor, in which
   the first-type contactor is connected to the source region of the conversion efficiency switching transistor.
(23) The semiconductor device according to any one of (20) to (22), in which the second-type contactor is connected to at least one of the source region and the drain region of the amplification transistor.
(24) The semiconductor device according to any one of (20) to (22), in which the first-type contactor is connected to at least one of the source region and the drain region of the amplification transistor.
(25) The semiconductor device according to any one of (20) to (24), further including:
   a first semiconductor substrate; and
   a second semiconductor substrate, in which
   the photoelectric conversion element, the floating diffusion and the transfer transistor are provided over the first semiconductor substrate, and
   the at least one of the conversion efficiency switching transistor and the reset transistor, the amplification transistor, and the selection transistor are provided over the second semiconductor substrate.
(26) The semiconductor device according to any one of (20) to (25), in which in plan view, the first-type contactor and the second-type contactor have the same shape.
(27) The semiconductor device according to (26), in which the same shape is a square shape.
(28) The semiconductor device according to (26) or (27), in which in plan view, a relative position of the second-type contactor with respect to at least one of the source region and the drain region is shifted from a relative position of the first-type contactor with respect to at least one of the source region and the drain region.
(29) The semiconductor device according to (26) or (27), in which in plan view, a width of at least one of the source region and the drain region to which the second-type contactor is connected is smaller than a width of at least one of the source region and the drain region to which the first-type contactor is connected.
(30) The semiconductor device according to any one of (20) to (29), in which
   the second-type contactor is connected to the drain region of the conversion efficiency switching transistor,
   the second-type contactor is connected to the source region of the reset transistor, and
   the second-type contactor connected to the drain region of the conversion efficiency switching transistor and the second-type contactor connected to the source region of the reset transistor are connected to each other.
(31) The semiconductor device according to any one of (20) to (30), in which
   the second-type contactor is connected to the source region of the amplification transistor,
   the second-type contactor is connected to the drain region of the selection transistor, and
   the second-type contactor connected to the source region of the amplification transistor and the second-type contactor connected to the drain region of the reset transistor are connected to each other.
(32) The semiconductor device according to (1), in which the contactor includes:
   a first contact portion extending from a wiring line of a wiring layer to the at least one of the source region and the drain region, and
   a second contact portion including the contact surface being in contact with at least one of the source region and the drain region and extending downward.
(33) The semiconductor device according to (32), in which the contact surface of the second contact portion is in contact not only with the at least one of the source region and the drain region but also with a portion located on a lower side of the at least one of the source region and the drain region in the semiconductor portion.
(34) The semiconductor device according to (32) or (33), in which in a vertical direction, the first contact portion and the second contact portion are continuous with each other.
(35) The semiconductor device according to (34), in which
   the first contact portion extends into the at least one of the source region and the drain region,
   in plan view, the first contact portion has an area different from an area of the second contact portion, and
   the first contact portion and the second contact portion are continuous with each other so as to include a step portion within the at least one of the source region and the drain region.
(36) The semiconductor device according to (32) or (33), in which
   the second contact portion extends from the wiring line of the wiring layer separately from the first contact portion, and
   in plan view, the first contact portion and the second contact portion are spaced apart from each other.
(37) The semiconductor device according to (36), in which
   the at least one of the source region and the drain region includes a side surface exposed on a surface of the semiconductor portion, and
   the contact surface of the second contact portion is in contact with the side surface of the at least one of the source region and the drain region.
(38) The semiconductor device according to any one of (32) to (37), in which in plan view, the first contact portion has an area greater than an area of the second contact portion.
(39) The semiconductor device according to any one of (32) to (37), in which in plan view, the second contact portion has an area greater than an area of the first contact portion.
(40) A semiconductor device including:
   a plurality of semiconductor portions having island shapes provided spaced apart from each other, and
   a contactor, in which
   the plurality of semiconductor portions includes:
      a first semiconductor portion in which at least one of a source region and a drain region of a first transistor, and at least one of a source region and a drain region of a second transistor electrically connected to the at least one of the source region and the drain region are formed, and
      a second semiconductor portion in which at least one of the source region and the drain region of the first transistor is formed, and
      the contactor includes:
         a first contact portion extending upward from the at least one of the source region and the drain region of the first transistor formed in the first semiconductor portion, and
         a second contact portion extending upward from the at least one of the source region and the drain region of the first transistor formed in the second semiconductor portion.
(41) The semiconductor device according to (40), in which
   the first contact portion extends from at least one of the source region and the drain region of the first transistor to a wiring line of a wiring layer,
   the second contact portion extends from at least one of the source region and the drain region of the first transistor to the wiring line, and
   the at least one of the source region and the drain region of the first transistor formed in the first semiconductor portion and the at least one of the source region and the drain region of the first transistor formed in the second semiconductor portion are electrically connected through the first contact portion, the wiring line and the second contact portion.
(42) The semiconductor device according to any one of (1) to (41), in which the semiconductor portion is provided to protrude from a top surface of an insulating layer.
(43) The semiconductor device according to any one of (1) to (42) is a light detection apparatus.
(44) An electronic apparatus including a semiconductor device, in which
   the semiconductor device includes:
   a semiconductor portion having an island shape;
   a transistor including at least one of a source region and a drain region formed in the semiconductor portion; and
   a contactor connected to the at least one of the source region and the drain region, in which
   the contactor includes a contact surface being in contact with the at least one of the source region and the drain region and extending downward.
(45) An electronic apparatus including a semiconductor device, the semiconductor device including:
   a plurality of semiconductor portions having island shapes provided spaced apart from each other,
   a contactor, in which
   the plurality of semiconductor portions includes:
      a first semiconductor portion in which at least one of a source region and a drain region of a first transistor, and at least one of a source region and a drain region of a second transistor electrically connected to the at least one of the source region and the drain region are formed, and
      a second semiconductor portion in which the at least one of the source region and the drain region of the first transistor is formed, and
      the contactor includes:
         a first contact portion extending upward from the at least one of the source region and the drain region of the first transistor formed in the first semiconductor portion, and
         a second contact portion extending upward from the at least one of the source region and the drain region of the first transistor formed in the second semiconductor portion.

### Reference Signs List

100 Semiconductor device
161 Electronic apparatus
1 Insulating layer
2 Transistor
2-1 Transistor (First transistor)
2-2 Transistor (Second transistor)
2-3 Transistor (Third transistor)
2-4 Transistor (Fourth transistor)
20 Semiconductor portion
20-1 Semiconductor portion (First semiconductor portion)
20-2 Semiconductor portion (Second semiconductor portion)
201 Low-concentration impurity region
21 S/D region
21-1 S/D region (First S/D region)
21-2 S/D region (Second S/D region)
21-S Source region
21-D Drain region
211 First region
212 Second region
21a Top surface
21c Side surface
21c-1 Side surface
21c-2 Side surface
21c-3 Side surface
21c-4 Side surface
22 Channel region
23 Gate electrode
23a Top surface
3 Contactor
4 Contactor
4-1 Contactor
4-2 Contactor
4-α Contactor
4-β Contactor
4r-α Recess portion
4r-β Recess portion
41 Contact portion
411 Base portion
411a Top surface
411b Bottom surface
412 Extension portion
412-1 Extension portion (First extension portion)
412-2 Extension portion (Second extension portion)
412-3 Extension portion (Third extension portion)
412c Contact surface
412c-1 Contact surface
412c-2 Contact surface
41c Contact surface
41m Material
41r Recess portion
42 Extraction portion
42a Top surface
42b Bottom surface
42m Material
42r Recess portion
4A-1 Contact portion
4A-2 Contact portion
5 Wiring line
6 Insulating material
7 Contact portion
7b Bottom surface
7r Recess portion
8 Contact portion
8a Top surface
8c Contact surface
8c-1 Contact surface
8c-2 Contact surface
8c-3 Contact surface
8c-4 Contact surface
9 Side wall
91 Film
92 Film
10 Inter-substrate contactor
11 SiN layer
12 Film
AMP Amplification transistor
BM Barrier metal
FD Floating diffusion
FDG Conversion efficiency switching transistor
PD Photodiode (Photoelectric conversion element)
RM Resist mask
RST Reset transistor
S Step portion
SEL Selection transistor
TRG Transfer transistor

## Claims

1. A semiconductor device comprising:
a semiconductor portion having an island shape;
a transistor including at least one of a source region and a drain region formed in the semiconductor portion; and
a contactor connected to the at least one of the source region and the drain region, wherein
the contactor includes a contact surface being in contact with the at least one of the source region and the drain region and extending downward.

2. The semiconductor device according to claim 1, wherein
the contactor includes:
a first contactor connected to the source region, and
a second contactor connected to the drain region.

3. The semiconductor device according to claim 1, wherein
the at least one of the source region and the drain region includes a side surface exposed on a surface of the semiconductor portion, and
the contact surface of the contactor is in contact with the side surface of at least one of the source region and the drain region.

4. The semiconductor device according to claim 1, wherein
the semiconductor portion includes:
a first semiconductor portion, and
a second semiconductor portion provided spaced apart from the first semiconductor portion,
the at least one of the source region and the drain region is formed in each of the first semiconductor portion and the second semiconductor portion, and
the contact surface of the contactor is in contact with the at least one of the source region and the drain region formed in each of the first semiconductor portion and the second semiconductor portion.

5. The semiconductor device according to claim 1, wherein
the at least one of the source region and the drain region includes a top surface and a side surface exposed on a surface of the semiconductor portion,
the contactor includes:
a contact portion being in contact with the top surface and the side surface of the at least one of the source region and the drain region, and
an extraction portion extending upward from the contact portion, and
in plan view, the extraction portion has an area smaller than an area of the contact portion.

6. The semiconductor device according to claim 5, wherein the area of the extraction portion is smaller than a sum of an area of the top surface and an area of the side surface of the at least one of the source region and the drain region in contact with the contact portion.

7. The semiconductor device according to claim 1, wherein
the semiconductor portion includes a low-concentration impurity region having an impurity concentration lower than an impurity concentration of the at least one of the source region and the drain region on a lower side of the at least one of the source region and the drain region, and
the contact surface of the contactor is in contact with the at least one of the source region and the drain region and the low-concentration impurity region.

8. The semiconductor device according to claim 7, wherein an impurity concentration of the drain region is lower than an impurity concentration of the source region and higher than the impurity concentration of the low-concentration impurity region.

9. The semiconductor device according to claim 1, wherein the transistor includes:
a transistor in which a first-type contactor is connected to at least one of a source region and a drain region, and
a transistor in which a second-type contactor is connected to at least one of a source region and a drain region,
the contactor is the second-type contactor,
the semiconductor device further includes the first-type contactor,
the first-type contactor includes a contact surface being in contact with the at least one of the source region and the drain region, and
the contact surface of the first-type contactor does not extend downward or extends downward with a length shorter than a downward extension length of a contact surface of the second-type contactor.

10. The semiconductor device according to claim 9, wherein the contact surface of the first-type contactor does not extend downward and is in contact only with a top surface of the at least one of the source region and the drain region.

11. The semiconductor device according to claim 9, wherein
the semiconductor portion includes a low-concentration impurity region having an impurity concentration lower than an impurity concentration of the at least one of the source region and the drain region on a lower side of the at least one of the source region and the drain region,
the contact surface of the first-type contactor extends downward so as not to be in contact with the low-concentration impurity region, and
the contact surface of the second-type contactor extends downward so as to be in contact with the low-concentration impurity region.

12. The semiconductor device according to claim 10, further comprising:
a photoelectric conversion element;
a floating diffusion;
a transfer transistor connected between the photoelectric conversion element and the floating diffusion;
at least one of a reset transistor and a conversion efficiency switching transistor connected between the floating diffusion and a power source line;
an amplification transistor configured to output a voltage corresponding to a charge accumulated in the floating diffusion; and
a selection transistor connected between the amplification transistor and a signal line, wherein
the first-type contactor is connected to at least one of the source region and the drain region of the at least one of the conversion efficiency switching transistor and the reset transistor, and
the second-type contactor is connected to at least one of the source region and the drain region of at least the selection transistor of the amplification transistor and the selection transistor.

13. The semiconductor device according to claim 12, wherein the first-type contactor is connected to the source region of the at least one of the conversion efficiency switching transistor and the reset transistor.

14. The semiconductor device according to claim 12, comprising:
both the conversion efficiency switching transistor and the reset transistor, wherein
the first-type contactor is connected to the source region of the conversion efficiency switching transistor.

15. The semiconductor device according to claim 12, further comprising:
a first semiconductor substrate; and
a second semiconductor substrate, wherein
the photoelectric conversion element, the floating diffusion and the transfer transistor are provided over the first semiconductor substrate, and
the at least one of the conversion efficiency switching transistor and the reset transistor, the amplification transistor, and the selection transistor are provided over the second semiconductor substrate.

16. The semiconductor device according to claim 1, wherein
the contactor includes:
a first contact portion extending from a wiring line of a wiring layer to the at least one of the source region and the drain region, and
a second contact portion including the contact surface being in contact with at least one of the source region and the drain region and extending downward.

17. The semiconductor device according to claim 16, wherein the contact surface of the second contact portion is in contact not only with the at least one of the source region and the drain region but also with a portion located on a lower side of the at least one of the source region and the drain region in the semiconductor portion.

18. The semiconductor device according to claim 16, wherein in a vertical direction, the first contact portion and the second contact portion are continuous with each other.

19. The semiconductor device according to claim 16, wherein
the second contact portion extends from the wiring line of the wiring layer separately from the first contact portion, and
in plan view, the first contact portion and the second contact portion are spaced apart from each other.

20. An electronic apparatus comprising:
a semiconductor device, wherein
the semiconductor device includes:
a semiconductor portion having an island shape;
a transistor including at least one of a source region and a drain region formed in the semiconductor portion; and
a contactor connected to the at least one of the source region and the drain region, wherein
the contactor includes a contact surface being in contact with the at least one of the source region and the drain region and extending downward.
